# EUROPÄISCHE PATENTSCHRIFT

(11) **EP 1 902 599 B1**
(45) Veröffentlichungstag und Bekanntmachung des Hinweises auf die Patenterteilung: **19.10.2011**
(21) Anmeldenummer: 06775706.2
(22) Anmeldetag: 14.07.2006
(51) Int. Cl.: H05H 1/24

(54) **VORRICHTUNG ZUR ERZEUGUNG EINES ATMOSPHÄRENDRUCK-PLASMAS**
DEVICE FOR PRODUCING AN ATMOSPHERIC PRESSURE PLASMA
DISPOSITIF POUR GENERER UN PLASMA A PRESSION ATMOSPHERIQUE

(30) Priorität: 14.07.2005 DE 102005032890
(43) Veröffentlichungstag der Anmeldung: 26.03.2008
(73) Patentinhaber: Reinhausen Plasma GmbH, 93057 Regensburg (DE)
(72) Erfinder: ENGEMANN, Jürgen, 42119 Wuppertal (DE); TESCHKE, Markus, 40233 Düsseldorf (DE)
(74) Vertreter: Meier, Gerald Heinz
(86) Internationale Anmeldenummer: PCT/DE2006/001234
(87) Internationale Veröffentlichungsnummer: WO 2007/006298

(56) Entgegenhaltungen:
- JP-A- 10 022 538
- US-A- 5 615 466
- US-A- 5 751 092
- US-A- 5 814 922
- TERANISHI K ET AL: "A novel generation method of dielectric barrier discharge and ozone production using a piezoelectric transformer" JAPANESE JOURNAL OF APPLIED PHYSICS, PART 1 (REGULAR PAPERS, SHORT NOTES & REVIEW PAPERS) JAPAN SOC. APPL. PHYS JAPAN, Bd. 43, Nr. 9B, September 2004 (2004-09), Seiten 6733-6739, XP002432140 ISSN: 0021-4922

## Beschreibung

Die Erfindung betrifft zunächst eine Vorrichtung zur Erzeugung eines Atmosphärendruck-Plasmas gemäß dem Oberbegriff des Anspruches 1.

Als Atmosphärendruck-Plasma im Sinne der Erfindung wird ein Plasma bezeichnet, welches unter Atmosphärendruck, gegebenenfalls aber auch bei höheren Drücken, generiert werden kann. Bei Vorrichtungen zur Erzeugung eines Atmosphärendruck-Plasmas können Vakuumeinrichtungen, wie Pumpen etc., entfallen. Derartige Vorrichtungen weisen daher gegenüber Vorrichtungen zur Erzeugung von Niederdruck- oder Niedertemperatur-Plasmen grundsätzlich eine einfache Bauweise auf.

Die Erfindung betrifft insbesondere Vorrichtungen zur Erzeugung eines Atmosphärendruck-Plasmas, die zur Bearbeitung eines Substrates dienen. Als Substrat wird dabei u.a. ein zweidimensionaler oder dreidimensionaler Festkörper verstanden, dessen Oberfläche, gegebenenfalls auch bis zu einer bestimmten Bearbeitungstiefe, bearbeitet werden kann, beispielsweise beschichtet, aktiviert, gereinigt, modifiziert oder sonst wie behandelt werden kann. Als Substrat im Sinne der vorliegenden Patentanmeldung wird aber beispielsweise auch ein zu behandelnder Gasstrom, beispielsweise ein zu reinigender Abgasstrom, verstanden.

Atmosphärendruck-Plasmen lassen sich in so genannte "kalte", nichtthermische Plasmen mit einer Gastemperatur von typisch kleiner als 100° C sowie thermische Plasmen mit höherer Gastemperatur unterscheiden. Die vorliegende Erfindung befasst sich vornehmlich mit nichtthermischen Plasmen, die den Vorteil haben, dass die Gastemperatur in der Größenordnung der Zimmertemperatur oder nur wenig darüber liegt, so dass auch eine längere Verweildauer des Plasmas am Substrat möglich ist und auch sehr empfindliche Substrate, wie z.B. dünne Polymerfolien, länger mit diesem Plasma behandelt werden können, ohne dass die Oberfläche des Substrats oder das Substrat selbst beschädigt wird.

Sowohl bei den Barrierenentladungen, wie sie z.B. aus der US 5,637,279 B1 bekannt sind, als auch bei Vorrichtungen zur Erzeugung eines Atmosphärendruck-Glimmentladungsplasmas, wie sie z.B. aus der DE 102 03 543 A1 der Anmelderin bekannt sind, erfolgt die Bereitstellung der für die lonisierung des Arbeitsgases notwendigen Hochspannung durch ein von den Anregungselektroden getrenntes, externes Hochspannungsnetzteil, das einen ferromagnetischen elektrischen Transformator enthält, der aus einer relativ kleinen Wechselspannung, im einfachsten Fall aus einer Netzspannung von 230 V/50 Hz, eine Hochspannung in der Größenordnung zwischen 1 und 15 kV erzeugt. Als Arbeitsgase kommen z.B. Edelgase, Sauerstoff, Stickstoff oder Luft in Betracht. Die im Hochspannungsnetzteil erzeugte Hochspannung wird über elektrisch isolierte Kabel den Elektroden zugeführt. Nachteilig bei dieser bekannten Vorrichtung zur Erzeugung von Atmosphärendruck-Plasmen mit einem solchen ferromagnetischen elektrischen Transformator sind grundsätzlich dessen Gewicht, dessen Größe und die Tatsache, dass die bei der Bildung der ionenerzeugenden Filamente (Teilentladungen) entstehenden elektrischen Impulse über den Transformator in die Spannungsversorgung zurück übertragen werden. Dies kann zwar durch einen Trenntransformator unterdrückt werden, erfordert jedoch zusätzlichen Aufwand. Weiterhin müssen aus Gründen der elektrischen Sicherheit und zum Schutz vor elektromagnetischen Beeinflussungen die Kabel zu den Elektroden isoliert sein, was den technischen Aufwand nochmals erhöht. Hierzu kommen hohe Umwandlungs- und Übertragungsverluste.

Aus der DE 101 29 041 A1 ist es bekannt, die erforderliche Hochspannung durch einen geregelten piezoelektrischen Transformator (PT) zu erzeugen. Dies hat einen wesentlich kompakteren Aufbau zur Folge. Diese Lösung geht vom bekannten piezoelektrischen Effekt aus, wobei balkenförmige piezoelektrische Keramiken bei mechanischer Verformung eine Spannung abgeben; dies wird technisch z.B. bei Zündgeräten ausgenutzt. Das Prinzip des piezoelektrischen Transformators besteht darin, dass die in Resonanz betriebene piezoelektrische Keramik durch Anlegen einer im Resonanzpunkt betriebenen elektrischen Niedervolt-Wechselspannung in ihrem Primärbereich in Schwingungen versetzt wird und andererseits an ihrem anderen Ende, dem so genannten Sekundärbereich, die erzeugten mechanischen Schwingungen wieder in eine elektrische Hochvolt-Wechselspannung zurückverwandelt. Bei der in der DE 101 29 041 A1 beschriebenen Lösung ist der piezoelektrische Transformator ein separates Bauteil, d.h. die erzeugte Hochspannung wird über die bereits beschriebenen isolierten Zuleitungen zu den Elektroden geführt.

Aus der Veröffentlichung (K. Teranishi, S. Suzuki, H. Itoh: "High Efficiency Ozon Production by a Compact Ozoniser Using Piezoelectric Transformer", Chiba Institute of Technology oder K. Teranishi et al: "A novel generation method of dielectric barrier discharge and ozone production using a piezoelectric transformer "- Jap. Journal of Applied Physics, Part 1, Bd.43, Nr9B, Sept. 2004, seiten 6733-6739), im Folgenden Itoh-Veröffentlichung, ist es zur Erzeugung von Ozon unter Zuhilfenahme eines Plasmas bereits bekannt, zur Erzeugung der Hochspannung einen piezoelektrischen Transformator zu verwenden, der gleichzeitig die Funktion der Hochspannungselektrode übernimmt. Dazu wird ein flacher, traditioneller sogenannter "Rosentyp" PT verwendet. Als Rosentyp PT wird eine Einrichtung aus piezoelektrischem Material bezeichnet, die im Wesentlichen die Form eines flachen, lang gestreckten Quaders besitzt.

Der Quader ist in einen Primärbereich und in einen Sekundärbereich unterteilt. An dem Primärbereich sind zwei Elektroden angeordnet, die unter einem Abstand, der von der Dicke des Materialbereiches vorgegeben ist, voneinander beabstandet sind. Durch Anlegen einer Niedervolt-Wechselspannung, also einer Wechselspannung mit einer Amplitude von insbesondere weniger als 500 V, wird der Primärbereich in Schwingungen versetzt. Diese Schwingungen werden von dem Primärbereich auf den Sekundärbereich übertragen. Da der Sekundärbereich eine vorgegebene Polarisationsrichtung aufweist, die sich entlang der Längserstreckung des Sekundärbereiches erstreckt, kommt es zur Ausbildung eines elektrischen Feldes bzw. von Potentialdifferenzen entlang der Längsrichtung des Sekundärbereiches.

Der Rosentyp PT ist im Primärbereich vorzugsweise transversal und im Sekundärbereich vorzugsweise longitudinal polarisiert.

Bei der Vorrichtung gemäß der Itoh-Veröffentlichung sind, bedingt durch die vorgegebene Bauart, nur flächige Entladungen in kleinen Spalten möglich. Der Sauerstoff wird entlang der Breitseiten des Sekundärbereiches geführt, und zwar innerhalb eines Ringraumes, der außen von einem Kühlgehäuse begrenzt ist. Mit der in der Itoh-Veröffentlichung beschriebenen Vorrichtung sind über die Ozonerzeugung hinausgehende Anwendungen nicht realisierbar. Die Ozonerzeugung selbst ist mit der Vorrichtung gemäß der Itoh-Veröffentlichung nicht besonders effizient. Die Vorrichtung gemäß der Itoh-Veröffentlichung besitzt noch weitere Nachteile, die ihre Anwendung stark einschränken: Zunächst ist keine Feldsteuerung möglich. Des Weiteren treten parasitäre Entladungen an verschiedenen Stellen auf, die keine örtliche bzw. räumliche Steuerung der Plasmaentladung gestatten. Ferner ist eine Skalierung aus mechanischen Gründen nicht möglich. Damit scheiden großflächigen Anwendungsmöglichkeiten aus. Auch ist die beschriebene Vorrichtung für die "Plasma-Jet"-Technik nicht geeignet, bei der ein Plasma aus einem Mündungsrohr herausgetragen wird und über die Kontur der plasmaerzeugenden Vorrichtung hinaus vorsteht.

Ausgehend von einer Vorrichtung gemäß dem Oberbegriff des Anspruches 1, wie sie in der angegeben Itoh-Veröffentlichung beschrieben ist, besteht die Aufgabe der Erfindung darin, die bekannte Vorrichtung derartig weiterzubilden, dass eine verbesserte Plasmagenerierung möglich wird.

Die Erfindung löst diese Aufgabe zunächst mit den Merkmalen des Anspruches 1, insbesondere mit denen des Kennzeichenteils, und ist demgemäß **dadurch gekennzeichnet, dass** der Sekundärbereich zwei Teilbereiche umfasst, die entlang der Längsrichtung entgegengesetzt polarisiert sind.

Das Prinzip der Erfindung besteht im Wesentlichen darin, bei der erfindungsgemäßen Vorrichtung eine modifizierte Einrichtung aus piezoelektrischem Material vorzusehen, bei der der Sekundärbereich nunmehr zwei unterschiedliche Teilbereiche umfasst, die unterschiedlich polarisiert sind. Dabei ist bei einer Variante der Erfindung vorgesehen, dass die beiden Teilbereiche Bestandteile eines einheitlichen Werkstückes aus piezo-elektrischem Material sind, welche im Rahmen eines später noch zu beschreibenden Polarisationsverfahrens unterschiedlich polarisiert worden sind. Alternativ können die beiden Teilbereiche auch von gesonderten Werkstücken aus piezo-elektrischem Material gebildet sein, und einander benachbart, beabstandet oder unbeabstandet voneinander, angeordnet sein.

Für den Fall, dass die beiden Teilbereiche aus einem gemeinsamen, unterschiedlich polarisierten Werkstück bestehen, kann es vorteilhaft sein, wenn den beiden Teilbereichen ein gemeinsamer Primärbereich zugeordnet ist. Der Primärbereich wird durch Anlegen einer Niedervolt-Wechselspannung an die beiden Elektroden in Schwingungen versetzt. Diese Schwingungen übertragen sich auf die beiden Teilbereiche des Sekundärbereiches. Aufgrund der entgegengesetzten Polarisationsrichtungen der beiden Teilbereiche werden elektrische Felder entlang der Oberflächen der beiden Teilbereiche generiert. Die größte Potentialdifferenz und die größten Feldstärken treten dabei zwischen den beiden Teilbereichen, und zwar insbesondere im Bereich der freien Enden des Sekundärbereiches, das heißt, im Bereich der dem Primärbereich fernen Enden der Teilbereiche auf. Im Bereich dieser freien Enden kann mit einem hohen Wirkungsgrad ein Atmosphärendruck-Plasma generiert werden.

Eine Anregung des Primärbereiches bedeutet im Sinne in der vorliegenden Patentanmeldung, dass die Niedervolt-Wechselspannung eine Frequenz aufweist, die einer Resonanzfrequenz der Einrichtung aus piezo-elektrischem Material entspricht. Die Resonanzfrequenz ist abhängig von dem gewählten piezo-elektrischen Material, insbesondere von der Schallgeschwindigkeit in dem piezo-elektrischen Material, und von der Geometrie des Primärbereiches und des Sekundärbereiches. Typische Resonanzfrequenzen liegen im Bereich zwischen 10 und 500 KHz. Eine Anregung des Primärbereiches ist auch mit einer Frequenz möglich, deren Wellenlänge das n-fache oder das n x 0,5-fache der Resonanzwellenlänge beträgt. Es handelt sich je nach Wahl des n um unterschiedliche Anregungsmoden.

Mit der erfindungsgemäßen Vorrichtung kann mit einer Niedervolt-Wechselspannungsquelle ein hohes elektrisches Feld an einer vorher bestimmten Stelle oder an einem vorher bestimmten Bereich generiert werden, um dort ein Plasma zu erzeugen. Die Hochspannung wird also unmittelbar dort erzeugt, wo das Plasma die starken elektrischen Felder erfordert. Auf besonders gesicherte Kabel oder Leitungen zur Leitung von Hochspannung kann verzichtet werden. Außerdem werden besonders kompakte platzsparende Bauformen erzielbar.

Die Piezo-Keramik selbst ist ein Isolator. Damit können zwar Spannungsunterschiede entlang der Oberfläche des Sekundärbereiches abgegriffen und gemessen werden. Würde man allerdings beispielsweise mit einem Finger die Außenseite des Sekundärbereiches berühren, so könnten hier nur immer derartig geringe Ladungen abfließen, dass die Gefahr von elektrischen Schlägen nicht besteht. Somit sind nur geringere Sicherheitsanforderungen zu erfüllen als bei herkömmlichen Vorrichtungen des Standes der Technik. Mit der erfindungsgemäßen Vorrichtungen sind sehr hohe Wirkungsgrade, größer als 0,9 erreichbar. Ein in konstruktiver Hinsicht besonderes einfacher Aufbau ergibt sich aufgrund der vorhandenen "natürlichen" dielektrischen Barrieren.

Gemäß einer vorteilhaften Ausgestaltung der Erfindung sind die beiden Teilbereiche im Wesentlichen parallel zueinander angeordnet. Dies ermöglicht eine besonders effiziente Plasma-Erzeugung.

Gemäß einer weiteren vorteilhaften Ausgestaltung der Erfindung generiert eine Anregung des Primärbereiches eine Potentialdifferenz zwischen den beiden Teilbereichen in einer Richtung quer zur Längsrichtung. Damit werden auch hohe elektrische Felder in einem Bereich zwischen den beiden Teilbereichen, und zwar in besonderem Maße nahe dem Verbindungsbereich zwischen den beiden Teilbereichen, generiert. Dies ermöglicht insbesondere die Erzeugung eines Plasmas im Bereich der freien Enden des Sekundärbereiches, und damit grundsätzlich die Erzeugung von großflächigen Plasmen, wenn mehrere Teilbereiche entlang einer Geraden oder entlang einer Ebene angeordnet sind. Außerdem können die erzeugten Felder sehr genau vorher bestimmt werden.

Die Erzeugung von Potentialdifferenzen zwischen den beiden Teilbereichen entlang einer Richtung quer zur Längsrichtung bedeutet insbesondere, dass sich maximale Potentialdifferenzen im Bereich der freien Enden der Teilbereiche bilden. Damit werden dort maximale elektrische Felder generiert, was in diesen Bereichen zu einer bevorzugten Plasmagenerierung führt.

Bei einer weiteren vorteilhaften Ausgestaltung der Erfindung sind die beiden Teilbereiche einander benachbart angeordnet. Dies ermöglicht eine sehr kompakte Bauweise und die Erzielung hoher Potentialdifferenzen und damit die Erzielung hoher elektrischer Feldstärken zwischen den beiden Teilbereichen.

Bei einer weiteren vorteilhaften Ausgestaltung der Erfindung sind die beiden Teilbereiche voneinander unbeabstandet. Diese Ausführung ermöglicht eine besonders einfache Bauweise der Einrichtung aus piezoelektrischem Material, da die beiden Teilbereiche des Sekundärbereiches von einem gemeinsamen Werkstück gebildet sein können, welches unterschiedlich polarisiert ist. Die Vornahme der Polarisierung und das entsprechende Polarisationsverfahren sind an einer späteren Stelle dieser Anmeldung beschrieben. Diese Ausgestaltung der Erfindung ermöglicht eine besonders kompakte und einfache Bauweise.

Bei einer weiteren vorteilhaften Ausgestaltung der Erfindung sind die beiden Teilbereiche von einem gemeinsamen Werkstück gebildet, welches in unterschiedliche Richtungen polarisiert ist. Dies ermöglicht eine besonders einfache Bauweise.

Gemäß einer weiteren vorteilhaften Ausgestaltung der Erfindung sind der Primärbereich und der Sekundärbereich von einem gemeinsamen Werkstück gebildet, welches in wenigstens drei unterschiedliche Richtungen polarisiert ist. Dies ermöglicht eine besonders einfache und kompakte Bauweise.

Gemäß einer weiteren vorteilhaften Ausgestaltung der Erfindung sind der Primärbereich und der Sekundärbereich und/oder die Teilbereiche von unterschiedlichen Werkstücken gebildet, die aneinander befestigt sind. Dies ermöglicht eine modulartige Bauweise, die es beispielsweise zulässt, dass die Teilbereiche und der Primärbereich zunächst gesondert, nach der Herstellung, polarisiert werden, wobei erst anschließend eine Montage erfolgt. Die Montage kann mit geeigneten Verbindungsmitteln, beispielsweise mit geeigneten Klebemitteln, erfolgen. Entscheidend ist, dass die Verbindung eine Übertragung der Resonanzschwingungen von dem Primärbereich auf den Sekundärbereich zulässt. Geeignete Verbindungsmittel sind im Stand der Technik bekannt.

Gemäß einer weiteren vorteilhaften Ausgestaltung der Erfindung sind die beiden Teilbereiche voneinander geringfügig beabstandet. Dies ermöglicht einerseits die Bereitstellung eines Freiraumes zwischen den beiden Teilbereichen, der für eine mechanische und/oder elektrische Entkopplung der Teilbereiche sorgen kann. Der Freiraum kann auch einen Gasströmungskanal bereitstellen, der einerseits die Plasma-Erzeugung vorteilhaft beeinflusst und der andererseits auch ein Prozess- oder Arbeitsgas zur Plasma-Erzeugung bereitstellen kann. Schließlich kann der Gasströmungskanal auch das zu behandelnde, gasförmige Substrat führen.

Des Weiteren kann in dem entstehenden Freiraum zwischen den beiden Teilbereichen auch ein Isolatorelement angeordnet werden. Eine derartige Isolierstrecke kann für eine mechanische oder gegebenenfalls auch elektrische Entkopplung der beiden Teilbereiche sorgen, so dass es zur Ausbildung von hohen elektrischen Feldern oder Potentialdifferenzen nur entlang vorgegebener, bestimmter Bereiche kommt. Dies erhöht die Genauigkeit, mit der die Bereiche, in denen Plasma erzeugt wird, im Vorfeld festgelegt werden können.

Gemäß einer weiteren vorteilhaften Ausgestaltung der Erfindung ist jedem Teilbereich ein eigener Primärbereich zugeordnet. Dies bedeutet, dass einem ersten Teilbereich ein erster Primärbereich und einem zweiten Teilbereich ein zweiter Primärbereich zugeordnet ist. Die beiden Primärbereiche können über jeweils wenigstens ein eigenes Paar von Anschlusselektroden verfügen, so dass jeder Primärbereich gesondert mit Wechselspannung beaufschlagt wird. Dies bedeutet, dass für die beiden Primärbereiche wenigstens drei Elektroden vorgesehen sind. Eine Elektrode kann beiden Primärbereichen gemeinsam zugeordnet sein.

Von wesentlicher Bedeutung ist, dass die beiden Primärbereiche entweder phasengleich oder 180°-phasenversetzt angeregt werden, jedenfalls in Phase angeregt werden. Dies ermöglicht die effiziente und kontrollierte Generierung von hohen elektrischen Feldern und großen Potentialdifferenzen.

Bei einer weiteren vorteilhaften Ausgestaltung der Erfindung ist eine Vielzahl von Teilbereichen linear in Reihe, insbesondere quer zur Längsrichtung, angeordnet. Eine derartige Reihenanordnung von Teilbereichen kann eine in Linearrichtung beliebig lang gestreckte Bauform erlauben. Vorteilhafterweise ist jedem Teilbereich ein eigener Primärbereich zugeordnet, so dass jeweils zwischen zwei Teilbereichen ein Freiraum verbleiben kann. Die Zahl der Elektrodenpaare kann der Zahl der Teilbereiche entsprechen. Die Polarisationsrichtungen der Teilbereiche können entlang der Reihe alternieren. Damit wird jeweils zwischen zwei benachbarten Teilbereichen, vorzugsweise im Bereich ihrer freien Enden, die Erzeugung eines Plasmas möglich.

Bei einer weiteren vorteilhaften Ausgestaltung der Erfindung ist eine Vielzahl von Teilbereichen entlang einer Ebene nach Art eines Rasters angeordnet. Dies ermöglicht eine besonders großflächige Plasma-Erzeugung und entsprechend eine besonders großflächige Substratbearbeitung.

Die Erfindung betrifft des Weiteren eine Vorrichtung zur Erzeugung eines Atmosphärendruck-Plasmas gemäß dem Oberbegriff des Anspruches 21.

Die Erfindung geht wiederum aus von der zuvor erwähnten Itoh-Veröffentlichung. Die Aufgabe der Erfindung besteht gleichermaßen darin, die Erzeugung eines Atmosphärendruck-Plasmas zu verbessern.

Die Erfindung löst diese Aufgabe mit den Merkmalen des Anspruches 21, insbesondere mit denen des Kennzeichenteils, und ist demgemäß **dadurch gekennzeichnet, dass** der Sekundärbereich von zwei gesonderten Teilbereichen gebildet ist, die entlang der gleichen Polarisationsrichtung polarisiert sind, dass jedem Teilbereiche ein eigener Primärbereich zugeordnet ist, und dass die beiden Primärbereiche gegengetaktet angeordnet sind. Auf diese Weise generiert eine Anregung der beiden Primärbereiche eine Potentialdifferenz zwischen den beiden Teilbereichen in einer Richtung quer zur Längsrichtung.

Das Prinzip dieser Erfindung versteht sich am Besten in Analogie zur Betrachtung der oben geschilderten Funktionsweise einer Vorrichtung gemäß Anspruch 1.

Während gemäß Anspruch 1 zwei entgegengesetzt polarisierte Teilbereiche des Sekundärbereiches vorgesehen sind, verwendet die vorliegende Erfindung zwei gesonderte Teilbereiche, die entlang der gleichen Polarisationsrichtung polarisiert sind. Diese werden allerdings gegengetaktet angeregt, was auf unterschiedliche Weisen erfolgen kann. Eine gegengetaktete Anordnung der beiden Primärbereiche bedeutet z.B., dass beide Primärbereiche entlang der gleichen Polarisationsrichtung polarisiert sind und 180° phasenversetzt, aber in Phase, d.h. mit konstanter Phase, angeregt werden. Alternativ können die beiden Primärbereiche auch entlang entgegengesetzter Polarisationsrichtungen polarisiert sein und gleichphasig, d.h. ohne Phasenverschiebung, in Phase angeregt werden. Entscheidend ist, dass die Primärbereiche synchron, aber mit 180°-Phasenverschiebung schwingen, so dass die beiden gesonderten Teilbereiche des Sekundärbereiches ebenfalls mit konstanter Phase, aber zueinander entgegengesetzt, schwingen. Hierdurch werden gleichermaßen hohe elektrische Feldstärken zwischen den beiden Teilbereichen generiert, die die Erzeugung von Atmosphärendruck-Plasmen begünstigen.

Eine gegengetaktete Anordnung der beiden Primärbereiche beinhaltet beide beschriebenen Alternativen der Wahl der Polarisationsrichtungen der Primärbereiche und die entsprechende, zugehörige Elektrodengeometrie sowie die zugehörigen Spannungsversorgungsleitungen.

Die beiden gesonderten Teilbereiche und z.B. gleichermaßen auch die beiden zugehörigen Primär-Teilbereiche können voneinander beabstandet sein und zwischen sich entweder einen Freiraum, insbesondere in Form eines Gasströmungskanals, oder einen Isolator aufweisen. Im Falle eines Gasströmungskanals zwischen den beiden Teilbereichen kann es auch zu einer Plasmaerzeugung innerhalb des Gasströmungskanals kommen. Falls sich zwischen den beiden Teilbereichen ein Isolator befindet, erfolgt eine Plasmaerzeugung vorzugsweise an der freien Stirnseite der Teilbereiche, insbesondere entlang der Verbindungsflächen oder entlang der Grenzflächen zwischen den beiden Teilbereichen.

Bei einer vorteilhaften Ausgestaltung der Erfindung weisen die beiden Primärbereiche eine übereinstimmende Polarisationsrichtung auf und sind 180°-phasenversetzt anregbar. Eine phasenversetzte Anregung bedeutet, dass die beiden Primärbereiche in einer festen konstanten Phase zueinander angeregt werden, wobei eine Phasenverschiebung von 180° vorgesehen ist. Die beiden Primärbereiche können bei dieser Alternative entlang der gleichen Polarisationsrichtung polarisiert sein.

Alternativ weisen die beiden Primärbereiche entgegengesetzte Polarisationsrichtungen auf und sind phasengleich, d.h. ohne Phasenverschiebung, in Phase, anregbar.

Bei einer vorteilhaften Ausgestaltung der Erfindung verfügt jeder der beiden Primärbereiche über ein Paar von Elektroden. Dies bedeutet, dass jeder Primärbereich über ein gesondertes Paar von Elektroden verfügen kann. Alternativ kann auch eine Anordnung vorgesehen sein, wobei eine der Elektroden den beiden Primärbereiche gemeinsam zugeordnet ist, und wobei diese Elektrode zwischen den beiden Primärbereichen angeordnet ist.

Vorteilhafterweise sind jeweils ein Primärbereich und ein Teilbereich von einem gemeinsamen Werkstück gebildet. Dies ermöglicht eine besonders einfache Bauweise.

Weiter vorteilhaft sind die beiden Teilbereiche voneinander geringfügig beabstandet angeordnet. Dies ermöglicht die Anordnung eines Isolierelementes zwischen den beiden Teilbereichen oder alternativ die Anordnung eines Gasströmungskanals zwischen den beiden Teilbereichen.

Bei einer vorteilhaften Ausgestaltung der Erfindung ist eine Vielzahl von Teilbereichen linear in Reihe, insbesondere quer zur Längsrichtung, angeordnet. Dies ermöglicht die Konstruktion einer Vorrichtung mit einer Vielzahl von plasmaerzeugenden Bereichen, so dass insgesamt eine sehr großflächige Substratbearbeitung möglich wird.

Die Gegentaktung der zugehörigen Primärbereiche alterniert bei einer vorteilhaften Ausgestaltung der Erfindung entlang der Reihe der Teilbereiche. Dies bedeutet, dass eine Vielzahl von Teilbereichen beispielsweise unmittelbar benachbart oder unter Beabstandung entlang einer Reihe angeordnet ist, und sämtliche Teilbereiche eine gleiche Polarisationsrichtung aufweisen. Um Potentialdifferenzen quer zur Längsrichtung erzeugen zu können, müssen die den einzelnen Teilbereichen zugeordneten Primärbereiche synchron, aber 180°-phasenversetzt schwingen. Dies bedeutet, dass jeweils zwei benachbarte Primärbereiche zueinander gegengetaktet angeordnet sind. Wiederum kann dies durch zwei unterschiedliche alternative Ausführungen erreicht werden. Bei einer ersten Alternative sind die beiden benachbarten Primärbereich entlang der gleichen Polarisationsrichtung polarisiert, aber 180°-phasenversetzt angeregt. Bei einer zweiten Alternative weisen die Primärbereiche entgegengesetzte Polarisationsrichtungen auf und werden phasengleich, d.h. ohne Phasenverschiebung, in Phase angeregt.

Bei einer weiteren vorteilhaften Ausgestaltung der Erfindung ist eine Vielzahl von Teilbereichen entlang einer Ebene nach Art eines Rasters angeordnet. Hierdurch kann eine besonders großflächige Substratbearbeitung ermöglicht werden. Die Gegentaktung zugehöriger Primärbereiche kann bei dieser Ausführung der Erfindung entlang einer ersten und entlang einer zweiten Richtung alternieren. Damit wird die bezüglich Anspruch 33 und 34 beschriebene Vorrichtung aus der beschriebenen eindimensionalen Anordnung in eine zweidimensionale Anordnung überführt.

Die Erfindung betrifft des Weiteren eine Vorrichtung zur Erzeugung eines Atmosphärendruck-Plasmas gemäß dem Oberbegriff des Anspruches 37.

Die Erfindung geht wiederum aus von einer Vorrichtung, wie sie in der vorerwähnten Itoh-Veröffentlichung beschrieben ist.

Die Aufgabe der Erfindung besteht gleichermaßen darin, die bekannte Vorrichtung derartig weiterzuentwickeln, dass eine verbesserte und insbesondere effizientere Plasmaerzeugung möglich wird.

Die Erfindung löst diese Aufgabe mit den Merkmalen des Anspruches 37, insbesondere mit den Merkmalen des Kennzeichenteils, und ist demgemäß **dadurch gekennzeichnet, dass** eine zweite Einrichtung mit einem zweiten, gesonderten Primärbereich und mit einem zweiten, gesonderten, sich in Längsrichtung erstreckenden Sekundärbereich vorgesehen ist, dass die beiden Sekundärbereiche parallel zueinander und quer zur Längsrichtung voneinander beabstandet angeordnet sind, und dass die beiden Sekundärbereiche zwischen sich einen in Längsrichtung verlaufenden Gasführungskanal bilden.

Das Prinzip der Erfindung besteht im Wesentlichen darin, zwei Sekundärbereiche in einer Richtung quer zur Längsrichtung der Sekundärbereiche voneinander beabstandet, aber parallel zueinander, anzuordnen. Die beiden Sekundärbereiche können auf diese Weise zwischen sich einen in Längsrichtung verlaufenden Gasführungskanal bilden. Den beiden Sekundärbereichen ist jeweils ein gesonderter Primärbereich zugeordnet. Der Gasführungskanal erstreckt sich vorteilhafterweise auch zwischen den beiden gesonderten Primärbereichen hindurch.

Die beiden Primärbereiche werden in fester Phase zueinander phasengleich oder alternativ 180°-phasenversetzt, angeregt. Hierzu ist jeder der beiden Primärbereiche mit einem Paar von Elektroden versehen, an die eine Nieder-Wechselspannung angelegt wird. Die beiden Primärbereiche werden synchron angeregt, was bedeutet, dass die beiden Primärbereiche entweder entlang der gleichen Polarisationsrichtungen polarisiert sind und in Phase, entweder phasengleich oder 180°-phasenversetzt, angeordnet sind. Alternativ können die Primärbereiche auch entlang unterschiedlicher, insbesondere entlang entgegengesetzter Richtungen polarisiert sein.

Entscheidend ist, dass zwischen den beiden Sekundärbereichen ein Gasstrom hindurchgeführt werden kann, der von den elektrischen Feldern, die sich zwischen den beiden Sekundärbereichen ausbilden, beeinflusst werden kann. Die elektrischen Felder können sich aufgrund von Potentialdifferenzen bilden, die sich entweder entlang der Längsrichtung der jeweiligen Sekundärbereiche oder quer zu dieser Längsrichtung erstrecken. Die räumliche Verteilung der elektrischen Feldlinien hängt im Wesentlichen davon ab, wie die Sekundärbereiche polarisiert sind, nämlich ob zwei einander gegenüberliegende Sekundärbereiche entlang der gleichen Polarisationsrichtung oder entlang entgegengesetzter Polarisationsrichtungen polarisiert sind. Beide Alternativen sind möglich.

Wesentlich für das Funktionsprinzip dieser Erfindung ist, dass zwei einander gegenüberliegende Sekundärbereiche vorgesehen sind, so dass sich sehr genau vorherbestimmbare elektrische Feldgeometrien ergeben, wobei sich die elektrischen Felder überlagern und verstärken. Durch die synchrone Anregung der zugehörigen Primärbereiche und durch eine entsprechende synchrone Erzeugung elektrischer Felder entlang der sich einander gegenüberliegenden Sekundärbereiche wird die Plasmaerzeugung in dem Bereich zwischen den beiden Teilbereichen des Sekundärbereichs begünstigt.

Bei einer vorteilhaften Ausführungsform der Erfindung ist eine Vielzahl von Sekundärbereichen linear in einer Reihe angeordnet und bildet zwischen sich eine Vielzahl von in Längsrichtung verlaufenden Gasführungskanälen. Dies ermöglicht die Erzeugung großvolumiger oder großflächiger Plasmen.

Gemäß einer weiteren Ausgestaltung der Erfindung ist eine Vielzahl von Sekundärbereichen entlang einer Ebene, insbesondere nach Art eines Rasters angeordnet, und bildet zwischen sich eine Vielzahl von in Längsrichtung verlaufenden Gasführungskanälen. Dies ermöglicht die Erzeugung eines besonders großvolumigen bzw. eines besonders großflächigen Plasmas und gleichermaßen die Bearbeitung großflächiger oder großvolumiger Substrate.

Die Erfindung betrifft des Weiteren eine Vorrichtung zur Erzeugung eines Atmosphärendruck-Plasmas gemäß dem Oberbegriff des Anspruchs 40. Die Erfindung geht wiederum von der vorbeschriebenen Itoh-Veröffentlichung aus.

Der Erfindung liegt die Aufgabe zugrunde, die bekannte Vorrichtung derartig weiterzubilden, dass eine verbesserte Generierung von Plasma möglich wird.

Die Erfindung löst diese Aufgabe mit den Merkmalen des Anspruches 40, insbesondere mit denen des Kennzeichenteils, und ist demgemäß **dadurch gekennzeichnet, dass** der Sekundärbereich eine gekrümmte Innenfläche aufweist, die eine Wandung eines Gasführungskanals ausbildet.

Das Prinzip der Erfindung besteht im Wesentlichen darin, den Sekundärbereich gekrümmt auszubilden. In Folge der Krümmung erhält der Sekundärbereich eine gekrümmte Innenfläche. Die Innenfläche stellt erfindungsgemäß die Wandung eines Gasführungskanals bereit. Ein Arbeits- oder Prozessgas kann also unmittelbar entlang der Oberfläche des Sekundärbereiches geführt werden, wobei aufgrund der Krümmung eine vergrößerte Oberfläche erzielt wird. Damit kann eine Plasmaerzeugung in einem größeren Volumen bzw. entlang einer vergrößerten Oberfläche erzielt werden bzw. eine verbesserte Wechselwirkung zwischen dem Gas und dem Plasma erreicht werden. Die entlang der gekrümmten Innenfläche verlaufenden elektrischen Feldlinien begünstigen im Gegensatz zum Stand der Technik die Generierung von Plasma.

Insbesondere bietet diese Vorrichtung auch die Möglichkeit, auf gesonderte Behältnisse zur Führung eines Gases für die plasmaerzeugenden Bereiche vollständig zu verzichten. Das beim Stand der Technik erforderliche Behältnis, das den Verlauf der elektrischen Feldlinien bzw. die elektrischen Wechselfelder nachteilig beeinflusst, kann nun von dem Sekundärbereich selbst bereitgestellt werden, ohne dass es zu einer nachteiligen Beeinflussung kommt.

Die Innenfläche ist vorzugsweise um eine Krümmungslinie herum gekrümmt, die sich im Wesentlichen entlang der Längsrichtung des Sekundärbereiches erstreckt. Damit kann auch der Gasstrom entlang der Längsachse geführt werden.

Vorzugsweise ist der Primärbereich radial polarisiert. Dies bedeutet, dass die Polarisationsrichtung im Primärbereich auf die Krümmungslinie zu oder von dieser weggerichtet ist.

Gemäß einer vorteilhaften Ausgestaltung der Erfindung stellt die gekrümmte Innenfläche eine Begrenzungsfläche für das Atmosphärendruck-Plasma dar. Somit kann auf gesonderte Begrenzungsflächen verzichtet werden.

Die Erfindung betrifft des Weiteren eine Vorrichtung zur Erzeugung eines Atmosphärendruck-Plasmas gemäß dem Oberbegriff des Anspruchs 42.

Die Erfindung geht wiederum aus von der vorbeschriebenen Itoh-Veröffentlichung.

Der Erfindung liegt die Aufgabe zugrunde, die bekannte Vorrichtung derartig weiterzubilden, dass eine verbesserte Plasmaerzeugung möglich wird.

Die Erfindung löst diese Aufgabe mit den Merkmalen des Anspruches 42, insbesondere mit denen des Kennzeichenteiles, und ist demgemäß **dadurch gekennzeichnet, dass** in dem Sekundärbereich ein in Längsrichtung verlaufender, durchgehender Gasströmungskanal angeordnet ist, und dass der Sekundärbereich den Gasströmungskanal vollständig umrandet.

Das Prinzip der Erfindung besteht im Wesentlichen darin, dass der Sekundärbereich eine durchgehende Öffnung aufweist, die einen Gasströmungskanal bildet. Der Sekundärbereich umrandet den Gasströmungskanal vollständig. Der Sekundärbereich kann auch einen Mündungsbereich für einen Plasmajet bereitstellen. Innerhalb des Gasströmungskanals kann Plasma generiert werden, an das sich, abhängig von diversen Parametern, wie beispielsweise der Strömungsgeschwindigkeit des Gases, auch ein Plasmajet in Strömungsrichtung hinter der Mündung des Gasströmungskanals anschließen kann. Hierzu kann der Mündungsbereich auch düsenförmig ausgebildet sein.

Besonders vorteilhaft ist, dass auf gesonderte Behältnisse zur Bereitstellung eines Gasströmungskanals vollständig verzichtet werden kann. Die Wandungen der Durchgangsöffnung im Sekundärbereich können unmittelbar die Wandungen des Gasströmungskanals bereitstellen. Damit wird eine besonders vorteilhafte und optimierte Erzeugung eines Plasmas bei einfacher Bauweise der Vorrichtung möglich.

Gemäß einer vorteilhaften Ausgestaltung der Erfindung durchgreift der Gasströmungskanal auch den Primärbereich. Damit wird eine wabenartige Struktur der Einrichtung möglich, die im Idealfall aus einem einzigen Werkstück hergestellt werden kann. Die Herstellung einer derartigen Wabenstruktur wird nachfolgend noch beschrieben.

Wenn der Gasströmungskanal auch den Primärbereich durchgreift, ist der Primärbereich vorzugsweise radial polarisiert. Dies bedeutet, dass die Polarisationsrichtung im Primärbereich auf das Zentrum oder eine Mittellinie des Gasströmungskanals hin gerichtet oder von dieser weg gerichtet ist.

Eine derartige Polarisierung kann auf denkbar einfache Weise dadurch erfolgen, dass an der Innenseite des Gasführungskanals und an der Außenseite des Gasführungskanals Elektroden angebracht werden.

Gemäß einer vorteilhaften Ausgestaltung der Erfindung ist die Einrichtung im Wesentlichen rohrförmig ausgebildet. Eine derartige Struktur ermöglicht eine besonders einfache Bauweise.

Eine Vielzahl entsprechender rohrförmiger Einrichtungen kann z.B. in einer linearen Anordnung oder entlang einer Ebene, zu einem Raster angeordnet, zusammengefasst sein. Damit werden auch wabenartige Strukturen möglich, die großflächige bzw. großvolumige Plasmen erzeugen können.

Die Erfindung betrifft des Weiteren eine Vorrichtung zur Erzeugung eines Atmosphärendruck-Plasmas gemäß dem Oberbegriff des Anspruches 46.

Die Erfindung geht wiederum aus von der vorbeschriebenen Itoh-Veröffentlichung.

Der Erfindung liegt die Aufgabe zugrunde, eine verbesserte und effizientere Generierung von Atmosphärendruck-Plasma zu ermöglichen.

Die Erfindung löst diese Aufgabe mit den Merkmalen des Anspruches 46, insbesondere mit denen des Kennzeichenteiles, und ist demgemäß **dadurch gekennzeichnet, dass** in dem Sekundärbereich mehrere, in Längsrichtung verlaufende, durchgehende und zueinander parallele Gasströmungskanäle angeordnet sind.

Das Prinzip der Erfindung besteht im Wesentlichen darin, in dem Sekundärbereich eine Vielzahl von Gasströmungskanälen vorzusehen. Die Gasströmungskanäle verlaufen in Längsrichtung des Sekundärbereiches, so dass entlang der Richtung, entlang der sich Potenzialdifferenzen ausbilden, auch die Gasströmung erfolgt. Die Gasströmungskanäle führen zu einer wabenartigen Struktur des Sekundärbereiches. Dies ermöglicht eine besonders einfache und kompakte Bauweise der erfindungsgemäßen Vorrichtung sowie eine besonders großvolumige bzw. großflächige Plasmaerzeugung.

Weitere Vorteile der Erfindung ergeben sich anhand der nicht zitierten Unteransprüche sowie aus der nun folgenden Beschreibung zahlreicher, in den Figuren dargestellten Ausführungsbeispiele. In den Figuren zeigen:
- Fig. 1: in einer schematischen teilgeschnittenen Darstellung ein erstes Ausführungsbeispiel der erfindungsgemäßen Vorrichtung mit einem Sekundärbereich, der in zwei in entgegengesetzte Richtungen polarisierte Teilbereiche unterteilt ist,
- Fig. 2: die Vorrichtung gemäß Fig. 1 in perspektivischer Ansichtsdarstellung, wobei die Elektroden und die Spannungsversorgungsquelle der Übersicht halber weggelassen worden sind und wobei der Primärbereich und die beiden Teilbereiche des Sekundärbereichs von gesonderten Elementen gebildet sind,
- Fig. 3: in einer Darstellung gemäß Fig. 1 ein zweites Ausführungsbeispiel der erfindungsgemäßen Vorrichtung, wobei zwischen den beiden Teilbereichen des Sekundärbereiches eine Isolierstrecke angeordnet ist, und wobei jedem Teilbereich des Sekundärbereiches ein eigener zugehöriger Primärbereich zugeordnet ist,
- Fig. 4: in einer schematischen Darstellung ein weiteres Ausführungsbeispiel der erfindungsgemäßen Vorrichtung, bei dem die beiden Teilbereiche des Sekundärbereiches und die beiden zugehörigen Primärteilbereiche voneinander durch einen Freiraum beabstandet sind,
- Fig. 5: eine Reihenanordnung von Teilbereichen des Sekundärbereiches in einer Darstellung gemäß Fig. 1, wobei jedem Teilbereich ein in Primärteilbereiche unterteilter eigener Primärbereich zugeordnet ist,
- Fig. 6: die Vorrichtung gemäß Fig. 5 in einer Unteransicht gemäß Ansichtspfeil VI in Fig. 5,
- Fig. 7: ein weiteres Ausführungsbeispiel der erfindungsgemäßen Vorrichtung in Draufsicht auf die plasmaerzeugende Oberseite, wobei eine Vielzahl von Teilbereichen des Sekundärbereiches entlang einer Geraden angeordnet ist,
- Fig.8: ein weiteres Ausführungsbeispiel der erfindungsgemäßen Vorrichtung, bei dem die Teilbereiche des Sekundärbereiches von stabförmigen Körpern mit dreieckigem Querschnitt gebildet sind,
- Fig.9: ein weiteres Ausführungsbeispiel der erfindungsgemäßen Vorrichtung in einer Darstellung gemäß Fig. 8, wobei jedem Teilbereich ein eigener Primärteilbereich zugeordnet ist, und wobei die Teilbereiche und die Primärteilbereiche von stabförmigen Körpern mit im Wesentlichen quadratischem Querschnitt gebildet sind, wobei jeder stabförmige Körper von einem benachbarten stabförmigen Körper beabstandet ist,
- Fig. 10: ein weiteres Ausführungsbeispiel der erfindungsgemäßen Vorrichtung vergleichbar der Vorrichtung gemäß Fig. 9, wobei die stabförmigen Körper voneinander unbeabstandet sind,
- Fig. 11: ein weiteres Ausführungsbeispiel der erfindungsgemäßen Vorrichtung in einer Darstellung gemäß Fig. 9, wobei ein einzelner, zentrisch angeordneter stabförmiger Körper vorgesehen ist, der von einem ringförmigen Körper mit quadratischem Querschnitt unter Belassung eines Ringraumes umgeben ist,
- Fig.12: ein weiteres Ausführungsbeispiel der erfindungsgemäßen Vorrichtung in einer Darstellung gemäß Fig. 11, wobei drei konzentrisch angeordnete Körper unbeabstandet voneinander angeordnet sind,
- Fig. 13: ein weiteres Ausführungsbeispiel der erfindungsgemäßen Vorrichtung vergleichbar der Ausführungsbeispiele der Fig. 11 und 12, wobei im Unterschied zu der Darstellung der Fig. 11 bei diesem Ausführungsbeispiel der zentrale Körper selbst eine Durchgangsöffnung aufweist,
- Fig. 14: ein weiteres Ausführungsbeispiel der erfindungsgemäßen Vorrichtung, bei dem zwei im Wesentlichen quaderförmige Körper voneinander beabstandet sind, so dass die beiden Primärteilbereiche und die beiden Teilbereiche des Sekundärbereiches zwischen sich einen Gasströmungskanal ausbilden,
- Fig. 15: in einer Darstellung gemäß Fig. 14 ein weiteres Ausführungsbeispiel der Erfindung, bei dem zwischen den beiden quaderförmigen Körpern eine Isolierstrecke angeordnet ist,
- Fig. 16: ein weiteres Ausführungsbeispiel der erfindungsgemäßen Vorrichtung mit zwei Teilbereichen eines Sekundärbereiches, die entlang der gleichen Polarisationsrichtung polarisiert sind,
- Fig. 17: ein weiteres Ausführungsbeispiel der erfindungsgemäßen Vorrichtung, bei dem zwischen den beiden Sekundärbereichen und den zugehörigen Primärteilbereichen ein Freiraum angeordnet ist,
- Fig. 18: ein weiteres Ausführungsbeispiel der erfindungsgemäßen Vorrichtung mit einer zentralen Durchgangsöffnung,
- Fig. 19: ein weiteres Ausführungsbeispiel der Erfindung vergleichbar dem Ausführungsbeispiel der Fig. 18,
- Fig. 20: ein weiteres Ausführungsbeispiel der erfindungsgemäßen Vorrichtung mit einer Vielzahl von Durchtrittsöffnungen,
- Fig.21: ein weiteres Ausführungsbeispiel der erfindungsgemäßen Vorrichtung mit einer im Wesentlichen nahezu rohrförmigen, zylindrischen Einrichtung zur Erzeugung eines Plasmajets,
- Fig. 22: eine Multi-Plasmajetquelle in einer Darstellung gemäß Fig. 21,
- Fig. 23: eine Vorrichtung gemäß Fig. 22. in Untersicht, etwa gemäß Ansichtspfeil XXIII in Fig. 22,
- Fig. 23a: eine Draufsicht auf die Vorrichtung gemäß Ansichtspfeil XXIIIa in Fig. 22,
- Fig. 24: ein weiteres Ausführungsbeispiel der erfindungsgemäßen Vorrichtung,
- Fig. 25: ein weiteres Ausführungsbeispiel der erfindungsgemäßen Vorrichtung mit einem düsenartig verjüngtem Gasströmungskanal,
- Fig.26: ein weiteres Ausführungsbeispiel der erfindungsgemäßen Vorrichtung,
- Fig. 27: ein weiteres Ausführungsbeispiel der erfindungsgemäßen Vorrichtung zur Veranschaulichung des physikalischen Grundprinzips,
- Fig. 28: ein weiteres Ausführungsbeispiel der erfindungsgemäßen Vorrichtung zur Veranschaulichung eines weiteren physikalischen Grundprinzips,
- Fig. 29: ein weiteres Ausführungsbeispiel der erfindungsgemäßen Vorrichtung mit einer besonderen, innen liegenden Elektrode,
- Fig. 30: ein weiteres Ausführungsbeispiel der erfindungsgemäßen Vorrichtung mit einem Gehäuse,
- Fig.31: ein weiteres Ausführungsbeispiel der erfindungsgemäßen Vorrichtung mit einer schräg gestellten Schichtstrukturanordnung, wobei die einzelnen Schichten beispielsweise aus laminierten Keramikfolien mit aufgedruckten Elektroden bestehen,
- Fig. 32: ein weiteres Ausführungsbeispiel der erfindungsgemäßen Vorrichtung in einer Unteransicht ähnlich der Darstellung der Fig. 6,
- Fig. 33: ein weiteres Ausführungsbeispiel der erfindungsgemäßen Vorrichtung in einer schematischen, teilgeschnittenen, perspektivischen Darstellung nach Art einer Wellblechstruktur,
- Fig. 33a: ein weiteres Ausführungsbeispiel der erfindungsgemäßen Vorrichtung mit zwei schematisch dargestellten Wellblechstrukturen etwa in einer Ansichtsdarstellung gemäß Ansichtspfeil XXXIIIa in Fig. 33, und
- Fig. 33b: ein weiteres Ausführungsbeispiel ähnlich der Fig. 33a, bei dem die beiden Wellblechstrukturen parallel zueinander sind.

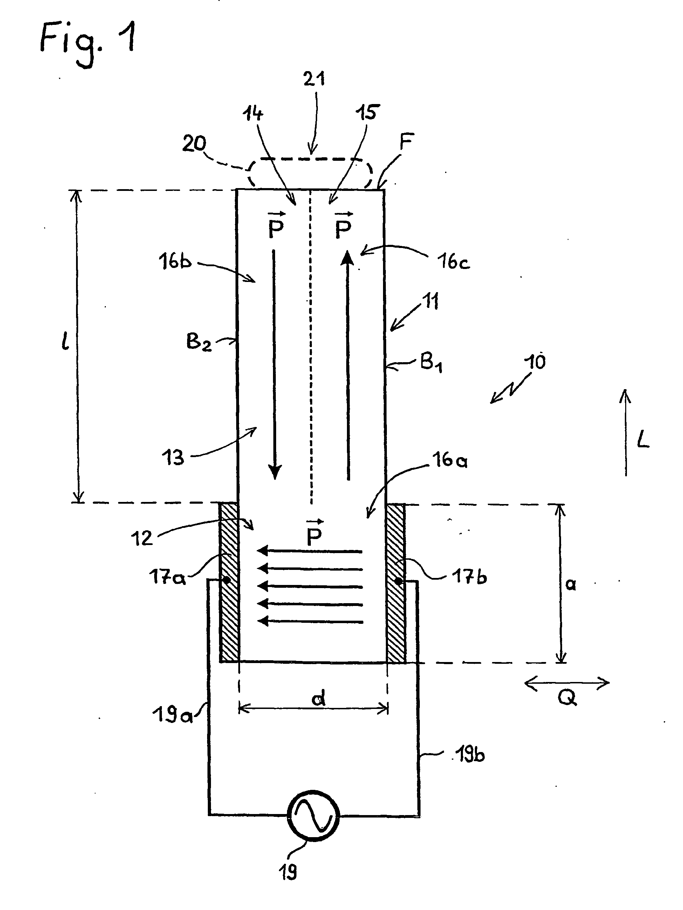

Die in ihrer Gesamtheit mit 10 bezeichnete erfindungsgemäße Vorrichtung zur Erzeugung eines Plasmas soll hinsichtlich einer ersten Variante der Erfindung zunächst anhand der Fig.1 von ihrem Grundprinzip her erläutert werden. Angemerkt sei vorab, dass in der nachfolgenden Figurenbeschreibung, auch soweit unterschiedliche Ausführungsbeispiele betroffen sind, gleiche oder vergleichbare oder funktionsgleiche Teile oder Elemente der Übersichtlichkeit halber mit gleichen Bezugszeichen und mit gleichen Buchstaben, teilweise unter Hinzufügen kleiner, angehängter Buchstaben bezeichnet sind.

Fig. 1 zeigt ein erstes Ausführungsbeispiel einer erfindungsgemäßen Vorrichtung 10, die eine Einrichtung 11 aus piezo-elektrischem Material umfasst. Als piezo-elektrisches Material kommen geeignete, einen piezoelektrischen Effekt zeigende Materialien, wie beispielsweise PXE-Keramiken, wie Blei-, Zirkonat-Titanate Pb(ZrTi)O₃ in Betracht.

Die Einrichtung 11 kann beispielsweise von einem einzigen Werkstück gebildet sein, welches in drei Zonen 16a, 16b 16c unterschiedlicher Polarisation unterteilt ist. Die Polarisationsrichtungen sind mit Pfeilen P angedeutet.

Eine Polarisationsrichtung eines piezo-elektrischen Materials wird generiert, indem eine hohe Polarisationsspannung angelegt wird, so dass die gesamten Weis'schen Dipol-Bezirke in dem Material in diese, durch die angelegte Spannung bzw. durch die Elektrodengeometrie vorgegebene Richtung umklappen. Die Polarisationsrichtung wird daher durch die kürzeste geometrische Verbindung zwischen den beiden angelegten Elektroden und durch deren Polung vorgegeben.

Gemäß Fig. 1 weist die Einrichtung 11 eine Primärzone 12 oder einen Primärbereich mit im Wesentlichen in Querrichtung Q verlaufender Polarisationsrichtung P und eine Sekundärzone 13 oder Sekundärbereich mit in und entgegen der Längsrichtung L verlaufenden Polarisationsrichtungen auf.

Die Einrichtung 11 gemäß Fig. 1 kann beispielsweise die Form eines Quaders aufweisen, der sich senkrecht zur Papierebene entlang einer Strecke s erstreckt, die z. B. größer ist als die Breite d der Einrichtung 11.

An den entsprechend gebildeten Breitseiten B1 und B2 der Einrichtung 11 sind im Primärbereich 12 im Wesentlichen plattenförmige Elektroden 17a und 17b angebracht. Die Elektroden können beispielsweise aufgedruckt, aufgesputtert oder auf sonstige geeignete Arten befestigt sein.

Die beiden Elektroden 17a und 17b sind über Spannungsversorgungsleitungen 10a und 10b mit einer Spannungsversorgungsquelle 19 verbunden, die eine Niedervolt-Wechelspannung einer vorgegebenen Frequenz und mit einer Amplitude von weniger als 500 Volt generiert.

Wird der Primärbereich 12 mit einer zu bestimmenden Resonanzfrequenz von beispielsweise 100KHz angelegt, kommt es aufgrund der angelegten elektrischen Wechselspannung zu mechanischen Schwingungen des Primärbereiches 12, die zu periodischen Änderungen der Dicke d des Primärbereiches 12 zwischen den Elektroden 17a, 17b führen. Diese mechanischen Schwingungen werden auch auf den Sekundärbereich 13 übertragen.

Der Sekundärbereich 13 ist auf erfindungemäße Weise in zwei Teilbereiche 14 und 15 unterteilt, die unterschiedliche, und zwar entgegengesetzte Polarisationsrichtungen P aufweisen. Schwingt nun der Sekundärbereich 13 ebenfalls in Resonanz, so kommt es zur Ausbildung von elektrischen Feldern bzw. von Potentialdifferenzen entlang der Länge I des Sekundärbereiches 13 in Längsrichtung L.

Die größten Potentialdifferenzen und damit die größten elektrischen Feldstärken treten allerdings im Verbindungsbereich 21 zwischen den beiden Teilbereichen 14 und 15 auf, und zwar insbesondere im freien Endbereich des Sekundärbereichs 13. Dort kommt es zur Ausbildung eines Plasmas 20, wie es in Fig. 1 durch eine flach ausgebildete Plasmawolke angedeutet ist.

Mit der in Fig. 1 beschriebenen Vorrichtung kann daher ein Stirnflächenplasma mit hoher Effizienz generiert werden.

Die Einrichtung 11 stellt einen Piezo-Transformator (PT) bereit und ermöglicht die Erzeugung von Hochspannungspotentialdifferenzen entlang des Sekundärbereiches 13 durch eine Niederspannungsquelle 19. Damit kann eine besonders kompakt und einfach aufgebaute erfindungsgemäße Vorrichtung realisiert werden.

Unter Bezugnahme auf Fig. 1 sei angemerkt, dass der Primärbereich 12 und der Sekundärbereich 13 mit den beiden Teilbereichen 14 und 15 aus einem einzigen Werkstück gebildet sein kann, welches in die drei Zonen 16a, 16b, 16c mit unterschiedlichen Polarisationsrichtungen durch Anlegen entsprechender Polarisationsspannungen und durch Anordnung geeigneter Elektroden unterteilt sein kann.

Alternativ kann der Primärbereich 12, was in Fig. 1 nicht dargestellt ist, aus einem gesonderten Werkstück gebildet sein, das mit dem Sekundärbereich 13 verbunden ist. Schließlich besteht auch die Möglichkeit, die beiden Teilbereiche 14 und 15 des Sekundärbereiches 13 von unterschiedlichen Werkstücken bereitzustellen, die, was in Fig. 1 nicht dargestellt ist, ebenfalls miteinander mechanisch verbunden sein können. Zusammenfassend bleibt festzustellen, dass die Einrichtung 11 gemäß Fig. 1 aus ein, zwei oder drei unterschiedlichen Werkstücken gebildet sein kann.

Angemerkt sei an dieser Stelle, dass der Primärbereich 12 aus einem oder aus einer Vielzahl von Werkstücken gebildet sein kann. Fig. 1 zeigt eine Anordnung, bei der dem Primärbereich 12 zwei Elektroden 12a und 12b zugeordnet sind. Der Primärbereich kann aber auch in eine Vielzahl von Teilbereichen unterteilt sein, wobei eine Vielzahl von Elektroden mit alternierender Spannung vorgesehen sein kann. Ein solcher Schichtaufbau wird später noch erläutert werden.

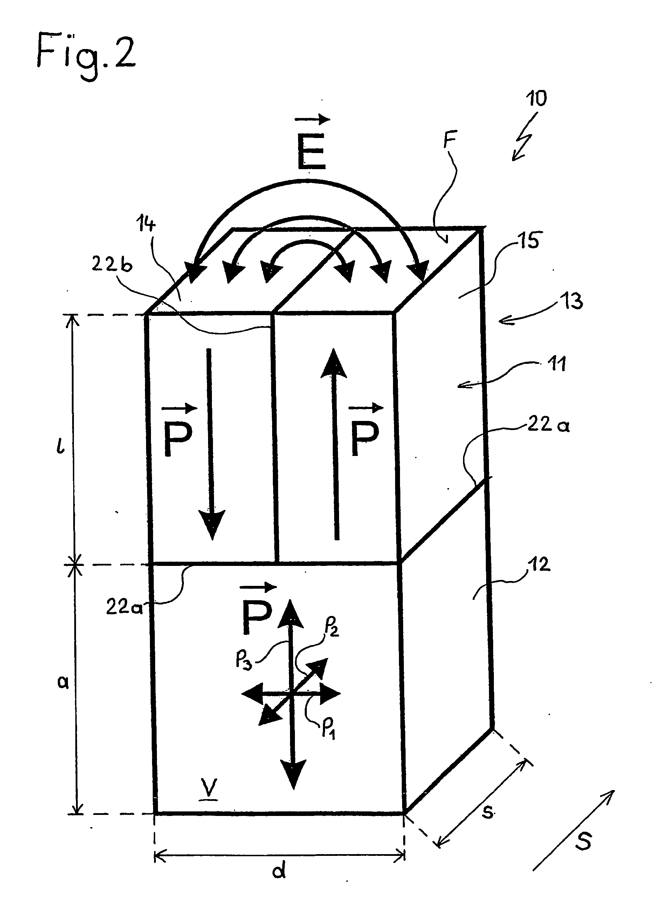

Anhand der Fig. 2 soll nun das Funktionsprinzip der erfindungsgemäßen Vorrichtung 10 weiter erläutert werden. Hier sind der Primärbereich 12 und der Sekundärbereich 13 mit den beiden Teilbereichen 14 und 15 jeweils von gesonderten Elementen gebildet. Im Bereich der Grenzschichten 22a, 22b finden sich geeignete Verbindungsmittel, wie beispielsweise Klebstoffe, die eine ausreichende mechanische Verbindung bewerkstelligen und insbesondere für eine Übertragung der mechanischen Schwingungen von dem Primärbereich 12 auf den Sekundärbereich 13 sorgen.

Fig. 2 macht deutlich, dass der Primärbereich 12 entlang unterschiedlicher Polarisationsrichtungen P1, P2 oder P3 polarisiert sein kann. Die Polarisationsrichtung P1 gemäß Fig. 2 entspricht dabei der Polarisationsrichtung P gemäß Fig. 1, wobei die Elektroden bei der Vorrichtung gemäß Fig. 2 nicht dargestellt sind. Auf die Orientierung der Polarisationsrichtung P₁ kommt es dabei zunächst nicht an. Alternativ könnte der Primärbereich 12 aber auch entlang der Polarisationsrichtung P₂ polarisiert sein, wobei dann an der in Fig. 2 dargestellten Vorderseite V und an der in Fig. 2 nicht dargestellten rückwärtigen Seite flächige Elektroden angeordnet sein müssten, so dass die Verbindungslinie der Elektroden der Polarisationsrichtung P₂ entspricht.

Eine in Polarisationsrichtung P₂ gewählte Polarisation würde in gleicher Weise eine mechanische resonante Schwingung des Primärbereiches 12 generieren und entsprechend eine mechanische Schwingung des Sekundärbereiches 13 hervorrufen, die letztendlich die in Fig. 2 durch E-Pfeile angedeuteten elektrischen Felder generiert.

Der Übersichtlichkeit halber ist in Fig. 2 das generierte Plasma an der Oberseite F der Einrichtung 11 nicht dargestellt.

Fig. 2 zeigt schließlich der Vollständigkeit halber noch eine Polarisationsrichtung P3, die im Wesentlichen parallel zu den Polarisationsrichtungen P des Sekundärbereiches verläuft. Dies soll andeuten, dass durch Anordnung von Elektroden beispielsweise im Bereich des unteren Endes des Primärbereiches 12 und im Bereich des oberen Endes des Primärbereiches 12 theoretisch die Möglichkeit besteht, den Primärbereich 12 gleichermaßen anzuregen. Eine derartige Bauform weist zwar in konstruktiver Hinsicht Nachteile auf, kann das erfindungsgemäße Prinzip aber dennoch erzielen.

Unter Bezugnahme auf die Figuren 1 und 2 sei angemerkt, dass jeweils ein Primärbereich 12 oder ein später noch zu erläuternder Primärteilbereich insgesamt in resonante Schwingungen durch Anlegen elektrischer Wechselfelder gebracht werden muss. Hierzu genügen grundsätzlich zwei voneinander beabstandete Elektroden, die zwischen sich den piezo-elektrischen Materialbereich (Primärbereich) der Dicke (D) einfassen können. Alternativ kann entlang der Dicke oder Breite D des Primärbereiches 12 auch eine Vielzahl paralleler Elektrodenplatten angeordnet sein, so dass eine Schichtstruktur, wie sie auch später noch an anderen Ausführungsbeispielen erläutert sein wird, entsteht. Diese Schichtstruktur ist beim Aufbau zunächst komplizierter, kann aber den Vorteil besitzen, dass das Übertragungsverhältnis der angeregten Niedervoltspannung zu der zu erzielenden Hochspannung verbessert wird. Bei Anordnung von mehr als zwei Elektroden an einem Primärbereich, der insgesamt einheitlich schwingen soll, ist eine entsprechende Beschaltung der Elektroden bzw. eine entsprechende Abfolge der Polarisationsrichtungen der Abschnitte des Primärbereiches erforderlich. Dies wird im Detail noch später erläutert werden.

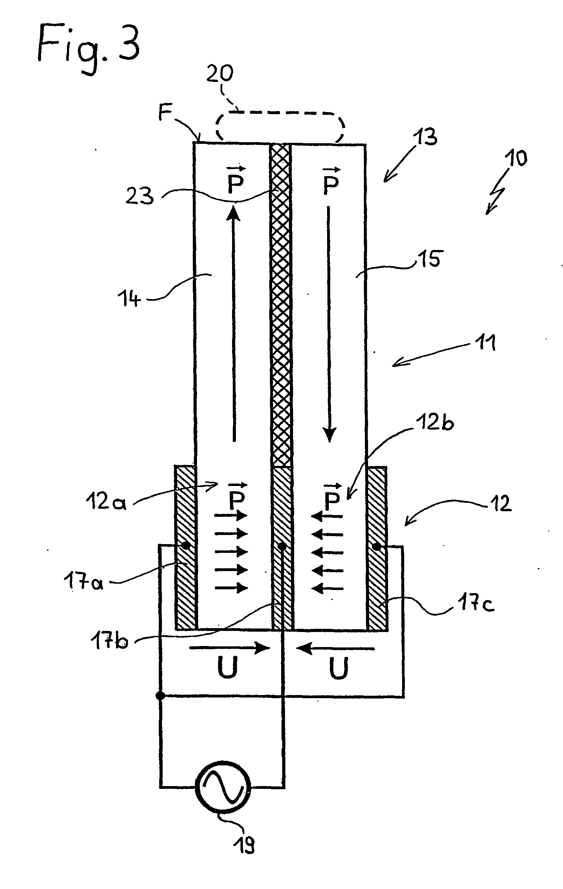

Fig. 3 zeigt ein weiteres Ausführungsbeispiel der erfindungsgemäßen Vorrichtung in einer Darstellung vergleichbar der Fig. 1. Die erfindungsgemäße Vorrichtung 10 umfasst bei dieser Variante eine Einrichtung 11, die zwei gesonderte Primärbereiche 12a und 12b sowie zwei räumlich getrennte Teilbereiche 14 und 15 entgegengesetzter Polarisation aufweist. Zwischen den beiden Teilbereichen 14 und 15 des Sekundärbereiches 13 befindet sich bei dem Ausführungsbeispiel gemäß Fig. 3 ein Isolierelement 23. Es kann sich dabei um ein mechanisches und/oder um ein elektrisches Isolierelement handeln. Das mechanische Isolierelement kann die beiden Teilbereiche 14 und 15 hinsichtlich der mechanischen Schwingungen zumindest teilweise voneinander entkoppeln. Das elektrische Isolierelement 23 kann dafür sorgen, dass die elektrischen Felder im Bereich der einander zugewandten Grenzflächen der beiden Teilbereiche 14 und 15 keine nachteiligen Effekte generieren, und das Plasma 20 lediglich im Bereich der Stirnfläche F der Einrichtung 11 erzeugt wird.

Die beiden Primärbereiche oder Primärteilbereiche 12a und 12b weisen jeweils ein eigenes Paar Elektroden auf. Anhand von Fig. 3 wird allerdings deutlich, dass die beiden Primärbereiche 12a und 12b auch eine gemeinsame Elektrode 17b aufweisen können.

Die drei Elektroden 17a, 17b, 17c sind mit einer Niederspannungsquelle 19 verbunden und werden in Phase, und zwar phasengleich angeregt. Der durch die beiden Primärbereiche 12a und 12b gebildete Gesamtprimärbereich 12 bei dem Ausführungsbeispiel gemäß Fig. 3 entspricht also dem Primärbereich 12 der Vorrichtung 10 gemäß Fig. 1 und schwingt insgesamt synchron.

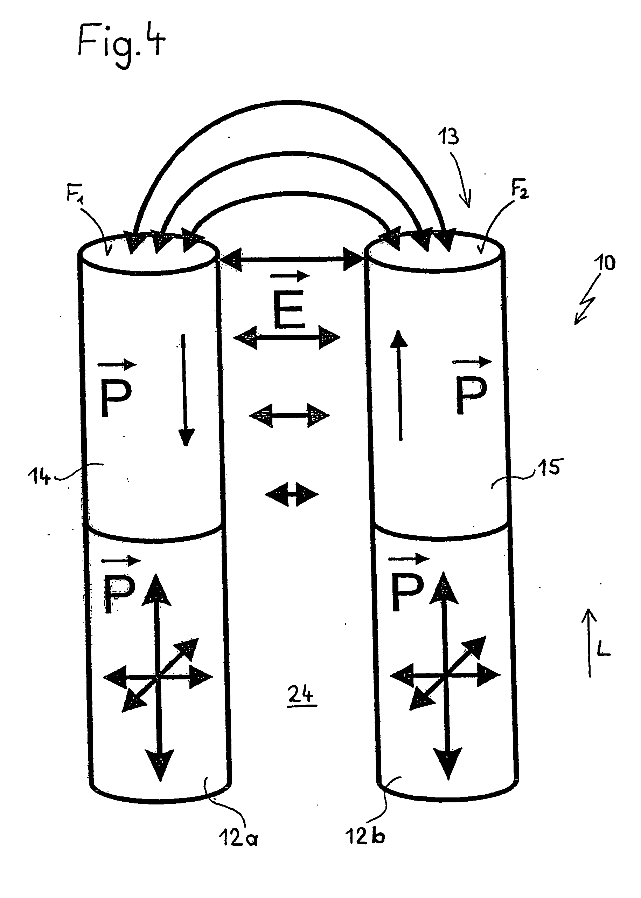

Fig. 4 zeigt ein weiteres Ausführungsbeispiel einer erfindungsgemäßen Vorrichtung 10, bei der die beiden Primärbereiche 12a und 12b und die beiden Teilbereiche 14 und 15 des Sekundärbereiches 13 durch einen Freiraum 24 vollständig voneinander getrennt sind. Der Freiraum 24 stellt einen Gasströmungskanal bereit, durch den hindurch ein geeignetes Arbeits- oder Trägergas in Längsrichtung L durchströmen kann. Fig. 4 verdeutlicht die Ausbildung der elektrischen Felder E, die die Potentialdifferenzen verdeutlichen und entlang der sich ein Plasma ausbilden kann. Fig. 4 zeigt, dass die größten elektrischen Feldstärken im Bereich zwischen den beiden Stirnseiten F1 und F2 der beiden Teilbereiche 14, 15 auftreten.

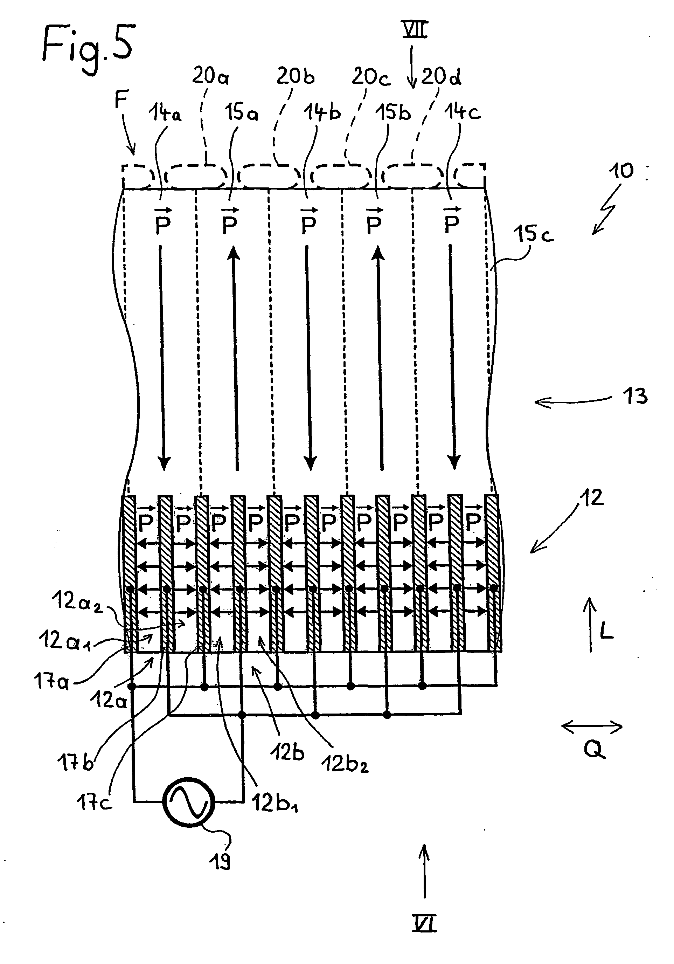

Fig. 5 zeigt eine Vorrichtung 10, die eine Reihenanordnung einer Vielzahl von Teilbereichen 14a, 14b, 14c und 15a, 15b, 15c etc. vorsieht. Der Sekundärbereich 13 ist demzufolge von einer Reihenanordnung von beispielsweise quaderförmig ausgebildeten Teilbereichen 14a, 15a, 14b, 15b, 14c, 15c gebildet.

Zwischen jeweils zwei Teilbereichen unterschiedlicher Polarisation, z. B. zwischen den Teilbereichen 14a und 15a, bildet sich eine Plasmawolke 20a aus. Sämtliche mit 14 bezeichneten Teilbereiche weisen eine Polarisierung entlang einer ersten Polarisationsrichtung und sämtliche mit 15 bezeichneten Teilbereiche weisen eine Polarisierung in entgegengesetzter Polarisationsrichtung auf.

Der Primärbereich 12 ist in eine Vielzahl von einzelnen Primärbereichen unterteilt. Beispielsweise weist der Teilbereich 14a einen zugehörigen Primärbereich 12a auf, der in einen Primärteilbereich 12a1 und einen zweiten Primärteilbereich 12a2 mit entgegengesetzter Polarisation unterteilt ist. Der Primärbereich 12a weist drei Elektroden 17a, 17b und 17c auf, die über Spannungsversorgungsleitungen mit der Spannungsversorgung 19 verbunden sind. Die beiden Primärteilbereiche 12a1 und 12a2 werden in Phase, das heißt phasengleich, angeregt, so dass der gesamte Primärbereich 12 resonant schwingt und seine Schwingungen auf den entsprechenden Teilbereich 14a übertragen kann. Auch die anderen Primärbereiche 12b sowie die in Fig. 5 dargestellten, aber nicht bezeichneten Primärbereiche schwingen alle insgesamt synchron, so dass es zwischen jeweils zwei einander benachbarten Teilbereichen unterschiedlicher Polarisation im Bereich der Oberseite F zur Ausbildung einer Plasmawolke 20a, 20b, 20c kommt.

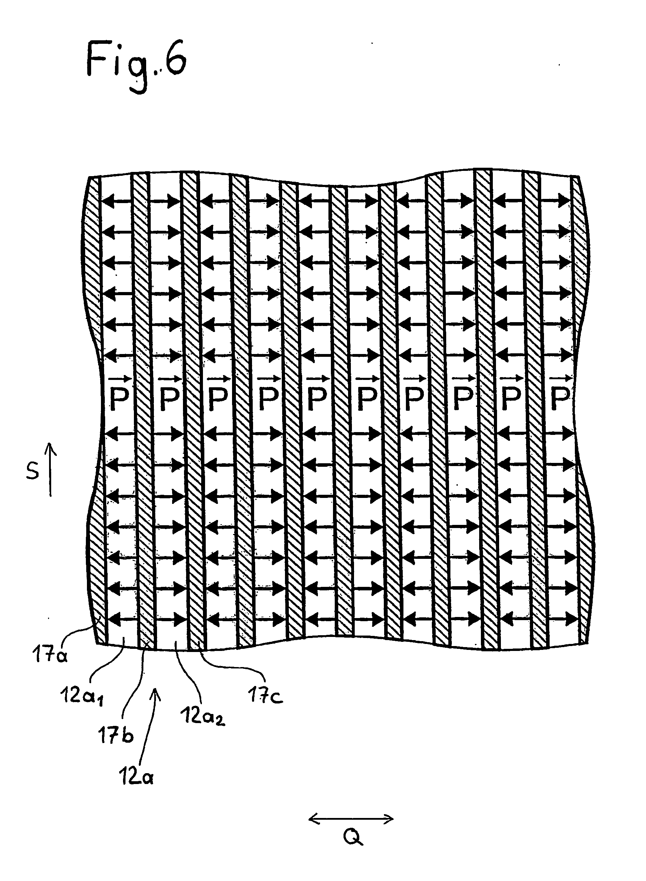

Fig. 6 verdeutlicht in einer Unteransicht gemäß Ansichtspfeil VI in Fig. 5 die geometrische Struktur des Primärbereiches 12 und zeigt, dass der Primärbereich 12 von mehreren in Richtung S lang gestreckten Elementen nach Art einer Schichtstruktur gebildet ist. Jeweils ein Primärteilbereich (z B. 12a1) ist von einem scheibenartigen Element gebildet, und zwischen jeweils zwei Primärteilbereichen, z. B. zwischen den Primärteilbereichen 12a1 und 12a2, befindet sich eine Elektrode. Damit wird deutlich, dass sich die Plasmawolken 20a, 20b, 20c an der Oberseite F der Vorrichtung 10 ebenfalls in Richtung S axial erstrecken, so dass es dort zu einem streifenförmigen Muster von Plasmawolken kommen kann.

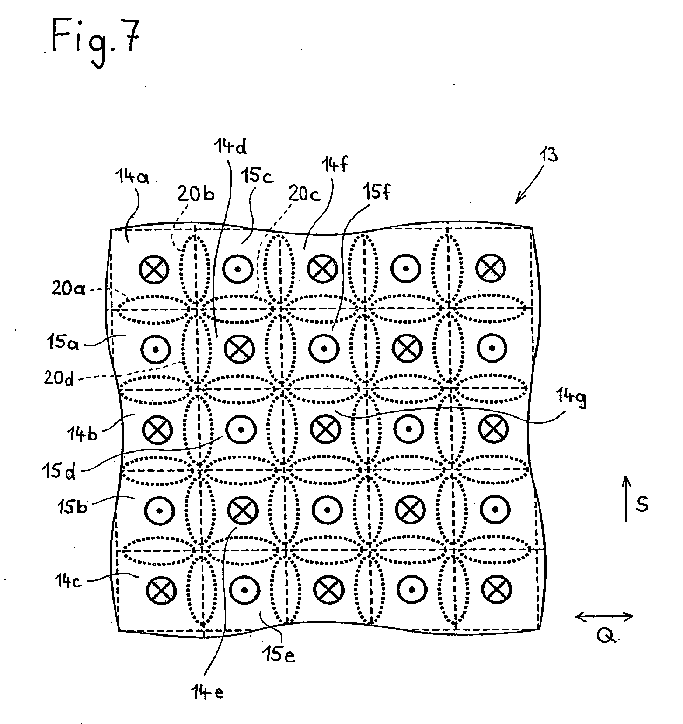

Fig. 7 macht schließlich deutlich, dass eine Vielzahl von Teilbereichen 14a, 14b, 14c, 14d, 14e, 14f, 14g, 15a, 15b, 15c, 15d, 15e, 15f des Sekundärbereiches 13 auch entlang einer Ebene, nach Art eines Rasters, angeordnet sein kann. Die Teilbereiche 14, 15 können so hinsichtlich ihrer Polarisationsrichtung auch entlang der Richtung S alternieren. Die in Fig. 7 gewählte Darstellung zeigt die Oberseite F einer Vorrichtung 10 in Draufsicht. Es wird deutlich, dass eine Vielzahl von kleeblattartig ausgebildeten Plasmawolken 20a, 20b, 20c, 20d generiert wird.

Jeweils zwei benachbarte Teilbereiche, z. B. die Teilbereiche 14a, 15c oder die Teilbereiche 14a und 15a weisen entgegengesetzte Polarisationsrichtungen auf, was durch die Symbole des eingekreisten x und des eingekreisten Punktes angedeutet ist. Die Polarisationsrichtungen benachbarter Teilbereiche alternieren also sowohl in Querrichtung Q als auch in Richtung des Pfeiles S.

Fig. 7 verdeutlicht, dass eine sehr großflächige Plasmaerzeugung und damit auch eine großflächige Substratbearbeitung möglich wird. Ein zu bearbeitendes Substrat kann entlang der Oberfläche F bewegt oder die Vorrichtung 10 kann relativ zu einen feststehenden Substrat bewegt werden.

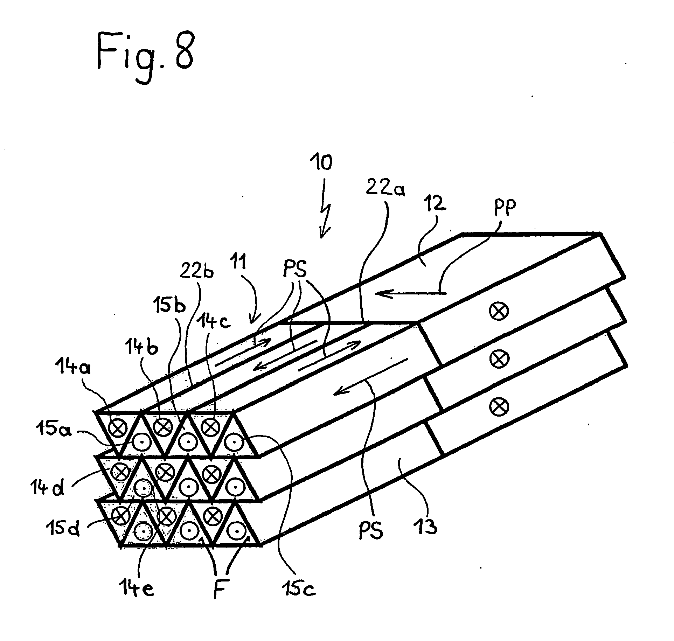

Anhand der Figuren 8 bis 15 sollen nun grundsätzlich unterschiedliche Geometrien von Ausführungsbeispielen erfindungsgemäßer Vorrichtungen zur Erzeugung eines Plasmas erläutert werden.

Angemerkt sei an dieser Stelle, dass in den Fig. 8 bis 15 der Übersichtlichkeit halber die Elektroden, die an dem Primärbereich oder an dem Primärteilbereich angeordnet sind, nicht dargestellt sind.

Fig. 8 zeigt eine Einrichtung 11 mit einem Primärbereich 12 und einen Sekundärbereich 13. Der Sekundärbereich 13 ist in eine Vielzahl von Teilbereichen 14a, 14b, 14c, 14d, 14e, 15a, 15b, 15c, 15d unterteilt, die von stabförmigen, im Querschnitt dreieckförmigen Körpern gebildet sind. Jeweils im Bereich der Begrenzungsflächen 22b zwischen zwei unterschiedlich polarisierten Teilbereichen, z. B. zwischen den Teilbereichen 14a und 15a, kommt es an der Stirnseite zur Ausbildung einer in Fig. 8 nicht dargestellten Plasmawolke.

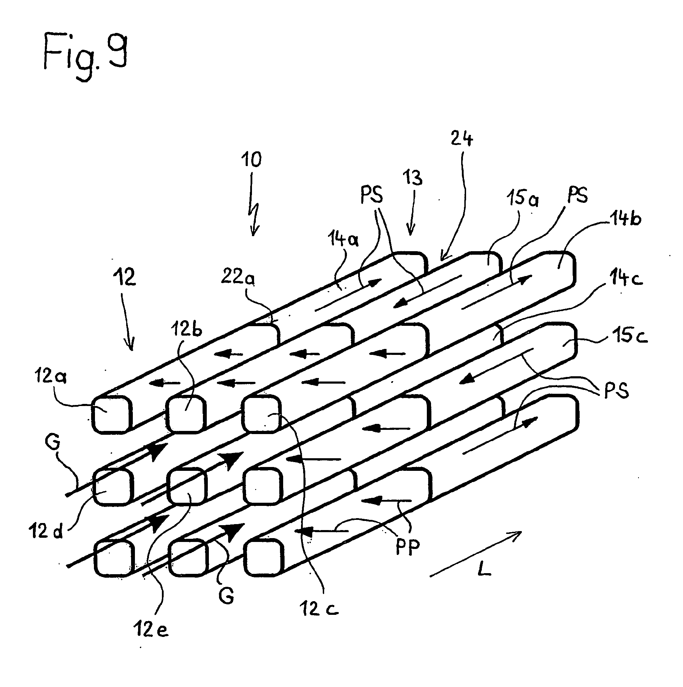

Bei einer alternativen Ausgestaltung einer Vorrichtung 10 gemäß Fig. 9 sind der Primärbereich 12 und der Sekundärbereich 13 jeweils von einer Vielzahl von Teilbereichen gebildet. So ist der Primärbereich 12 von Primärteilbereichen 12a 12b, 12c, 12d, 12e und der Sekundärbereich 13 von entsprechenden Sekundärteilbereichen 13a, 13b, 13c, usw. gebildet, wobei neun Sekundärteilbereiche und neun Primärbereiche dargestellt, aber nicht alle bezeichnet sind.

Benachbarte Teilbereiche 14a, 14b, 14c, 15a, 15c sind wiederum entgegengesetzt polarisiert, so dass sich jeweils zwischen zwei Teilbereichen 14a, 15a unterschiedlicher Polarisierung hohe elektrische Felder ausbilden können. Zwischen jeweils zwei Teilbereichen 14a, 15a erstreckt sich ein Gasströmungskanal 24 hindurch, der in Längsrichtung L verläuft. Die in Fig. 9 dargestellten Pfeile G veranschaulichen den Gasstrom.

Sämtliche Primärteilbereiche 12a, 12b, 12c, 12d, 12e etc. werden in fester Phasenbeziehung zueinander, das heißt insbesondere phasengleich angeregt, so dass sich die Erzeugung der elektrischen Felder zwischen den Teilbereichen 14a, 14b, 14c und 15a, 15b, 15c kontrollieren lässt.

Fig. 9 macht deutlich, dass ein zwischen zwei Teilbereichen 15a, 14b entgegengesetzter Polarisation durchströmender Gasstrom durch ein Plasma hindurchgeführt werden kann, das sich nicht nur ausschließlich im Bereich der Stirnseiten der Teilbereiche 15a, 14b erzeugen lässt, sondern auch im Bereich des Strömungskanals 24. Dies ermöglicht eine verbesserte Wechselwirkung des Gasstromes mit dem Plasma.

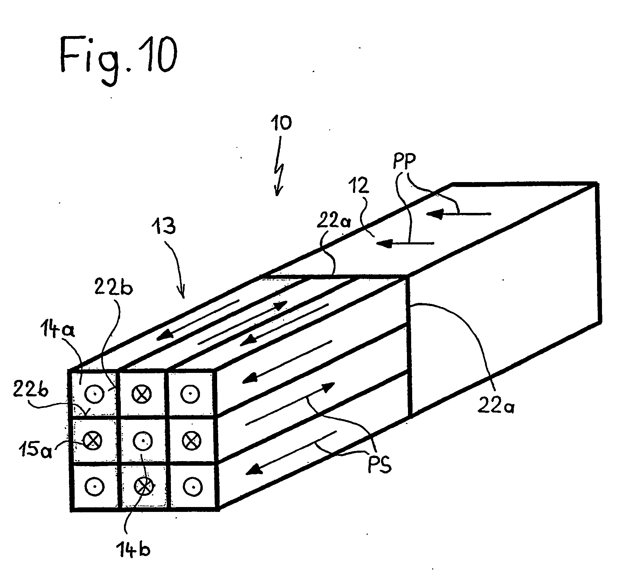

Fig. 10 zeigt eine weitere alternative Ausführungsform einer erfindungsgemäßen Vorrichtung 10, in einer Darstellung gemäß Fig. 8, die der dort gezeigten geometrischen Struktur relativ nahe kommt. Hier sind die Teilbereiche 14a, 15a des Sekundärbereiches 13 von zylindrischen Körpern mit quadratischem Querschnitt gebildet. Jeweils zwei benachbarte Teilelemente des Sekundärbereiches, z. B. die Teilbereiche 14a und 15a oder die Teilbereiche 15a und 14b weisen entgegengesetzte Polarisationsrichtungen auf, so dass sich im Bereich der Grenzflächen 22b zwischen jeweils zwei Teilbereichen unterschiedlicher Polarisationsrichtung nicht dargestellter Plasmawolken bilden.

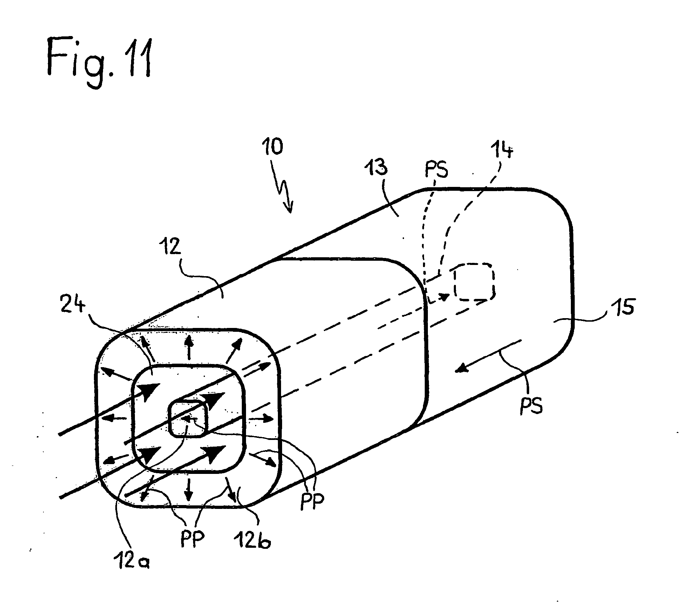

Fig. 11 zeigt ein weiteres Ausführungsbeispiel der erfindungsgemäßen Vorrichtung 10, bei der zwei gesonderte Einheiten vorgesehen sind, die jeweils einen Primärbereich 12 und einen Sekundärbereich 13 aufweisen. Eine erste Einheit ist in Form eines stabförmigen Körpers ausgebildet und weist entsprechend einen Primärteilbereich 12a mit quadratischem Querschnitt auf, der in einen Teilbereich 14 gleichen Querschnittes übergeht. Eine zweite Einheit ist nach Art eines zylindrischen Rohres mit quadratischem Querschnitt ausgebildet und umgibt die erste Einheit konzentrisch. Der der zweiten Einheit zugehörige zweite, radial polarisierte Primärteilbereich 12b geht in einen Teilbereich 15 des Sekundärbereiches 13 über, der eine gleiche geometrische Struktur wie der zweite Primärteilbereich 12b aufweist.

Zwischen den beiden Primärteilbereichen 12a und 12b und zwischen den beiden Teilbereichen 14 und 15 befindet sich ein ringförmiger Freiraum 24, der einen Gasströmungskanal bildet. Innerhalb des Gasströmungskanals 24 kann sich zwischen den beiden Teilbereichen 14 und 15 ein Plasma ausbilden.

Wenn der Primärbereich 12 mit den beiden Primärteilbereichen 12a und 12b in Phase, das heißt gleichgetaktet, angeregt wird, sind die beiden Teilbereiche 14 und 15 entgegengesetzt polarisiert, so dass sich im Bereich des Gasströmungskanals 24 entlang der Außenfläche des Teilbereiches 14 bzw. entlang der Innenfläche des Teilbereiches 15 ein Plasma ausbilden kann.

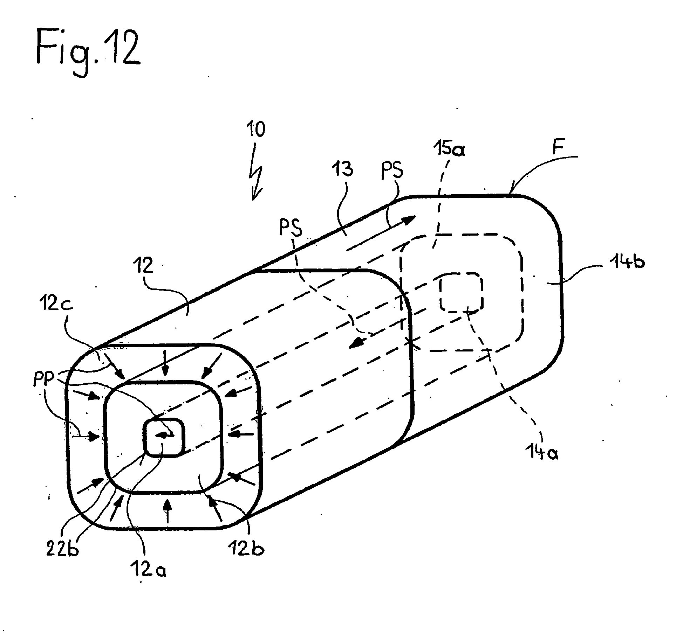

Fig. 12 zeigt eine weitere Variante einer erfindungsgemäßen Vorrichtung 10, bei der der Primärbereich 12 und der Sekundärbereich 13 von konzentrisch, voneinander in radialer Richtung unbeabstandeten Ringen gebildet ist. Zentral ist ein im Wesentlichen stabförmiger Körper mit quadratischem Querschnitt angeordnet, der einen Primärteilbereich 12a aufweist und in einen Sekundärteilbereich 14a übergeht. Konzentrisch umgeben ist der Primärteilbereich 12a von einem zweiten Primärteilbereich 12b, der in einen Teilbereich 15a des Sekundärbereiches übergeht, wobei der Teilbereich 15b eine zu dem Teilbereich 14a entgegengesetzte Polarisationsrichtung aufweist.

Schließlich ist ein dritter Primärteilbereich 12c vorgesehen, der die beiden Primärteilbereiche 12a und 12b konzentrisch umgibt. Der dritte Teilbereich 14b des Sekundärbereiches 13 weist die gleiche Polarisationsrichtung auf wie der Teilbereich 14a.

An der bezüglich Fig. 12 rückwärtigen Stirnfläche F können sich entlang der Verbindungsbereiche der Teilbereiche 14a, 15b und 14b im Wesentlichen ringförmige Plasmawolken ausbilden.

Insofern, wie in Fig. 12 dargestellt, drei konzentrische Ring-Primärteilbereiche 12a, 12b und 12c vorgesehen sind, kann zwischen den Ringbereichen 12c und 12b entlang der Verbindungslinie 22b eine rohrförmige Elektrode angeordnet sein. Zwischen den Primärteilbereichen 12b und 12a kann entlang der zugehörigen Verbindungslinie 22b ein Isolator angeordnet sein, der den stabförmigen Primärteilkörper 12a mantelartig umgibt. Das Isolierelement weist auf seiner Innenseite beispielsweise zwei plattenartige Elektroden auf, die einander gegenüberliegen und die dargestellte Primärpolarisationsrichtung PP berücksichtigen. Auf der dem Ringkörper 12b zugewandten Seite dieses Isolierelementes könnte dann wiederum eine weitere, dem Ringbereich 12e zugeordnete rohrförmige Elektrode angeordnet sein.

Alternativ ist bei einer geometrischen Struktur gemäß Fig. 12 vorstellbar, dass der mit 12b bezeichnete Bereich des Primärbereiches 12 von einer Isolierstrecke gebildet ist. Dann würde der Primärbereich 12 nur zwei Primärteilbereiche 12a und 12c aufweisen, die von einem Isolator getrennt wären.

Schließlich könnte der mit 12b bezeichnete Primärteilbereich auch entfallen und einen ringförmigen Gasströmungskanal ausbilden.

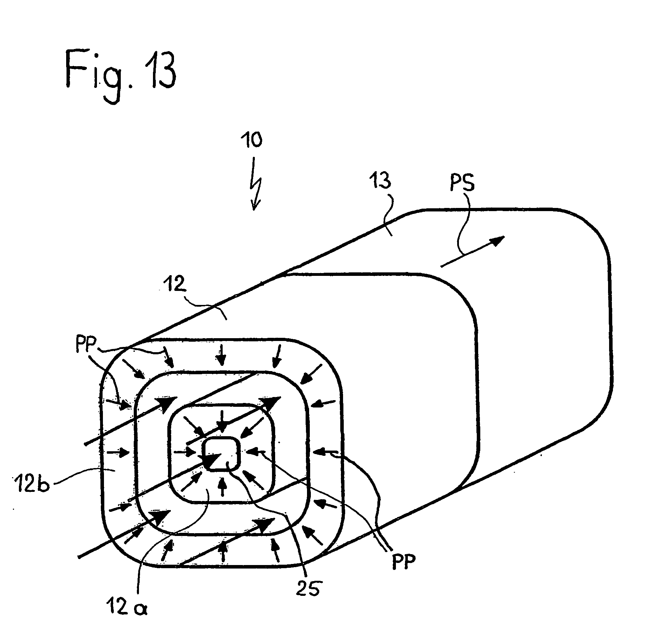

Fig. 13 zeigt eine weitere Variante der erfindungsgemäßen Vorrichtung 10 in einer Darstellung ähnlich Fig. 11, wobei gegenüber Fig. 11 der wesentliche Unterschied darin besteht, dass der Primärteilbereich 12a nicht von einem im Wesentlichen stabförmigen zylindrischen Körper mit quadratischem Querschnitt gebildet ist, sondern von einem hohlen Ringkörper, der in seinem Zentrum eine Öffnung 25 bereitstellt, die gleichermaßen einen Gasströmungskanal ausbilden kann. Bei Betrachtung dieser Figur wird deutlich, dass der Sekundärbereich 13 eine dem Primärbereich 12 entsprechende geometrische Struktur aufweist.

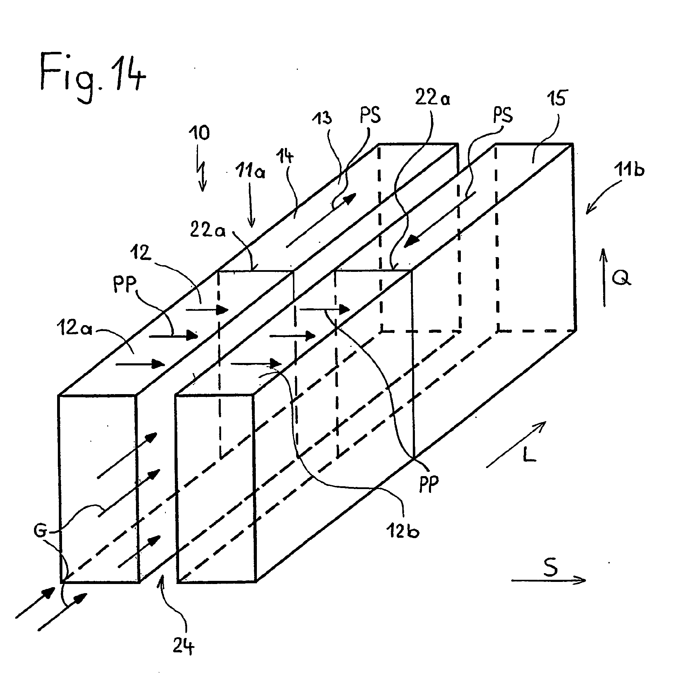

Fig. 14 zeigt ein weiteres Ausführungsbeispiel einer erfindungsgemäßen Vorrichtung, bei der der Primärbereich 12 und der Sekundärbereich 13 jeweils von gesonderten Teilbereichen gebildet werden. Der Primärteilbereich 12a weist die Form eines Quaders mit rechteckigem Querschnitt auf und geht in eine entsprechenden Teilbereich 14 des Sekundärbereiches 13 über. Der Primärteilbereich 12b weist einen identischen Querschnitt auf und geht in einen Teilbereich 15 des Sekundärbereiches 13 über. Zwischen den Primärteilbereichen 12a und 12b und zwischen den Teilbereichen 14 und 15 befindet sich ein Freiraum 24, der als Gasströmungskanal ausgebildet ist. Die Gasströmung erfolgt in Richtung der angedeuteten Pfeile G. Die Teilbereiche 14 und 15 sind in Längsrichtung L entgegengesetzt polarisiert.

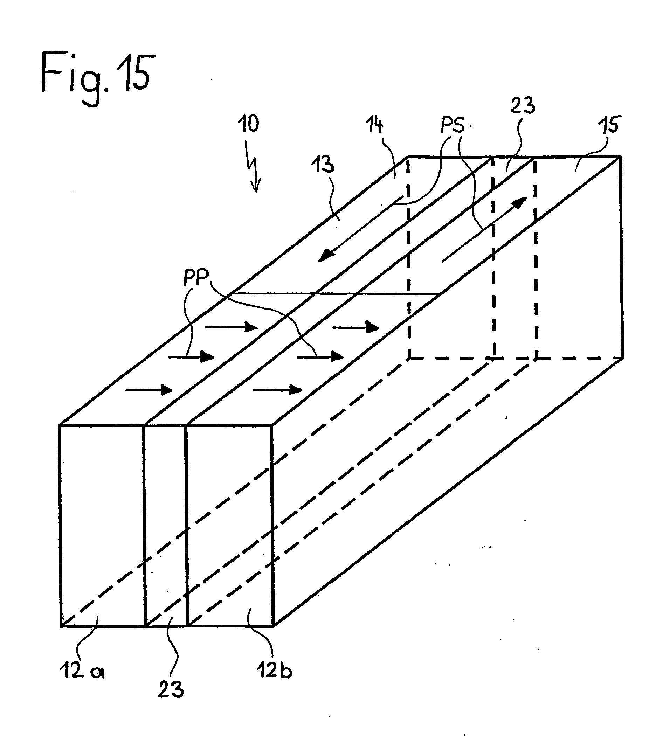

Fig. 15 zeigt eine weitere Variante der erfindungsgemäßen Vorrichtung in einer Darstellung ähnlich Fig. 14, wobei im Unterschied zu Fig. 14 in dem Freiraum 24 zwischen den beiden quaderförmigen Elementen ein Isolierelement 23 angeordnet ist. Dieses Ausführungsbeispiel ist dem Ausführungsbeispiel der Fig. 3 relativ ähnlich.

Angemerkt sei, dass auch in Fig. 15 im Primärbereich 12 keine Elektroden dargestellt sind. Anstelle einer Isolierstrecke könnten zwischen den beide Primärteilbereichen 12a und 12b auch Elektroden angeordnet sein. Entsprechende Gegenelektroden könnten dann auf den Außenseiten der Primärteilbereiche 12a und 12b angeordnet sein.

Angemerkt sei, dass auch eine geometrische Anordnung nach Art einer Kombination der Ausführungsbeispiele der Figuren 3 und 15 möglich ist, bei der zwischen den beiden Primärteilbereichen 12a und 12b eine Isolierstrecke 23 angeordnet ist, wobei auf den beiden Außenseiten der Isolierstrecke 23 jeweils eine Elektrode angeordnet ist.

Entscheidend bei den vorbeschriebenen Ausführungsbeispielen ist es, dass die Primärteilbereiche synchron, das heißt, in Resonanz angeregt werden.

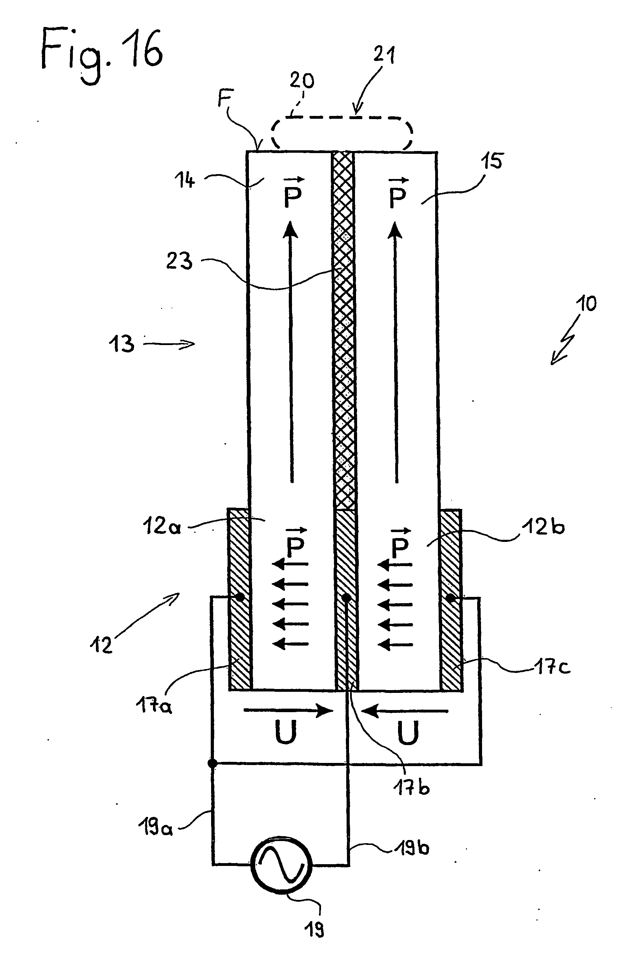

Anhand der Fig. 16 wird im Folgenden ein weiteres Ausführungsbeispiel einer erfindungsgemäßen Vorrichtung 10 erläutert:
Die Vorrichtung 10 umfasst wiederum einen über Niedervolt-Wechselspannung resonant anregbaren Primärbereich 12 und einen dadurch anregbaren Sekundärbereich 13 zur Erzeugung von Hochspannung. Der Sekundärbereich 13 ist in zwei Teilbereiche 14 und 15 unterteilt, die in der gleichen Polarisationsrichtung P polarisiert sind und zwischen denen sich ein Isolierelement 23 befindet. Jeder Teilbereich 14, 15 ist mit einem zugehörigen Primärteilbereich 12a, 12b schwingungsverbunden, was bedeutet, dass zwischen einem Primärteilbereich 12a, 12b und dem zugehörigen Teilbereich 14, 15 des Sekundärbereiches 12 resonante Schwingungen übertragen werden können. Der erste Primärteilbereich 12a weist eine Elektrode 17a und eine gegenüberliegende Elektrode 17b auf. Der zweite Primärteilbereich 12b weist eine Elektrode 17c und die zuvor schon erwähnte Elektrode 17b auf. Beide Primärteilbereiche 12a und 12b sind entlang der gleichen Polarisationsrichtung P polarisiert. Aufgrund der in Fig. 16 dargestellten Beschaltung der Elektroden liegt an den Elektroden 17a oder 17c zu jedem Zeitpunkt das gleiche Potential an. Damit werden die beiden Primärteilbereiche 12a und 12b 180°-phasenversetzt angeregt. Die Anordnung der beiden Primärteilbereiche 12a und 12b ist somit gegengetaktet getroffen.

In Folge der beschriebenen 180°-phasenversetzten oder phasenverschobenen Anregung der beiden Primärteilbereiche 12a und 12b geraten die Teilbereiche 14 und 15 des Sekundärbereiches 13 in Schwingungen, wobei die Teilbereiche 14, 15 allerdings gleichermaßen phasenversetzt schwingen. Demzufolge bilden sich maximale Potentialunterschiede entlang der Verbindungsbereiche 21 zwischen den beiden Teilbereichen 14 und 15 aus, so dass es an der Stirnseite F der Vorrichtung 10 zur Ausbildung eines Plasmas 20 kommt.

Das Isolierelement 23 dient dazu, die beiden Teilbereiche 14 und 15 mechanisch und elektrisch voneinander zu entkoppeln. Dies erhöht die Effizienz der beschriebenen Vorrichtung.

Wie zuvor bei anderen Ausführungsbeispielen beschrieben, können ein Teilbereich 14, 15 und ein dazugehöriger Primärteilbereich 12a, 12b jeweils aus einem einheitlichen Werkstück durch unterschiedliche Polarisation gebildet oder von gesonderten, aneinander befestigten Werkstücken hergestellt sein. Alternativ zu der getroffenen Anordnung gemäß Fig. 16 können auch für die beiden Primärteilbereiche 12a und 12b entgegengesetzte Polarisationsrichtungen vorgesehen sein, wobei dann eine phasengleiche Anregung erfolgt.

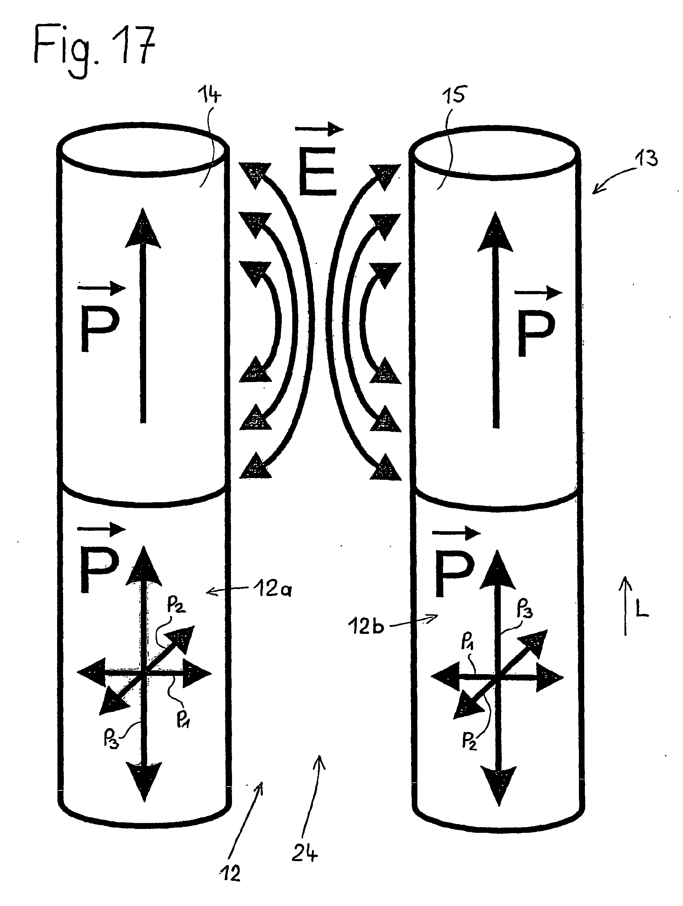

Fig. 17 zeigt in einer schematischen Darstellung das Funktionsprinzip der Vorrichtung gemäß Fig. 16, wobei anstelle eines zwischen den beiden Sekundärteilbereichen 14 und 15 vorgesehenen Isolierelementes 23 nunmehr ein Freiraum 24 belassen ist. Dieser Freiraum kann einen Gasströmungskanal bereitstellen.

Der Übersichtlichkeit halber sind die am Primärteilbereich 12a bzw. 12b anzuordnenden Elektroden nicht dargestellt. Auch das erzeugte Plasma ist der Übersichtlichkeit halber weggelassen worden.

Fig. 17 verdeutlicht, dass es unbedeutend ist, entlang welcher der drei Polarisationsrichtungen P1, P2 oder P3 eine Anregung des Primärteilbereiches erfolgt. Entscheidend ist, dass es zu einer synchronen, 180°-phasenverschobenen Anregung der beiden Primärteilbereiche 12a und 12b kommt.

Durch die gegengetaktete Anregung kommt es zur Bildung von elektrischen Feldern, die in Fig. 17 durch die dargestellten Feldlinien E schematisch angedeutet sind. Durch die synchrone Anregung der beiden Primärteilbereiche 12a und 12b kann sich das in dem Freiraum 24 befindliche Feld optimal verstärken.

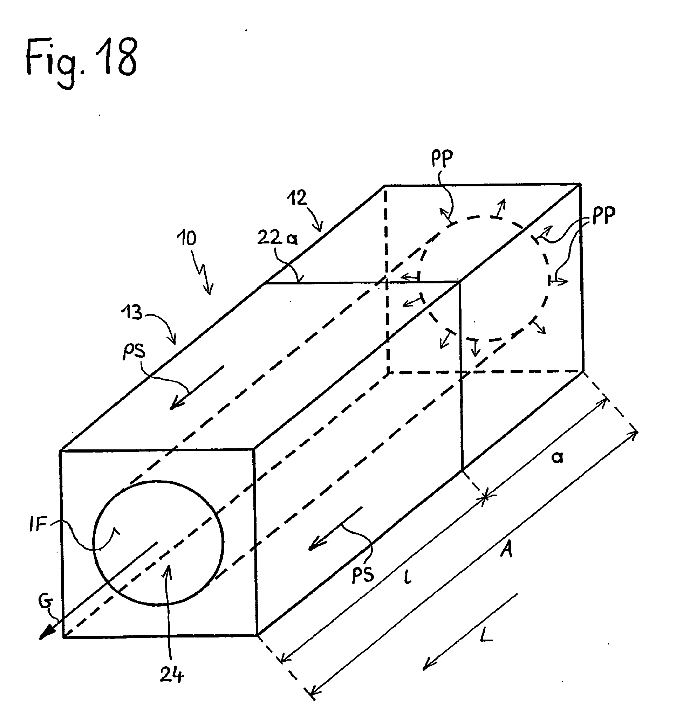

Anhand der Fig. 18 bis 26 soll nun eine weitere Gruppe von Ausführungsbeispielen der erfindungsgemäßen Vorrichtung erläutert werden:
Fig. 18 zeigt eine im Wesentlichen quaderförmige erfindungsgemäße Vorrichtung 10, die einen Primärteilbereich 12 und einen Sekundärbereich 13 aufweist. Im Primärteilbereich 12 ist die Polarisationsrichtung mit PP und im Sekundärbereich 13 ist die Polarisationsrichtung mit PS bezeichnet. Fig. 18 verdeutlicht, dass der Primärbereich in Radialrichtung und der Sekundärbereich in Längsrichtung L polarisiert ist.

Die Vorrichtung 10 ist von einer zentralen Durchtrittsöffnung 24 durchsetzt, die sich entlang der gesamten axialen Länge A = I + a der Vorrichtung 10 erstreckt. Die Durchtrittsöffnung 24 kann den Gasströmungskanal bereitstellen, wobei das Gas in Richtung des Pfeiles G durch die Vorrichtung hindurchströmen kann.

Wird der Primärbereich 12 durch in Fig. 18 nicht dargestellte Elektroden resonant angeregt, kommt es im Bereich der Durchgangsöffnung 24 entlang der Innenfläche IF des Sekundärbereiches 13 zur Ausbildung von elektrischen Feldern aufgrund von elektrischem Potentialdifferenzen entlang der Längsrichtung L. Insoweit kann sich in dem Durchgangskanal 24 ein Plasma ausbilden. Die zur Anregung des Primärbereiches erforderlichen Elektroden befinden sich an der Innenseite und an der Außenseite des Primärbereiches 12.

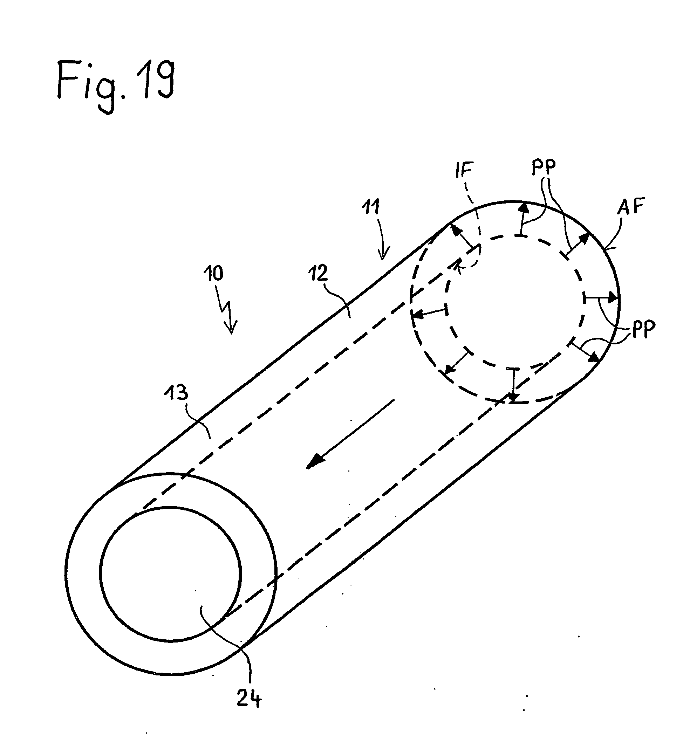

Fig. 19 zeigt eine der Fig. 18 ähnliche Anordnung, bei der der Durchgangskanal 24 einen kreisförmigen Querschnitt aufweist, und wobei die Einrichtung 11, die den Primärteilbereich 12 und den Sekundärbereich 13 bereitstellt, von einem zylindrischen, im Wesentlichen rohrförmigen Körper gebildet ist.

Gleichermaßen wie beim Ausführungsbeispiel der Fig. 18 ist der Primärbereich 12 in Radialrichtung PP polarisiert, wobei eine an der Innenumfangsfläche IF des Primärbereiches 12 und eine gegenüberliegende, an der Außenfläche AF des Primärteilbereichs 12 befindliche Elektrode, die in Fig. 19 nicht dargestellt sind, zum Betrieb der Vorrichtung 10 vorgesehen sind.

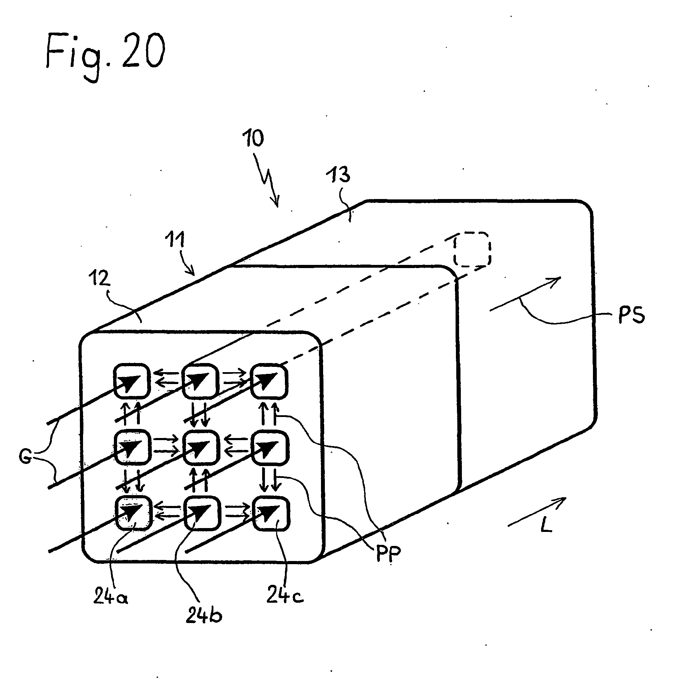

Fig. 20 verdeutlicht ein weiteres Ausführungsbeispiel einer erfindungsgemäßen Vorrichtung 10, bei dem die Einrichtung 11 nach Art eines im Querschnitt quadratischen Quaders ausgebildet ist, der wiederum in einen Primärteilbereich 12 und einen Sekundärbereich 13 unterteilt ist. Die Einrichtung 11 wird in Längsrichtung von im Querschnitt quadratischen Durchgangskanälen durchzogen. Im Primärbereich 12 weist jeder der Durchgangskanäle 24a, 24b, 24c, etc. eine nicht dargestellte Elektrode auf. Die Elektrode bildet also jeweils die Wandung des Gaskanals 24 im Primärbereich 12. Der Primärbereich 12 ist entsprechend den dargestellten Polarisationspfeilen PP polarisiert. Der Sekundärbereich 13 ist entlang der Polarisationsrichtung PS einheitlich polarisiert.

Entlang der Längsrichtung L bilden sich im Sekundärbereich 13 innerhalb der Durchgangskanäle 24a, 24b, 24c, etc. Atmosphären-Plasmen aus.

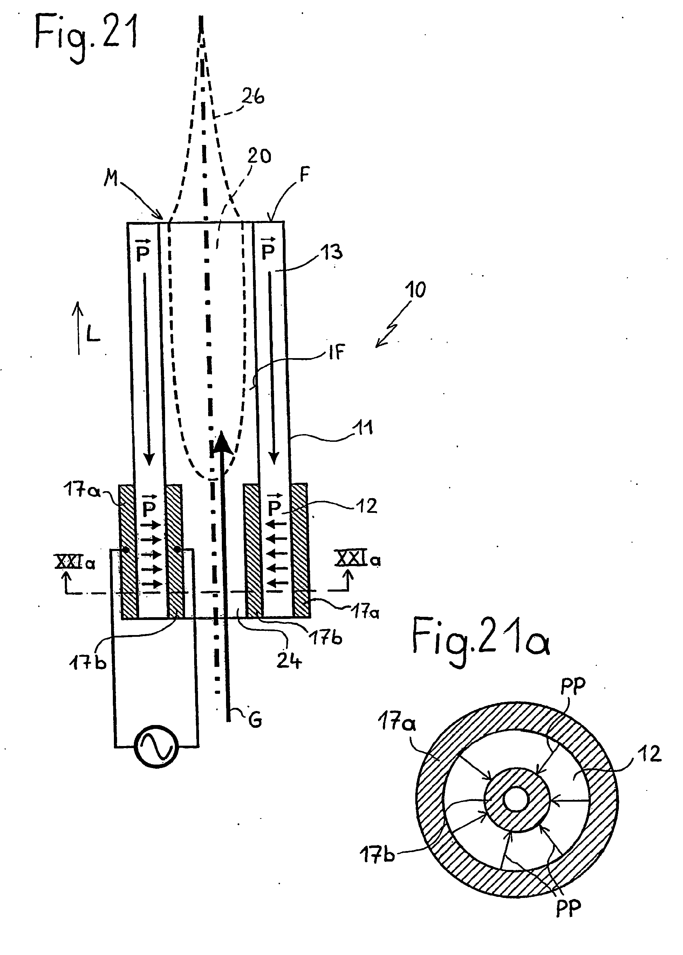

Fig. 21 zeigt in einer Darstellung gemäß Fig. 1 eine Vorrichtung gemäß Fig. 19. Bei diesem Ausführungsbeispiel einer erfindungsgemäßen Vorrichtung 10 ist die Einrichtung 11 von einem rohrförmigen kreiszylindrischen Körper gebildet, dessen Primärbereich 12 in Radialrichtung polarisiert ist und dessen Sekundärbereich 13 entgegen der Längsrichtung L polarisiert ist. Fig. 21a zeigt, dass die beiden Elektroden 17a und 17b im Wesentlichen nach Art eines axial recht kurz gehaltenen Rohres ausgebildet sind. Die in den Fig. 21 und 21a dargestellten Elektroden 17a und 17b sind übertrieben groß dargestellt. Dem Betrachter ist deutlich, dass die Elektroden tatsächlich nur sehr dünn, beispielsweise nur wenige µm dick, ausgebildet sind. Dies gilt im Übrigen auch für alle anderen in dieser Patentanmeldung dargestellten Ausführungsbeispiele.

Die innere Elektrode 17 b des Primärbereichs 12 und die Innenumfangsfläche IF des Sekundärbereiches 13 stellen die Wandung eines Gasströmungskanales 24 bereit. Die Gasströmung ist durch den Pfeil G angedeutet.

Entlang dem Gaskanal 24 bildet sich in dem Sekundärbereich 13 ein Atmosphärendruck-Plasma 20, welches sich in Form eines Plasmajets 26 aus der Mündung M des Sekundärbereiches 13 heraus erstreckt. Das zu bearbeitende Substrat, welches sich der Betrachter der Fig. 21 etwa oberhalb der Oberseite F der Vorrichtung 10 vorstellen muss, kann durch den Plasmajet 26 erfasst und bearbeitet werden. Die Länge des Plasmajets 26 in Längsrichtung L hängt unter anderem von der Strömungsgeschwindigkeit des Gases ab.

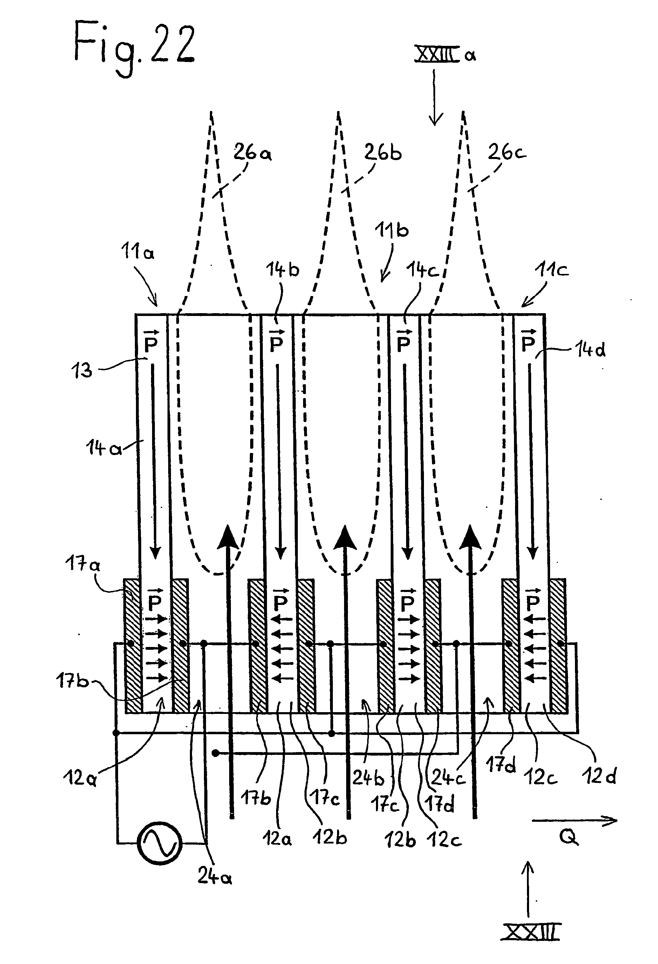

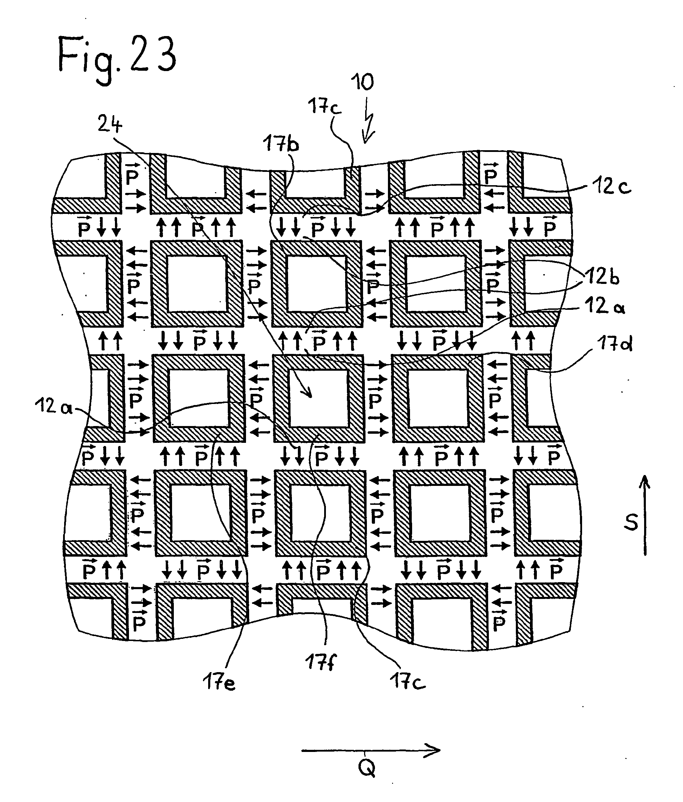

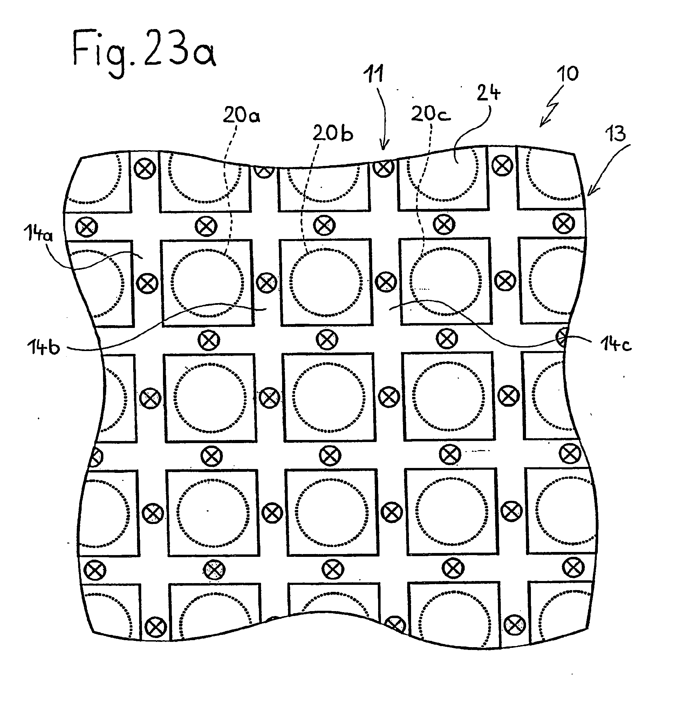

Fig. 22 macht deutlich, dass eine Vielzahl von Plasmajets 26a, 26b, 26c generierbar ist, wenn mehrere rohrartige Einrichtungen 11 in Reihe oder, wie dies Fig. 23 noch besser verdeutlicht, entlang einer Ebene, nach Art eines Rasters angeordnet sind. Bei einer Reihenanordnung gemäß Fig. 22, die sich in Querrichtung Q erstreckt, kann ein lang gestreckter Plasmastreifen generiert werden, wenn sich die Plasmajets 26a, 26b, 26c überlappen oder nahe kommen. Für den Fall, dass sich die Einrichtungen 11a, 11b, 11c bei einer Vorrichtung 10 gemäß Fig. 23 entlang einer Ebene, zu einem Raster angeordnet, erstrecken, kann ein flächenhaftes Plasma oder jedenfalls eine beliebig große Anzahl nebeneinander angeordneter Plasma-Jets generiert werden.

Der Betrieb einer Multijet-Vorrichtung gemäß Fig. 22 oder Fig. 23 erfolgt dadurch, dass die einzelnen Primärteilbereiche 12a, 12b, 12c in Phase, d.h. gleichphasig, betrieben werden. Jede Innenelektrode einer Einrichtung 11a stellt zugleich die Außenelektrode einer benachbarten Einrichtung 11b bereit. So stellt beispielsweise die Innenelektrode 17a der Einrichtung 11a zugleich die Außenelektrode 17a der Einrichtung 11b bereit. Die Teilbereiche 14a, 14b, 14c, 14d des Sekundärbereiches 13 sind sämtlich entlang der gleichen Polarisationsrichtung P polarisiert. Jeweils zwei benachbarte Primärteilbereiche 12a, 12b, 12c der Vorrichtung 10 sind gegengetaktet angeordnet, d.h. sie werden 180°-phasenversetzt, betrieben. Dabei ist allerdings zu beachten, dass beispielsweise die Wandung zwischen den Gasströmungskanälen 24a und 24b gemeinsam von Primärteilbereichen 12a und 12b gebildet ist. Dem Gasströmungskanal 24a ist ein erster Primärteilbereich 12a und dem Gasströmungskanal 24b ist ein zweiter Primärteilbereich 12b zugeordnet. Während der Primärteilbereich 12a zu einem bestimmten Schwingungszeitpunkt beispielsweise gerade eine radial einwärts gerichtete Maximalbewegung durchgeführt hat, mit dem der Gasströmungskanal 24a (wenn auch unmerklich) eingeschnürt ist, ist der benachbarte Gasströmungskanal 24b zu dem gleichen Zeitpunkt (unmerklich) maximal radial aufgeweitet. Der Primärteilbereich 12b, der zu dem Gasströmungskanal 24b gehört, ist daher gleichermaßen maximal expandiert. Damit sind die beiden Primärteilbereich 12a, 12b gerade 180°-phasenversetzt angeregt. Auf diese Weise bilden sich elektrische Felder in den Gasströmungskanälen 24a, 24b, 24c der drei Einrichtungen 11a, 11b, 11c entlang des Sekundärbereiches 13 aus.

Der Querschnitt der Gasströmungskanäle 24a, 24b ist bei einer Reihenanordnung beliebig, und kann beispielsweise von einem kreisförmigen oder rechteckförmigen Querschnitt, alternativ auch von einem anderen beliebigen Querschnitt gebildet sein.

Fig. 23 zeigt die zu einem Raster hochskalierte Vorrichtung gemäß Fig. 22 in Unteransicht gemäß Ansichtspfeil XXIII in Fig. 22. Es ist ersichtlich, dass jede Elektrode von vier benachbarten Elektroden umgeben ist. So ist beispielsweise die Elektrode 17a von vier Elektroden 17e, 17b, 17d und 17f umgeben.

Fig. 23 zeigt, dass die Elektrode 17a einen Gasströmungskanal 24 mit quadratischem Querschnitt umgibt. Dem Betrachter wird deutlich, dass auch andere Querschnittsformen möglich sind.

Fig. 23 a zeigt die zu einem Raster hochskalierte Vorrichtung gemäß Fig. 22 in Draufsicht, also etwa gemäß Ansichtspfeil XXIIIa in Fig. 22. Die Draufsicht verdeutlicht, dass eine Vielzahl von rasterartig angeordneten Plasma-Jets 20a, 20b, 20c generiert werden kann. Die Symbole des X im Kreis verdeutlichen, dass die gesamte wabenartige Struktur des Sekundärbereiches 13 entlang der gleichen Polarisationsrichtung, d.h. in Längsrichtung L, polarisiert ist.

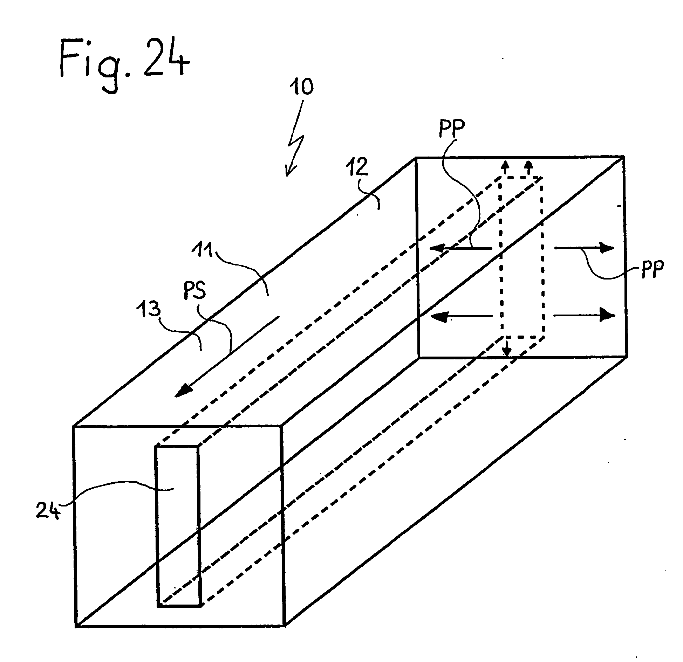

Fig. 24 zeigt ein weiteres Ausführungsbeispiel einer erfindungsgemäßen Vorrichtung 10, bei der die Einrichtung 11 mit einem Primärbereich 12 und einem Sekundärbereich 13 versehen ist. Die Vorrichtung entspricht nahezu der in Fig. 19 dargestellten Vorrichtung, so dass auf eine Vielzahl von Einzelheiten zur Vermeidung von Wiederholungen Bezug genommen wird. Die Besonderheit besteht hier in einem Gasströmungskanal 24, der einen im Wesentlichen rechteckigen Querschnitt aufweist. Die Polarisationsrichtungen des Primärbereiches 12 sind in Fig. 24 mit PP und die des Sekundärbereiches 13 mit PS bezeichnet. Fig. 24 zeigt, dass der Primärbereich 12 nahezu radial polarisiert sein kann.

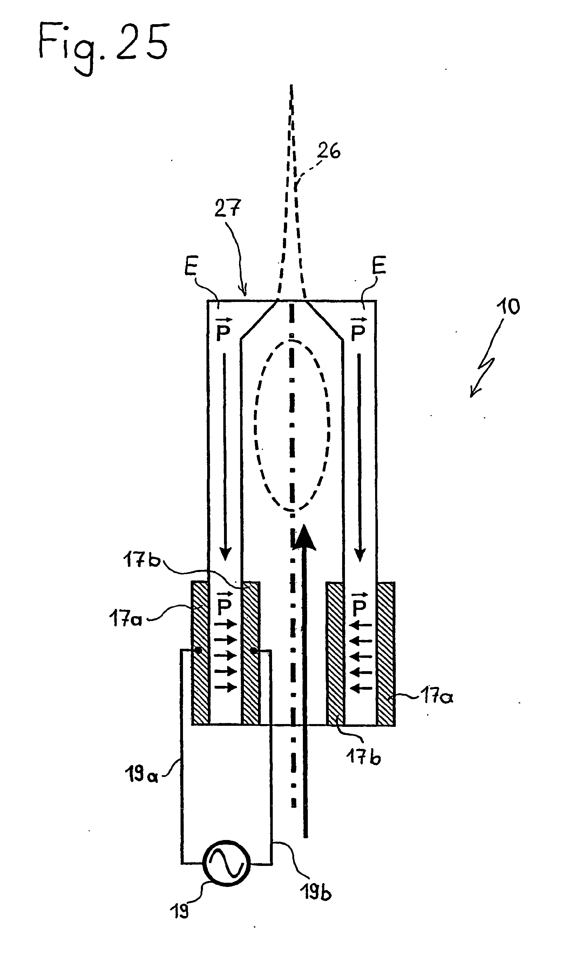

Fig. 25 zeigt ein weiteres Ausführungsbeispiel der erfindungsgemäßen Vorrichtung in einer Darstellung vergleichbar mit Fig. 21. Die Vorrichtung 10 gemäß Fig. 25 ist im Unterschied zu der Vorrichtung gemäß Fig. 21 mit einer Mündungsdüse 27 versehen, wodurch die Ausbildung eines Plasmajets 26 vorteilhaft beeinflusst werden kann. Die Vorrichtung entspricht im Übrigen hinsichtlich ihrer Struktur der Vorrichtung gemäß Fig. 21, so dass zur Vermeidung von Wiederholungen auf die obigen Ausführungen Bezug genommen wird.

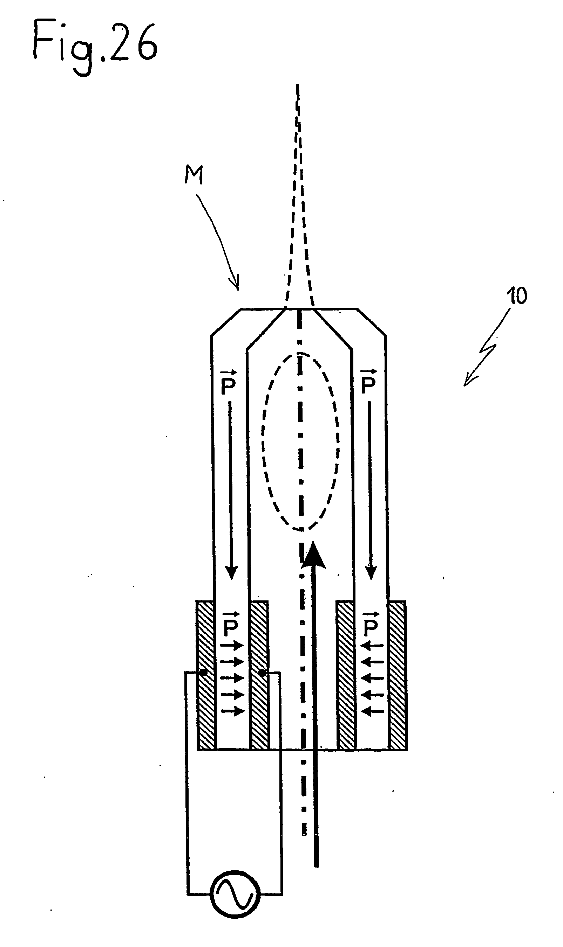

Fig. 26 zeigt ein weiteres Ausführungsbeispiel einer erfindungsgemäßen Vorrichtung in der Darstellung gemäß Fig. 25, wobei der Bereich der Mündung M der Vorrichtung 10 geringfügig abgeändert ist. Hier sind die in Fig. 25 dargestellten Eckbereiche E entfallen, so dass sich eine zangenartige Anordnung ergibt.

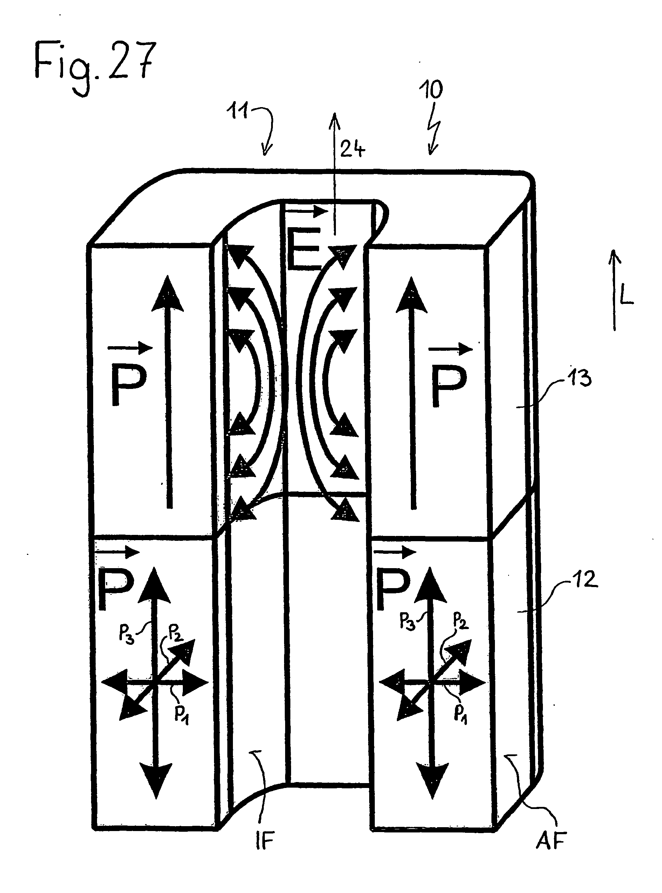

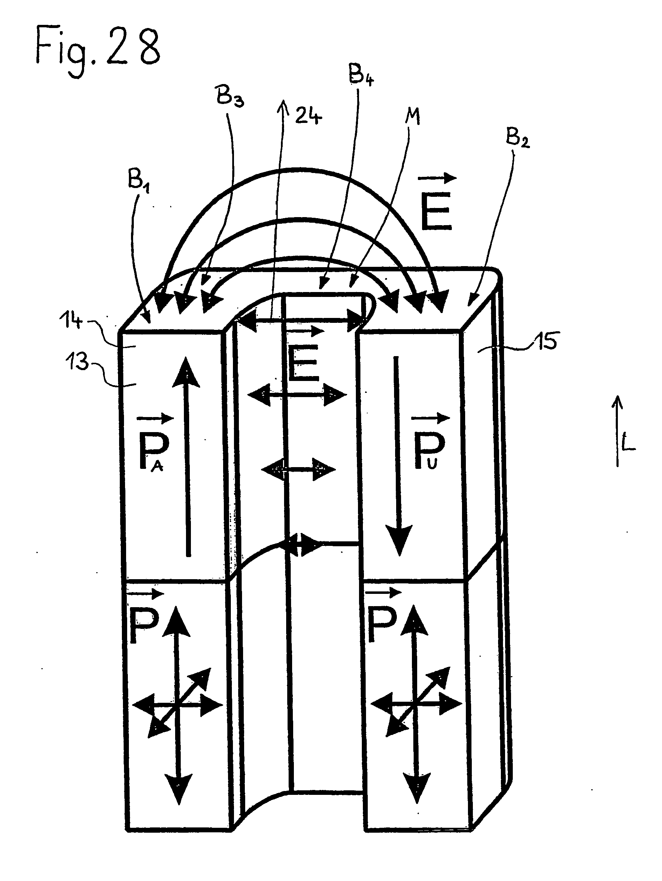

Anhand der Fig. 27 und 28 soll nunmehr noch einmal das physikalische Prinzip der erfindungsgemäßen Plasmaerzeugung erläutert werden:
Fig. 27 zeigt in einer teilgeschnittenen schematischen Ansicht einen Schnitt durch einen rohrförmigen Körper, der einen quadratischen Querschnitt aufweist. Die Darstellung der Fig. 27 entspricht etwa einem Längsschnitt durch die Vorrichtung gemäß Fig. 18 entlang einer Mittelebene, wobei der Gasströmungskanal 24 im Unterschied zu seiner Darstellung in Fig. 18 bei der Darstellung gemäß Fig. 27 einen im Wesentlichen quadratischen Querschnitt aufweist.

Der dargestellte, rohrförmige Körper bildet die Einrichtung 11 als Bestandteil einer Vorrichtung 10 zur Erzeugung eines Atmosphärendruck-Plasmas. Die Einrichtung 11 besteht aus piezoelektrischem Material und ist in einen Primärbereich 12 und einen Sekundärbereich 13 unterteilt. Der Primärbereich 12 wird entlang einer beliebigen der drei Polarisationsrichtungen P1, P2 und P3 angeregt. Vorzugsweise wird man eine radiale Polarisationsrichtung P1 wählen, um eine hülsenartige oder rohrförmige Innenelektrode an der Innenumfangsfläche IF des Primärbereiches 12 und eine entsprechende Außenelektrode an der Außenfläche AF des Primärbereiches 12 anbringen zu können. Bei anderen, nicht dargestellten Elektrodengeometrien könnte es aber durchaus auch in Erwägung gezogen werden, den Primärbereich 12 entlang der Polarisationsrichtung P2 oder P3 anzuregen.

Auf die gewählte Polarisationsrichtung des Primärbereiches 12 kommt es letztendlich nicht an. Die jeweils gewählte Polarisationsrichtung, d.h. die Polarisationsrichtung P1, P2 oder P3 hat jeweils nur eine entsprechende bestimmte Anordnung der nicht dargestellten Elektroden zur Folge. Richtig ist, dass der Primärbereich 12 insgesamt resonant angeregt wird und seine Schwingungen auf den Sekundärbereich 13 mit vorgegebener, in Längsrichtung verlaufender Polarisation übertragen kann.

Eine resonante Anregung des Primärbereiches 12 hat eine Übertragung der Schwingung in der Resonanzfrequenz zu dem Sekundärbereich 13 zur Folge, so dass sich entlang der Längsrichtung L ein elektrisches Feld ausbreitet. Der Gaskanal 24 kann von unten nach oben von Gas durchströmt werden, wobei sich im Bereich der stärksten elektrischen Felder ein Plasma ausbildet. Dadurch, dass der Gaskanal 24 an den gegenüberliegenden Seiten von Werkstoffbereichen des schwingenden Sekundärbereiches 13 umgeben ist, kann eine sehr vorteilhafte Feldgeometrie erzielt werden, die die Plasmaerzeugung begünstigt.

Bei einer alternativen Ausführungsform der Erfindung gemäß Fig. 28 ist der Sekundärbereich 13 unterschiedlich polarisiert. Fig. 28 zeigt wiederum eine schematische, teilgeschnittene Ansicht eines im Wesentlichen rohrförmigen Elementes. Der bezüglich Fig. 28 linke Teilbereich des Sekundärbereiches 13 ist in Polarisationsrichtung Pₐ und der bezüglich Fig. 28 rechte Teilbereich 15 des Sekundärbereiches 13 ist in Polarisationsrichtung Pᵤ polarisiert.

Da der gesamte Sekundärbereich 13 auch bei dem Ausführungsbeispiel der Fig. 28 von einem einzigen Werkstück gebildet sein kann, muss noch erläutert werden, wie sich die Polarisationsrichtungen im Übergangsbereich zwischen den Teilbereichen 14 und 15 verhalten. Hierzu ist anzumerken, dass die gewünschte Polarisation beispielsweise dadurch erhalten werden kann, dass im Bereich B1 eine erste Elektrode und im Bereich B2 während der Polarisation des Werkstücks eine zweite Elektrode mit entgegengesetzter Polung angeordnet wird. Die Polarisation in Längsrichtung L ist dann nach erfolgter Polarisation im Bereich B1 maximal und im Bereich B2 mit entgegengesetzter Polarisationsrichtung maximal. In einem Bereich B3 nimmt die Polarisation ab und erreicht in einem Bereich B4 etwa einen Nullwert bzw. dreht ihr Vorzeichen um. Damit wird deutlich, dass die größten Potentialdifferenzen und damit, wie in Fig. 28 dargestellt, die größten elektrischen Felder, im Bereich zwischen den Bereichen B1 und B2 auftreten.

Während die Vorrichtung gemäß Fig. 27 vornehmlich dazu dient, im Innenraum des Gasströmungskanals 24 ein Plasma zu generieren, ist die Vorrichtung gemäß Fig. 28 besonders vorteilhaft einsetzbar, um im Bereich der Mündung M des Gaskanals 24 ein Plasma zu generieren.

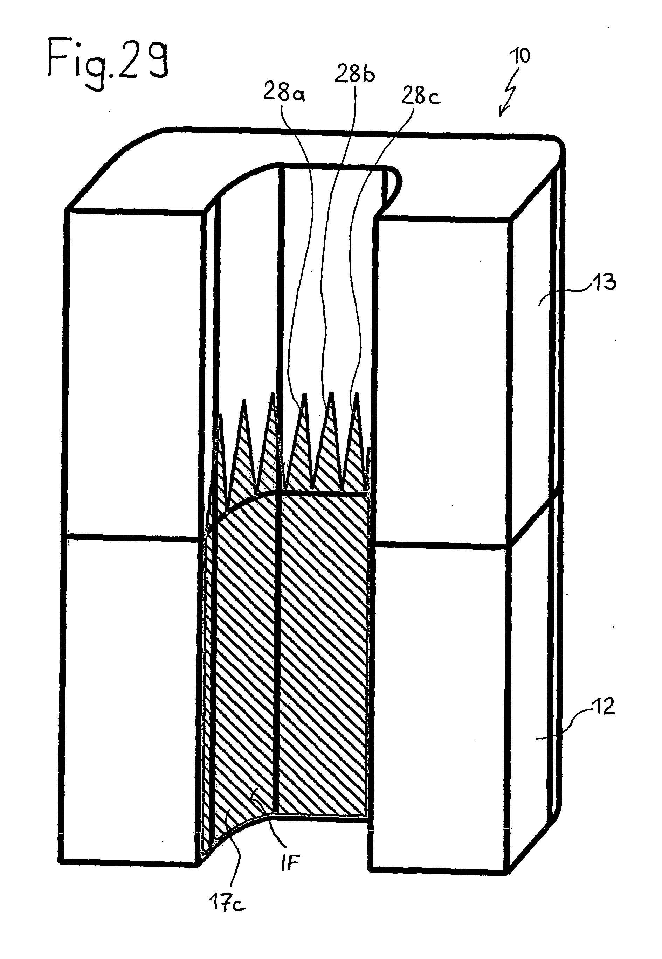

Fig. 29 zeigt in einer Darstellung gemäß den Figuren 27 bis 28 eine besonders strukturierte Elektrode 17c die an der Innenfläche IF des Primärbereichs 12 angeordnet ist. Wie ohne weiteres ersichtlich ist, weist die Elektrode 17c an dem dem Sekundärbereich 13 zugewandten Bereich eine Vielzahl von Zacken 28a, 28b, 28c auf. Die Zacken können eine schnelle Zündung des Plasmas begünstigen, da sich hier die elektrischen Felder auf geeignete Weise ausbilden. Im Bereich der Kanten der Elektroden sind typischerweise besonders große Feldstärken erreichbar, wodurch Plasmen schneller oder früher gezündet werden können.

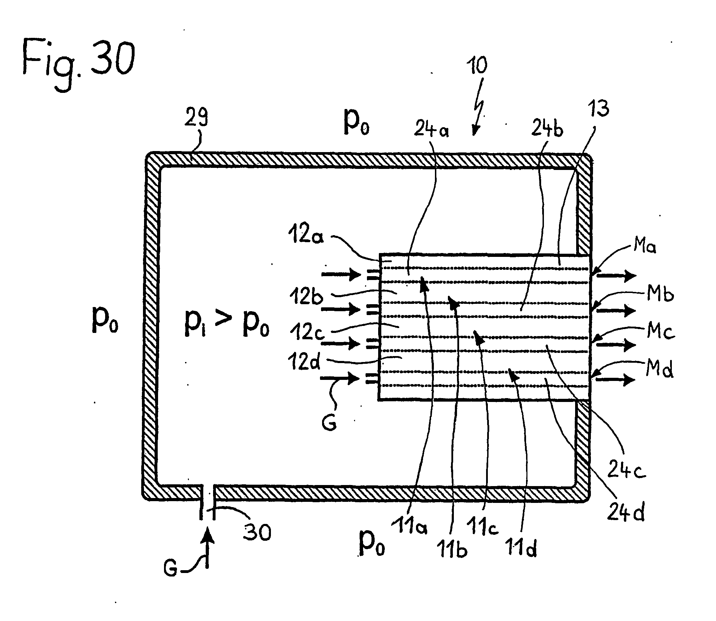

Fig. 30 zeigt ein weiteres Ausführungsbeispiel der erfindungsgemäßen Vorrichtung 10, bei der eine der vorher verschiedenen Anordnungen, beispielsweise eine Anordnung gemäß Fig. 22, innerhalb eines Gehäuses 29 angeordnet ist. Das Gehäuse verfügt über einen Gaseinlass 30, der mit einem nicht dargestellten Gasvorrat verbunden ist. Innerhalb des Gehäuses 29 herrscht ein Druck Pᵢ, der größer ist als der Außendruck P₀, der dem Atmosphärendruck entspricht. Die Druckdifferenz sorgt für einen vorgegebenen Gasfluss, der durch die dargestellten Pfeile G verdeutlicht ist.

Die Vorrichtung 10 gemäß Fig. 30 weist eine Mehrzahl von Einrichtungen 11a, 11b, 11c auf, die analog der Vorrichtung gemäß Fig. 21 in Reihe oder entlang einer Ebene nach Art eines Rasters angeordnet sind. Beispielhaft sind hier vier Einrichtungen 11a, 11b, 11c, 11d mit jeweils einem eigenen Gasströmungskanal 24a, 24 b, 24c, 24d dargestellt. Jede Einrichtung weist einen in Gasflussrichtung vorderen Primärbereich 12a, 12b, 12c, 12d und einen in Gasflussrichtung hinteren Sekundärbereich 13 auf. In den Mündungsbereichen Ma, Mb, Mc und Md bilden sich Plasmajets aus.

Mit der Vorrichtung gemäß Fig. 30 können insbesondere auch parasitäre Entladungen an den seitlichen Begrenzungen verhindert werden.

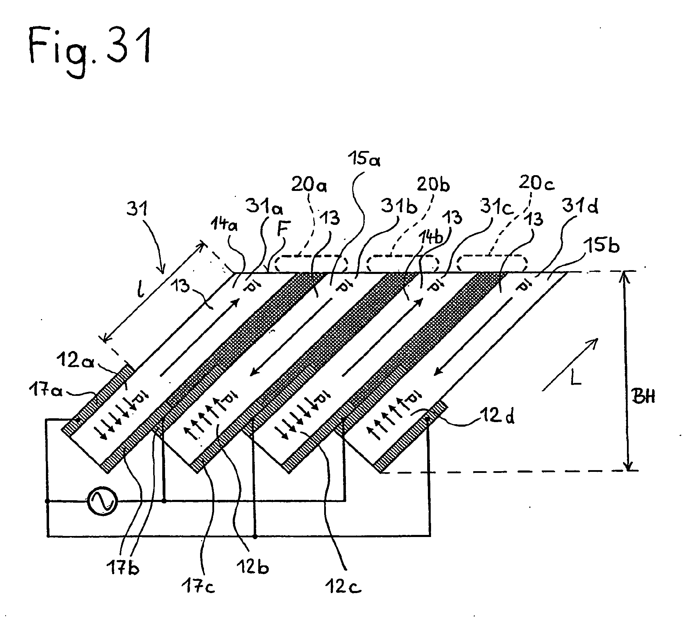

Fig. 31 zeigt ein weiteres Ausführungsbeispiel der erfindungsgemäßen Vorrichtung 10, bei dem eine Schichtstruktur 31 schräg geneigter Schichten vorgesehen ist. Fig. 31 zeigt eine erste Schicht 31a, eine zweite Schicht 31b, eine dritte Schicht 31c und eine vierte Schicht 31d. Jede der Schichten besteht aus piezoelektrischem Material und stellt einen Primärbereich 12 und einen zugehörigen Sekundärbereich 13 bereit. Die Sekundärbereiche 13 sind jeweils in Längsrichtung L oder entgegen der Längsrichtung L polarisiert. Jeweils zwei einander benachbarte Schichten weisen Teilbereiche 14a, 14b, 15a, 15b des Sekundärbereiches 13 auf, die entgegengesetzt polarisiert sind.

Die Primärbereiche 12a, 12b, 12c, 12d der einzelnen Schichten 31a, 31b, 31c, 31d sind quer zur Polarisationsrichtung des Sekundärbereiches 13 polarisiert. Jeder Primärbereich 12 umfasst ein Paar von Elektroden 17a, 17b; 17b, 17c, wobei sich jeweils zwei einander benachbarte Primärbereiche 12a, 12b eine gemeinsame Elektrode (z.B. 17b) teilen.

Von Bedeutung ist, dass sämtliche Primärbereiche 12a, 12b, 12c, 12d in konstanter Phase, aber ohne Phasenverschiebung, phasengleich angeregt werden. Hierdurch bilden sich besonders starke elektrische Felder, jeweils in den Verbindungsbereichen zweier benachbarter Teilbereiche (14a, 15a) entlang der Verbindungsbereiche an der Oberseite F der Vorrichtung aus. Hierdurch können an der Oberseite die in Fig. 31 dargestellten Plasmen 20a, 20b, 20c generiert werden.

Wie oben bereits erläutert, sind die zu erzielenden Hochspannungen bzw. Feldstärken abhängig von der axialen Länge I des Sekundärbereiches 13. Große Axiallängen werden daher gewünscht. Durch die schräg gestellte Schichtstruktur 31 gemäß Fig. 31 kann bei großer Axiallänge I des Sekundärbereiches 13 eine geringe Bauhöhe BH der Vorrichtung 10 erzielt werden, wodurch eine kompakte Bauweise möglich wird.

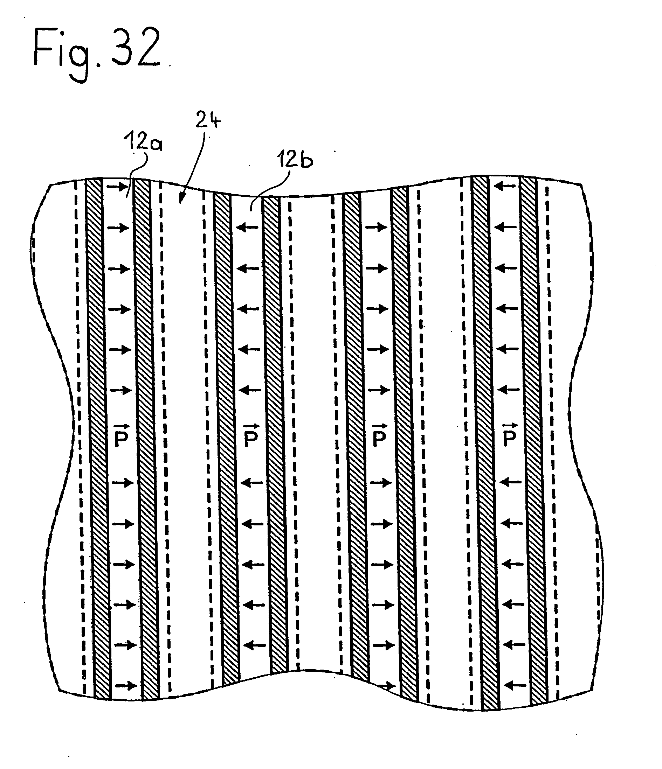

Fig. 32 zeigt ein weiteres Ausführungsbeispiel der erfindungsgemäßen Vorrichtung in einer Darstellung vergleichbar Fig. 6. Fig. 32 verdeutlicht, dass jeweils zwischen zwei Primärteilbereichen 12a, 12b, die jeweils eine im Wesentlichen scheibenartige oder plattenartige Struktur aufweisen, jeweils auch ein Freiraum 24 belassen werden kann, der einen Gasstromschlitz bereitstellen kann. Auf der der in Fig. 32 dargestellten Unterseite gegenüberliegenden Oberseite kann durch den Gasströmungsschlitz 24 entsprechend ein Plasmastreifen austreten. Selbstverständlich ist auch eine Plasmagenerierung innerhalb des Gasströmungsschlitzes 24 möglich.

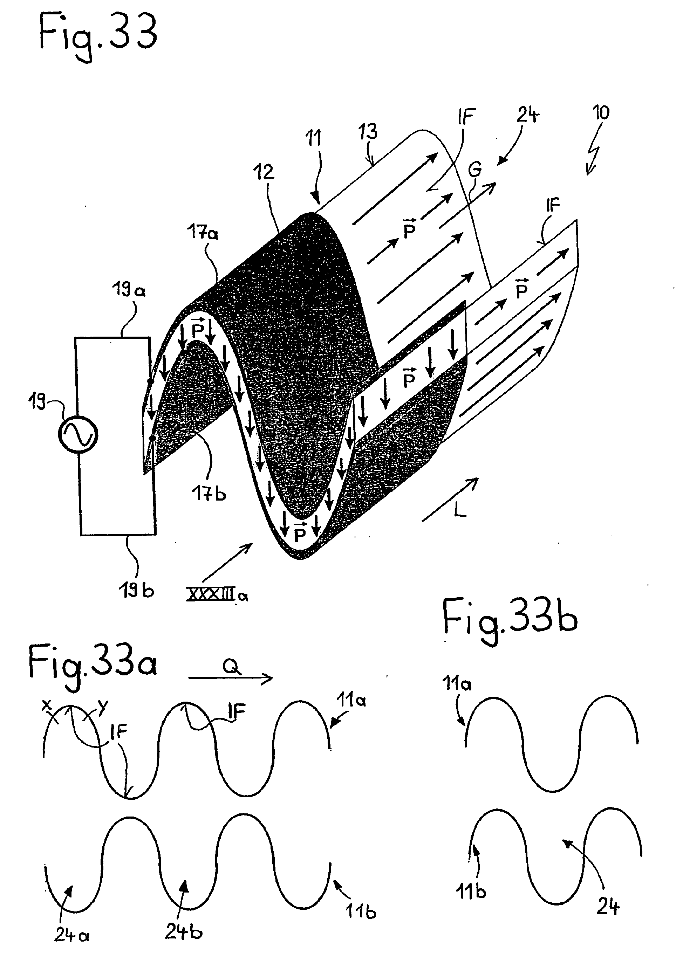

Schließlich zeigt Fig. 33 ein weiteres Ausführungsbeispiel der erfindungsgemäßen Vorrichtung 10, bei der die Einrichtung 11 von einem wellblechartig geformten Element gebildet ist. Fig. 33 macht deutlich, dass die Oberflächen der Einrichtung 11 gekrümmt sind. Eine gekrümmte Oberfläche ermöglicht gegenüber einer planen Oberfläche eine verbesserte Wechselwirkung zwischen dem entlang der Oberflächen vorbeiströmenden Gas und dem entlang der Oberflächen erzeugten Plasma. Eine gekrümmte Oberfläche des Primärbereiches 13 stellt eine gekrümmte Innenfläche IF bereit, die einen Gasströmungskanal 24, zumindest teilweise, umgrenzt. Die Gasströmung ist in Fig. 33 mit dem Pfeil G angedeutet.

Es wird deutlich, dass mehrere der wellblechartigen Strukturen gemäß Fig. 33 auch parallel zueinander angeordnet sein können. Eine solche Anordnung skizziert Fig. 33a. Diese verdeutlicht, dass sich eine Vielzahl praktisch vollständig geschlossener Gasströmungskanäle 24a, 24b ergibt, wenn eine entsprechend versetzte Anordnung zweier wellblechartig strukturierter Einrichtungen 11a und 11b gewählt wird. Fig. 33a entspricht dabei einer schematischen Querschnittsansicht des Ansichtspfeil XXXIIIa in Fig. 33.

Fig. 33b zeigt eine parallele, nicht versetzte Anordnung zweier wellblechartig strukturierter Einrichtungen 11a und 11b. Hierbei ergibt sich ein mäanderartiger, durchgehender Gasströmungsschlitz 24.

Es ist auch möglich, eine Vielzahl vergleichbarer wellblechartiger Strukturen 11a und 11b übereinander anzuordnen.

Die Vielzahl der dargestellten und beschriebenen Ausführungsbeispiele verdeutlicht, dass es für die Erfindung darauf ankommt, dass ein piezoelektrischer Transformator mit einem besonders ausgebildeten Primärbereich und einem besonders ausgebildeten Sekundärbereich ausgestattet ist. Einige Ausführungsbeispiele sehen auch Parallel-Anordnungen mehrerer piezoelektrischer Transformatoren vor. Für den Fall, dass in dem Sekundärbereich, und vorteilhafterweise gleichermaßen auch in dem Primärbereich, durchgehende Öffnungen vorgesehen sind, wie dies beispielsweise in Fig. 21 zeigt, empfiehlt es sich, den Primärbereich in Radialrichtung zu polarisieren.

Auf die Polarisationsrichtung des Primärbereiches kommt es bei einigen der oben beschriebenen Ausführungsbeispiele, z.B. bei dem Ausführungsbeispiel der Fig. 2, nicht an. Für den Fall, dass mehrere Primärbereiche vorgesehen sind, wie beispielsweise bei dem Ausführungsbeispiel der Fig. 3, kommt es bei einigen der oben beschriebenen Ausführungsbeispiele auf die Polarisationsrichtungen der Primärbereiche gleichermaßen nicht an. Wesentlich ist bei mehreren Primärbereichen oder Primärteilbereichen lediglich, dass eine synchrone Anregung erfolgt, d.h. dass die Primärbereiche unterschiedlicher Einrichtungen 11a, 11b oder 11c oder die Teilbereiche einer Einrichtung 11 in Phase, also entweder phasengleich, d.h. ohne Phasenverschiebung, oder um 180°-phasenversetzt schwingen. Hierzu können die unterschiedlichen Primärbereiche oder die unterschiedlichen Primärteilbereiche mit einer gemeinsamen Spannungsversorgung 19 über gesonderte Spannungsversorgungsleitungen 19a und 19b verbunden sein.

Aus den obigen Ausführungen heraus wird auch deutlich, dass es letztendlich auch auf die Polarisationsrichtungen der Sekundärbereiche 13 bzw. der zugehörigen Teilbereiche nicht zwingend ankommt. So kann z.B. das Ausführungsbeispiel der Fig. 15 mit den dort dargestellten Polarisationsrichtungen des Sekundärbereiches 13 betrieben werden, wonach die beiden Teilbereiche 14 und 15 entgegengesetzt polarisiert sind. Gleichermaßen kommt es aber auch in Betracht, die beiden Teilbereiche 14 und 15 mit einer gleichgerichteten. Polarisationsrichtung auszustatten und die zugehörigen Primärteilbereiche 12a und 12b gegengetaktet anzuregen. Schließlich kann das Ausführungsbeispiel der Fig. 15 aber auch mit einer gleichgetakteten Anordnung der Primärteilbereiche 12a und 12b betrieben werden.

Die gleichen Überlegungen hinsichtlich der Wahl der Polarisationsrichtungen gelten auch für die übrigen Ausführungsbeispiele, wobei man die Polarisationsrichtungen und die Geometrien der Einrichtungen 11, 11a, 11b und 11c primär in Abhängigkeit davon wählen wird, ob ein Atmosphärendruck-Plasma innerhalb eines Gasströmungskanals, ein Plasma-Jet oder eine Stirnflächenplasma erzeugt werden soll.

Anhand eines Vergleichs der Figuren 1 und 3 wird des weiteren deutlich, dass es nicht darauf ankommt, ob ein Primärbereich 12 in mehrere Primärteilbereiche 12a, 12b unterteilt ist oder nicht. Während der Primärbereich 12 gemäß Fig. 1 als Ganzes resonant schwingt, weil zwischen den beiden Elektroden 17a und 17b ein Wechselfeld generiert wird, schwingt der aus zwei Primärteilbereichen 12a und 12b zusammengesetzte Primärbereich 12 des Ausführungsbeispiels der Fig. 3 gleichermaßen insgesamt resonant, da hier entsprechend gegengepolt angeordnete Elektroden 17a, 17b, 17c vorgesehen sind.

Die Zahl der Elektroden kann zur Erzielung des gleichen Zweckes auch beliebig erhöht werden, wobei die zwischen zwei Elektroden verbleibende Materialdicke und die an den Elektroden angelegte Spannung ein Maß für das Spannungsübertragungsverhältnis von dem Primär- zu dem Sekundärbereich ist.

Schließlich ist auch die Geometrie von Primärbereich 12 und Sekundärbereich 13 bei den unterschiedlichen Ausführungsbeispielen der erfindungsgemäßen Vorrichtung 10 nahezu beliebig wählbar und an den vorgesehenen Anwendungszweck vorteilhaft anpassbar. So können sich beispielsweise die Einrichtungen 11a und 11b der Fig. 14 beispielsweise in Querrichtung Q erstrecken, und so plattenartige langgestreckte Körper bilden. In der Richtung S können sich an die beiden dargestellten Einrichtungen 11a und 11b noch eine Vielzahl weiterer Einrichtungen anschließen, so dass letztendlich eine Schichtstruktur, wie sie in Fig. 32 dargestellt ist, erzielbar ist.

Des Weiteren sei angemerkt, dass eine wabenartige Struktur einer Reihenanordnung 11, wie sie in Fig. 23a dargestellt ist, besonders einfach hergestellt werden kann, in dem in einem Extrusionsverfahren piezo-elektrisches Material durch eine komplementäre Gegenwabenstruktur durchgepresst oder ausgelassen wird, und die Durchtrittskanäle 24 durch entsprechende Dorne in der Extruderdüse bzw. durch eine entsprechende Gegenwabenstruktur der Düse generiert werden. Eine Polarisation eines derartigen wabenförmigen Werkstückes kann erfolgen, indem das Werkstück mit seinem ersten Endbereich, der den Sekundärbereich ausbilden soll, in eine metallische Flüssigkeit oder dgl. getaucht wird, um entlang der Wandungen der Gasströmungskanäle Elektroden anzubringen. Das Werkstück kann nach Anbringung der Elektrode beispielsweise auf eine Leiterplatte oder Platine od. dgl. aufgesetzt werden, an der eine Vielzahl von parallelen Federklemmen oder Federkontakten angeordnet sind. Die Federklemmenkontakte werden infolge einer Annäherung der Wabenstruktur an die Platine zugleich in die entsprechenden Gasströmungskanäle eingeführt und kontaktieren so die dort vorher angebrachten Elektroden. Eine Polarisierung des Primärbereiches zur Erzielung einer Polarisation gemäß Fig. 23 kann nachfolgend beispielsweise in einer die Durchschlagsfestigkeit erhöhenden Ölflüssigkeit oder einem Ölbad durchgeführt werden, wobei jeweils zwei einander benachbarte Elektroden unterschiedlich gepolt mit Polarisationsspannung beaufschlagt werden.

Nachfolgend kann der Sekundärbereich dieser Wabenstruktur polarisiert werden, in dem an die Oberseite, d.h. an die dem Primärbereich ferne Außenseite der Wabenstruktur eine Gegenelektrode angelegt wird und zwischen dieser Gegenelektrode und den zuvor erwähnten Federklemmkontakten eine Polarisationsspannung eingelegt wird. Hierdurch wird die in Fig. 23a dargestellte Polarisation des Sekundärbereiches 13 erreicht.

Alternativ ist es auch möglich, eine Wabenstruktur gemäß Fig. 23a derart zu polarisieren, so dass jeweils zwei einander benachbarte Teilbereiche, z.B. die Teilbereiche 14a und 14b, nicht entlang der gleichen Polarisationsrichtung, sondern entlang entgegengesetzter Polarisationsrichtungen polarisiert werden. Dies wird beispielsweise ermöglicht, indem an die Oberseite der Wabenstruktur zur Durchführung einer Polarisierung des Sekundärbereiches eine entsprechende Gegenelektrode herangebracht wird, die mit entsprechenden Elektroden versehen ist.

Unter Bezugnahme auf Fig. 33 sei angemerkt, dass neben sich endlos fortsetzenden Wellblechstrukturen auch Einrichtungen 11 vorgesehen werden können, -die nur ein Segment einer derartigen Wellblechstruktur aufweisen. Denkbar sind beispielsweise segmentartige Abschnitte, die besonders ausgeprägt gekrümmt sind und z.B. nur zwischen den Punkten X und Y der Fig. 33a verlaufen. Es handelt sich dabei um in Querrichtung Q relativ kurz gehaltene Abschnitte, die jedoch zu beliebigen geometrischen Strukturen zusammengesetzt werden können und aufgrund der gekrümmten Oberfläche eine verbesserte Wechselwirkung zwischen dem Plasma und dem Arbeitsgas bereitstellen bzw. eine verbesserte Plasmagenerierung ermöglichen.

Mit den oben beschriebenen, zahlreichen erfindungsgemäßen Vorrichtungen wird eine Skalierung zu beliebig großen Vorrichtungen hin möglich. Mit entsprechend groß dimensionierten Vorrichtungen könnten großflächige oder großvolumige Plasmen generiert werden.

Gleichermaßen ermöglichen die erfindungsgemäßen Vorrichtungen eine kompakte Bauform bis hin zu miniaturisierten Bauformen. Derartige Miniaturisierungen sind mit herkömmlichen Vorrichtungen zur Plasmaerzeugung, die gesonderte Hochspannungsgeneratoren und entsprechende besondere Hochspannungsleitungen, mit besonderen Isolierstrecken erfordern, nicht möglich.

Mit den erfindungsgemäßen Vorrichtungen werden Mikrostrukturen bearbeitbar oder gegebenenfalls auch generierbar. Beispielsweise können die Gasströmungskanäle 24, und zwar auch bei Wabenstrukturen gemäß beispielsweise Fig. 23a, mit nahezu beliebig kleinen Durchmessern ausgebildet werden.

## Patentansprüche

1. Vorrichtung (10) zur Erzeugung eines Atmosphärendruck-Plasmas (20, 20a, 20b, 20c, 20d), insbesondere zur Bearbeitung eines Substrates, umfassend eine Einrichtung (11, 11a, 11b, 11c) aus piezoelektrischem Material, mit mindestens einem Primärbereich (12, 12a, 12b, 12c), an dem wenigstens zwei Elektroden (17a, 17b, 17c) zum Anlegen einer Niedervolt-Wechselspannung angeordnet sind, und mit einem Sekundärbereich (13), entlang dessen Längsrichtung (L) sich infolge einer Anregung des Primärbereiches Potentialdifferenzen ausbilden, **dadurch gekennzeichnet, dass** der Sekundärbereich (13) zwei Teilbereiche (14, 14a, 14b, 14c, 15, 15a, 15b, 15c) umfasst, die entlang der Längsrichtung (L) entgegengesetzt polarisiert sind.

2. Vorrichtung nach Anspruch 1, **dadurch gekennzeichnet, dass** die beiden Teilbereiche (14, 14a, 14b, 14c, 15, 15a, 15b, 15c) im Wesentlichen parallel zueinander angeordnet sind.

3. Vorrichtung nach Anspruch 1 oder 2, **dadurch gekennzeichnet, dass** eine Anregung des Primärbereiches (12, 12a, 12b, 12c) eine Potentialdifferenz zwischen den beiden Teilbereichen (14, 14a, 14b, 14c, 15, 15a, 15b, 15c) in einer Richtung (Q) quer zur Längsrichtung (L) generiert.

4. Vorrichtung nach einem der vorgenannten Ansprüche, **dadurch gekennzeichnet, dass** die beiden Teilbereiche (14, 14a, 14b, 14c, 15, 15a, 15b, 15c) einander benachbart angeordnet sind.

5. Vorrichtung nach einem der vorgenannten Ansprüche, **dadurch gekennzeichnet, dass** die beiden Teilbereiche (14, 14a, 14b, 14c, 15, 15a, 15b, 15c) voneinander unbeabstandet sind.

6. Vorrichtung nach Anspruch 5, **dadurch gekennzeichnet, dass** die beiden Teilbereiche (14, 15) von einem gemeinsamen Werkstück gebildet sind, welches in entgegengesetzte Richtungen polarisiert ist.

7. Vorrichtung nach Anspruch 5 oder 6, **dadurch gekennzeichnet, dass** der Primärbereich (12) und der Sekundärbereich (13) von einem gemeinsamen Werkstück gebildet sind, welches in wenigstens drei unterschiedlichen Richtungen (16a, 16b, 16c) polarisiert ist.

8. Vorrichtung nach einem der vorgenannten Ansprüche, **dadurch gekennzeichnet, dass** der Primärbereich (12) und der Sekundärbereich (13) und/oder die Teilbereiche (14, 15) von unterschiedlichen Werkstücken gebildet sind, die aneinander befestigt sind.

9. Vorrichtung nach einem der Ansprüche 1 bis 4, **dadurch gekennzeichnet, dass** die beiden Teilbereiche (14, 15) voneinander geringfügig beabstandet sind.

10. Vorrichtung nach einem der vorgenannten Ansprüche, **dadurch gekennzeichnet, dass** jedem Teilbereich (14, 15) ein eigener Primärbereich (12a, 12b) zugeordnet ist.

11. Vorrichtung nach Anspruch 10, **dadurch gekennzeichnet, dass** die beiden Primärbereiche (12a, 12b), gleichgetaktet angeordnet sind, und insbesondere ohne Phasenverschiebung anregbar sind.

12. Vorrichtung nach Anspruch 10 oder 11, **dadurch gekennzeichnet, dass** jeder der beiden Primärbereiche (12a, 12b) ein eigenes Paar (17a, 17b; 17b, 17c) von Elektroden aufweist.

13. Vorrichtung nach Anspruch 12, **dadurch gekennzeichnet, dass** den beiden Primärbereichen (12a, 12b) wenigstens eine gemeinsame Elektrode (17b) zugeordnet ist.

14. Vorrichtung nach einem der vorgenannten Ansprüche, soweit dieser nicht auf Anspruch 5 rückbezogen ist, **dadurch gekennzeichnet, dass** zwischen den beiden Teilbereichen (14, 15) ein Freiraum (24) (Fig. 4, Fig. 14) angeordnet ist.

15. Vorrichtung nach einem der vorgenannten Ansprüche, soweit dieser nicht auf Anspruch 5 rückbezogen ist, **dadurch gekennzeichnet, dass** zwischen den beiden Teilbereichen (14, 15) ein Gaskanal (24) angeordnet ist.

16. Vorrichtung nach einem der vorgenannten Ansprüche, soweit dieser nicht auf Anspruch 5 rückbezogen ist, **dadurch gekennzeichnet, dass** zwischen den beiden Teilbereichen ein Isolator (23) angeordnet ist.

17. Vorrichtung nach einem der vorgenannten Ansprüche, **dadurch gekennzeichnet, dass** eine Vielzahl von Teilbereichen (14a, 14b, 14c, 15a, 15b,) linear in Reihe, insbesondere quer zur Längsrichtung, angeordnet ist.

18. Vorrichtung nach Anspruch 17, **dadurch gekennzeichnet, dass** die Polarisationsrichtungen der Teilbereiche entlang der Reihe alternieren.

19. Vorrichtung nach einem der vorgenannten Ansprüche, **dadurch gekennzeichnet, dass** eine Vielzahl von Teilbereichen (14a, 14b, 14c, 15a, 15b, 15c) entlang einer Ebene nach Art eines Rasters angeordnet ist.

20. Vorrichtung nach Anspruch 19, **dadurch gekennzeichnet, dass** die Polarisationsrichtungen der Teilbereiche (14a, 14b, 14c, 15a, 15b, 15c) entlang einer ersten, quer zur Längsrichtung stehenden Richtung (Q), und entlang einer zweiten, senkrecht zur ersten Richtung und senkrecht zur Längsrichtung stehenden Richtung (S), alternieren.

21. Vorrichtung (10) zur Erzeugung eines Atmosphärendruck-Plasmas (20, 20a, 20b, 20c), insbesondere zur Bearbeitung eines Substrates, umfassend eine Einrichtung (11, 11a, 11b, 11c) aus piezoelektrischem Material, mit mindestens einem Primärbereich (12, 12a, 12b, 12c), an dem wenigstens zwei Elektroden (17a, 17b, 17c) zum Anlegen einer Niedervolt-Wechselspannung angeordnet sind, und mit einem Sekundärbereich (13), entlang dessen Längsrichtung _(L) sich infolge einer Anregung des Primärbereiches Potentialdifferenzen ausbilden, **dadurch gekennzeichnet, dass** der Sekundärbereich (13) von zwei gesonderten Teilbereichen (14, 14a, 14b, 14c, 15, 15a, 15b, 15c) gebildet ist, die entlang der gleichen Polarisationsrichtung polarisiert sind, dass jedem Teilbereich ein eigener Primärbereich (12a, 12b) zugeordnet ist, und dass die beiden Primärbereiche (12a, 12b) gegengetaktet angeordnet sind.

22. Vorrichtung nach Anspruch 21, **dadurch gekennzeichnet, dass** die beiden Primärbereiche (12a, 12b) eine übereinstimmende Polarisationsrichtung aufweisen und 180°-phasenversetzt anregbar sind.

23. Vorrichtung nach Anspruch 21, **dadurch gekennzeichnet, dass** die beiden Primärbereiche (12a, 12b) entgegengesetzte Polarisationsrichtungen aufweisen und phasengleich, d.h. in Phase und ohne Phasenverschiebung anregbar sind.

24. Vorrichtung nach einem der Ansprüche 21 bis 23, **dadurch gekennzeichnet, dass** jeder der beiden Primärbereiche (12a, 12b) über ein Paar (17a, 17b; 17b, 17c) von Elektroden verfügt.

25. Vorrichtung nach Anspruch 24, **dadurch gekennzeichnet, dass** die beiden Primärbereiche (12a, 12b) wenigstens eine gemeinsame Elektrode (17b) aufweisen.

26. Vorrichtung nach einem der Ansprüche 21 bis 25, **dadurch gekennzeichnet, dass** die beiden Teilbereiche (14, 15, 14a, 15a, 14b, 15b, 14c, 15c) im wesentlichen parallel zueinander angeordnet sind.

27. Vorrichtung nach einem der Ansprüche 21 bis 26, **dadurch gekennzeichnet, dass** die beiden Teilbereiche (14, 14a, 14b, 14c, 15, 15a, 15b, 15c) einander benachbart angeordnet sind.

28. Vorrichtung nach einem der Ansprüche 21 bis 27, **dadurch gekennzeichnet, dass** jeweils ein Primärbereich (12a, 12b) und ein Teilbereich (14, 15) von einem gemeinsamen Werkstück gebildet ist.

29. Vorrichtung nach Anspruch 27, **dadurch gekennzeichnet, dass** die beiden Teilbereiche voneinander geringfügig beabstandet sind.

30. Vorrichtung nach Anspruch 29, **dadurch gekennzeichnet, dass** zwischen den beiden Teilbereichen (14, 15) ein Freiraum (24) angeordnet ist.

31. Vorrichtung nach Anspruch 30, **dadurch gekennzeichnet, dass** zwischen den beiden Teilbereichen ein Gaskanal (24) angeordnet ist.

32. Vorrichtung nach Anspruch 27, **dadurch gekennzeichnet, dass** zwischen den beiden Teilbereichen ein Isolator (23) angeordnet ist.

33. Vorrichtung nach einem der Ansprüche 21 bis 32, **dadurch gekennzeichnet, dass** eine Vielzahl von Teilbereichen (14a, 14b, 14c) linear in Reihe, insbesondere quer (Richtung Q) zur Längsrichtung (L), angeordnet ist.

34. Vorrichtung nach Anspruch 33, **dadurch gekennzeichnet, dass** die Gegentaktung der zugehörigen Primärbereiche (12a, 12b, 12c) entlang der Reihe der Teilbereiche (14a, 14b, 14c) alterniert.

35. Vorrichtung nach einem der Ansprüche 21 bis 34, **dadurch gekennzeichnet, dass** eine Vielzahl von Teilbereichen (14a, 14b, 14c) entlang einer Ebene nach Art eines Rasters angeordnet ist.

36. Vorrichtung nach Anspruch 35, **dadurch gekennzeichnet, dass** die Gegentaktung der zugehörigen Primärbereiche (12a, 12b, 12c) entlang einer ersten, quer zur Längsrichtung stehenden Richtung (Q) und entlang einer zweiten, senkrecht zur ersten Richtung und senkrecht zur Längsrichtung stehenden Richtung (S), alterniert.

37. Vorrichtung (10) zur Erzeugung eines Atmosphärendruck-Plasmas (20, 20a, 20b, 20c) insbesondere zur Bearbeitung eines Substrates, umfassend eine Einrichtung (11, 11a, 11b, 11c) aus piezoelektrischem Material, mit mindestens einem Primärbereich (12, 12a, 12b, 12c, 12d), an dem wenigstens zwei Elektroden (17a, 17b, 17c) zum Anlegen einer Niedervolt-Wechselspannung angeordnet sind, und mit einem sich in Längsrichtung (L) erstreckenden Sekundärbereich (14), wobei sich entlang der Längsrichtung (L) infolge einer Anregung des Primärbereiches Potentialdifferenzen ausbilden, **dadurch gekennzeichnet, dass** eine zweite Einrichtung (11b) mit einem zweiten, gesonderten Primärbereich (12b) und mit einem zweiten, gesonderten, sich in Längsrichtung erstreckenden Sekundärbereich (15) vorgesehen ist, dass die beiden Sekundärbereiche (14, 15) parallel zueinander ausgerichtet und quer zur Längsrichtung voneinander beabstandet angeordnet sind, und dass die beiden Sekundärbereiche zwischen sich einen in Längsrichtung (L) verlaufenden Gasführungskanal (24) bilden.

38. Vorrichtung nach Anspruch 37, **dadurch gekennzeichnet, dass** eine Vielzahl von Sekundärbereichen (14, 15, 14a, 15a, 14b, 15b, 14c, 15c) linear in einer Reihe angeordnet ist, und zwischen sich eine Vielzahl von in Längsrichtung (L) verlaufenden Gasführungskanälen (24a, 24b, 24c) bildet.

39. Vorrichtung nach Anspruch 37, **dadurch gekennzeichnet, dass** eine Vielzahl von Sekundärbereichen (14, 15, 14a, 15a, 14b, 15b, 14c, 15c) entlang einer Ebene, insbesondere nach Art eines Rasters, angeordnet ist und zwischen sich eine Vielzahl von in Längsrichtung (L) verlaufenden Gasführungskanälen bildet.

40. Vorrichtung (10) zur Erzeugung eines Atmosphärendruck-Plasmas, insbesondere zur Bearbeitung eines Substrates, umfassend eine Einrichtung (11) aus piezo-elektrischem Material, mit mindestens einem Primärbereich (12), an dem wenigstens zwei Elektroden (17a, 17b) zum Anlegen einer Niedervolt-Wechselspannung angeordnet sind, und mit einem Sekundärbereich (13), entlang dessen Längsrichtung (L) sich infolge einer Anregung des Primärbereiches Potentialdifferenzen ausbilden, **dadurch gekennzeichnet, dass** der Sekundärbereich (13) eine gekrümmte Innenfläche (IF) aufweist, die eine Wandung eines Gasführungskanals (24) ausbildet.

41. Vorrichtung nach Anspruch 40, **dadurch gekennzeichnet, dass** die gekrümmte Innenfläche (IF) eine Begrenzungsfläche für das Atmosphärendruck-Plasma (20) darstellt.

42. Vorrichtung (10) zur Erzeugung eines Atmosphärendruck-Plasmas, insbesondere zur Bearbeitung eines Substrates, umfassend eine Einrichtung (11) aus piezo-elektrischem Material, mit mindestens einem Primärbereich (12), an dem wenigstens zwei Elektroden (17a, 17b) zum Anlegen einer Niedervolt-Wechselspannung angeordnet sind, und mit einem Sekundärbereich (13), entlang dessen Längsrichtung (L) sich infolge einer Anregung des Primärbereiches (12) Potentialdifferenzen ausbilden, **dadurch gekennzeichnet, dass** in dem Sekundärbereich (13) ein in Längsrichtung (L) verlaufender, durchgehender Gasströmungskanal (24) angeordnet ist, und dass der Sekundärbereich (13) den Gasströmungskanal (24) vollständig umrandet.

43. Vorrichtung nach Anspruch 42, **dadurch gekennzeichnet, dass** der Sekundärbereich (13) mit seiner Innenfläche (IF) eine Wandung des Gasströmungskanals (24) bereitstellt.

44. Vorrichtung nach Anspruch 42 oder 43, **dadurch gekennzeichnet, dass** der Gasströmungskanal (24) den Primärbereich (12) durchgreift.

45. Vorrichtung nach einem der Ansprüche 42 bis 44, **dadurch gekennzeichnet, dass** die Einrichtung (11) im wesentlichen rohrförmig ausgebildet ist.

46. Vorrichtung (10) zur Erzeugung eines Atmosphärendruck-Plasmas, insbesondere zur Bearbeitung eines Substrates, umfassend eine Einrichtung (11) aus piezo-elektrischem Material, mit mindestens einem Primärbereich (12), an dem wenigstens zwei Elektroden (17a, 17b) zum Anlegen einer Niedervolt-Wechselspannung angeordnet sind, und mit einem Sekundärbereich (13), entlang dessen Längsrichtung (L) sich infolge einer Anregung des Primärbereiches (12) Potentialdifferenzen ausbilden, **dadurch gekennzeichnet, dass** in dem Sekundärbereich (13) mehrere, in Längsrichtung (L) verlaufende, durchgehende und zueinander parallele Gasströmungskanäle (24) angeordnet sind.

## Claims

1. Device (10) for generating an atmospheric pressure plasma (20, 20a, 20b, 20c, 20d), particularly for processing a substrate, comprising a device (11, 11a, 11b, 11c) of piezo-electric material, with at least one primary region (12, 12a, 12b, 12c), at which at least two electrodes (17a, 17b, 17c) for application of a low-volt alternating voltage are arranged, and with a secondary region (13), along the longitudinal direction (L) of which differences in potential form as a consequence of excitation of the primary region, **characterised in that** the secondary region (13) comprises two sub-regions (14, 14a, 14b, 14c, 15, 15a, 15b, 15c) which are oppositely polarised along the longitudinal direction (L).

2. Device according to claim 1, **characterised in that** the two sub-regions (14, 14a, 14b, 14c, 15, 15a, 15b, 15c) are arranged substantially parallel to one another.

3. Device according to claim 1 or 2, **characterised in that** excitation of the primary region (12, 12a, 12b, 12c) generates a difference in potential between the two sub-regions (14, 14a, 14b, 14c, 15, 15a, 15b, 15c) in a direction (Q) transverse to the longitudinal direction (L).

4. Device according to any one of the preceding claims, **characterised in that** the two sub-regions (14, 14a, 14b, 14c, 15, 15a, 15b, 15c) are arranged adjacent to one another.

5. Device according to any one of the preceding claims, **characterised in that** the two sub-regions (14, 14a, 14b, 14c, 15, 15a, 15b, 15c) are spaced from one another.

6. Device according to claim 5, **characterised in that** the two sub-regions (14, 15) are formed by a common workpiece which is polarised in opposite directions.

7. Device according to claim 5 or 6, **characterised in that** the primary region (12) and the secondary region (13) are formed by a common workpiece which is polarised in at least three different directions (16a, 16b, 16c).

8. Device according to any one of the preceding claims, **characterised in that** the primary region (12) and the secondary region (13) and/or the sub-regions (14, 15) are formed by different workpieces which are fastened to one another.

9. Device according to any one of claims 1 to 4, **characterised in that** the two sub-regions (14, 15) are slightly spaced from one another.

10. Device according to any one of the preceding claims, **characterised in that** an individual primary region (12a, 12b) is associated with each sub-region (14, 15).

11. Device according to claim 10, **characterised in that** the two primary regions (12a, 12b) are arranged in-phase and, in particular, are excitable without phase displacement.

12. Device according to claim 10 or 11, **characterised in that** each of the two primary regions (12a, 12b) has an individual pair (17a, 17b; 17b, 17c) of electrodes.

13. Device according to claim 12, **characterised in that** at least one common electrode (17b) is associated with the two primary regions (12a, 12b).

14. Device according to any one of the preceding claims insofar as this is not dependent on claim 5, **characterised in that** a free space (24) (Fig. 4, Fig. 14) is arranged between the two sub-regions (14, 15).

15. Device according to any one of the preceding claims insofar as this is not dependent on claim 5, **characterised in that** a gas channel (24) is arranged between the two sub-regions (14, 15).

16. Device according to any one of the preceding claims insofar as this is not dependent on claim 5, **characterised in that** an insulator (23) is arranged between the two sub-regions.

17. Device according to any one of the preceding claims, **characterised in that** a plurality of sub-regions (14a, 14b, 14c, 15a, 15b) is arranged linearly in a row, particularly transversely to the longitudinal direction.

18. Device according to claim 17, **characterised in that** the directions of polarisation of the sub-regions alternate along the row.

19. Device according to any one of the preceding claims, **characterised in that** a plurality of sub-regions (14a, 14b, 14c, 15a, 15b, 15c) is arranged along a plane in the manner of a grid.

20. Device according to claim 19, **characterised in that** the directions of polarisation of the sub-regions (14a, 14b, 14c, 15a, 15b, 14c) alternate along a first direction (Q) transverse to the longitudinal direction and along a second direction (S) perpendicular to the first direction and perpendicular to the longitudinal direction.

21. Device (10) for generating an atmospheric pressure plasma (20, 20a, 20b, 20c, 20d), particularly for processing a substrate, comprising a device (11, 11a, 11b, 11c) of piezo-electric material, with at least one primary region (12, 12a, 12b, 12c), at which at least two electrodes (17a, 17b, 17c) for application of a low-volt alternating voltage are arranged, and with a secondary region (13), along the longitudinal direction (L) of which differences in potential form as a consequence of excitation of the primary region, **characterised in that** the secondary region (13) is formed by two separate sub-regions (14, 14a, 14b, 14c, 15, 15a, 15b, 15c) which are polarised along the same direction of polarisation, that an individual primary region (12a, 12b) is associated with each sub-region and that the two sub-regions (12a, 12b) are arranged in-phase.

22. Device according to claim 21, **characterised in that** the two primary regions (12a, 12b) have a corresponding direction of polarisation and are excitable displaced in phase by 180°.

23. Device according to claim 21, **characterised in that** the two primary regions (12a, 12b) have opposite directions of polarisation and are excitable in like phase, i.e. in-phase and without phase displacement.

24. Device according to any one of claims 21 to 23, **characterised in that** each of the two primary regions (12a, 12b) has a pair (17a, 17b; 17b, 17c) of electrodes.

25. Device according to claim 24, **characterised in that** the two primary regions (12a, 12b) have at least one common electrode (17b).

26. Device according to any one of claims 21 to 25, **characterised in that** the two sub-regions (14, 15, 14a, 15a, 14b, 15b, 14c, 15c) are arranged substantially parallel to one another.

27. Device according to any one of claims 21 to 26, **characterised in that** the two sub-regions (14, 15, 14a, 15a, 14b, 15b, 14c, 15c) are arranged adjacent to one another.

28. Device according to any one of claims 21 to 27, **characterised in that** in each instance a primary region (12a, 12b) and a sub-region (14, 15) is formed by a common workpiece.

29. Device according to claim 27, **characterised in that** the two sub-regions are slightly spaced from one another.

30. Device according to claim 29, **characterised in that** a free space (24) is arranged between the two sub-regions (14, 15).

31. Device according to claim 30, **characterised in that** a gas channel (24) is arranged between the two sub-regions.

32. Device according to claim 27, **characterised in that** an insulator (23) is arranged between the two sub-regions.

33. Device according to any one of claims 21 to 32, **characterised in that** a plurality of sub-regions (14a,14b, 14c) is arranged linearly in a row, particularly transversely (direction Q) to the longitudinal direction (L).

34. Device according to claim 33, **characterised in that** the opposite phasing of the associated primary regions (12a, 12b, 12c) alternates along the row of sub-regions (14a, 14b, 14c).

35. Device according to any one of the claims 21 to 34, **characterised in that** a plurality of sub-regions (14a, 14b, 14c) is arranged along a plane in the manner of a grid.

36. Device according to claim 35, **characterised in that** the opposite phasing of the associated primary regions (12a, 12b, 12c) alternates along a first direction (Q) transverse to the longitudinal direction and along a second direction (S) perpendicular to the first direction and perpendicular to the longitudinal direction.

37. Device (10) for generating an atmospheric pressure plasma (20, 20a, 20b, 20c, 20d), particularly for processing a substrate, comprising a device (11, 11a, 11b, 11c) of piezo-electric material, with at least one primary region (12, 12a, 12b, 12c), at which at least two electrodes (17a, 17b, 17c) for application of a low-volt alternating voltage are arranged, and with a secondary region (14) extending in longitudinal direction (L), wherein differences in potential form along the longitudinal direction (L) as a consequence of excitation of the primary region, **characterised in that** a second device (11b) with a second, separate primary region (12b) and with a second, separate secondary region (15) extending in longitudinal direction is provided, that the two secondary regions (14, 15) are oriented parallel to one another and arranged at a spacing from one another transversely to the longitudinal direction, and that the two secondary regions form therebetween a gas guide channel (24) extending in longitudinal direction (L).

38. Device according to claim 37, **characterised in that** a plurality of secondary regions (14, 15, 14a, 15a, 14b, 15b, 14c, 15c) is arranged linearly in a row and a plurality of gas guide channels (24a, 24b, 24c) extending in longitudinal direction (L) is formed therebetween.

39. Device according to claim 37, **characterised in that** a plurality of secondary regions (14, 15, 14a, 15a, 14b, 15b, 14c, 15c) is arranged along a plane, particularly in the manner of a grid, and a plurality of gas guide channels extending in longitudinal direction (L) is formed therebetween.

40. Device (10) for generating an atmospheric pressure plasma, particularly for processing a substrate, comprising a device (11) of piezo-electric material, with at least one primary region (12), at which at least two electrodes (17a, 17b) for application of a low-volt alternating voltage are arranged, and with a secondary region (13), along the longitudinal direction (L) of which differences in potential form as a consequence of excitation of the primary region, **characterised in that** the secondary region (13) has a curved inner surface (IF) which forms a wall of a gas guide channel (24).

41. Device according to claim 40, **characterised in that** the curved inner surface (IF) represents a boundary surface for the atmospheric pressure plasma (20).

42. Device (10) for generating an atmospheric pressure plasma, particularly for processing a substrate, comprising a device (11) of piezo-electric material, with at least one primary region (12), at which at least two electrodes (17a, 17b) for application of a low-volt alternating voltage are arranged, and with a secondary region (13), along the longitudinal direction (L) of which differences in potential form as a consequence of excitation of the primary region, **characterised in that** a continuous gas flow channel (24) extending in longitudinal direction (L) is arranged in the secondary region (13) and that the secondary region (13) completely bounds the gas flow channel (24).

43. Device according to claim 42, **characterised in that** the secondary region (13) provides, by its inner surface (IF), a wall of the gas flow channel (24).

44. Device according to claim 42 or 43, **characterised in that** the gas flow channel (24) passes through the primary region (12).

45. Device according to any one of claims 42 to 44, **characterised in that** the device (11) is of substantially tubular construction.

46. Device (10) for generating an atmospheric pressure plasma, particularly for processing a substrate, comprising a device (11) of piezo-electric material, with at least one primary region (12), at which at least two electrodes (17a, 17b) for application of a low-volt alternating voltage are arranged, and with a secondary region (13), along the longitudinal direction (L) of which differences in potential form as a consequence of excitation of the primary region, **characterised in that** several continuous and mutually parallel gas flow channels (24) extending in longitudinal direction (L) are arranged in the secondary region (13).

## Revendications

1. Dispositif (10) pour générer un plasma à pression atmosphérique (20, 20a, 20b, 20c, 20d), en particulier pour le traitement d'un substrat, comprenant un dispositif (11, 11a, 11b, 11c) en un matériau piézoélectrique avec au moins un domaine primaire (12, 12a, 12b, 12c) sur lequel sont disposées au moins deux électrodes (17a, 17b, 17c) pour établir une tension alternative basse tension, et avec un domaine secondaire (13) le long de la direction longitudinale (L) duquel se forment des différences de potentiel suite à une excitation du domaine primaire, **caractérisé en ce que**
le domaine secondaire (13) comporte deux domaines partiels (14, 14a, 14b, 14c, 15, 15a, 15b, 15c) qui sont polarisés en sens inverse le long de la direction longitudinale (L).

2. Dispositif conforme à la revendication 1,
**caractérisé en ce que**
les deux domaines partiels (14, 14a, 14b, 14c, 15, 15a, 15b, 15c) sont disposés essentiellement parallèlement l'un à l'autre.

3. Dispositif conforme à la revendication 1 ou 2,
**caractérisé en ce qu'**
une excitation du domaine primaire (12, 12a, 12b, 12c) génère une différence de potentiel entre les deux domaines partiels (14, 14a, 14b, 14c, 15, 15a, 15b, 15c) dans une direction (Q) transversale à la direction longitudinale (L).

4. Dispositif conforme à l'une des revendications précédentes,
**caractérisé en ce que**
les deux domaines partiels (14, 14a, 14b, 14c, 15, 15a, 15b, 15c) sont disposés au voisinage l'un de l'autre.

5. Dispositif conforme à l'une des revendications précédentes,
**caractérisé en ce que**
les deux domaines partiels (14, 14a, 14b, 14c, 15, 15a, 15b, 15c) ne sont pas séparés l'un de l'autre.

6. Dispositif conforme à la revendication 5,
**caractérisé en ce que**
les deux domaines partiels (14, 15) sont formés par une pièce commune qui est polarisée dans des directions opposées.

7. Dispositif conforme à la revendication 5 ou 6,
**caractérisé en ce que**
le domaine primaire (12) et le domaine secondaire (13) sont formés par une pièce commune qui est polarisée dans au moins trois directions différentes (16a, 16b, 16c).

8. Dispositif conforme à l'une des revendications précédentes,
**caractérisé en ce que**
le domaine primaire (12) et le domaine secondaire (13) et/ou les domaines partiels (14, 15) sont formés par différentes pièces qui sont fixées les unes aux autres.

9. Dispositif conforme à l'une des revendications 1 à 4,
**caractérisé en ce que**
les deux domaines partiels (14, 15) sont situés à une faible distance l'un de l'autre.

10. Dispositif conforme à l'une des revendications précédentes,
**caractérisé en ce qu'**
à chaque domaine partiel (14, 15) est associé un domaine primaire (12a, 12b) propre.

11. Dispositif conforme à la revendication 10,
**caractérisé en ce que**
les deux domaines primaires (12a, 12b) sont en phase et peuvent en particulier être excités sans décalage de phase.

12. Dispositif conforme à la revendication 10 ou 11,
**caractérisé en ce que**
chacun des deux domaines primaires (12a, 12b) comporte une paire (17a, 17b, 17c) d'électrodes propre.

13. Dispositif conforme à la revendication 12,
**caractérisé en ce qu'**
au moins un électrode commune (17b) est associée aux deux domaines primaires (12a, 12b).

14. Dispositif conforme à l'une des revendications précédentes, dans la mesure où cette revendication n'est pas rattachée à la revendication 5, **caractérisé en ce qu'**
un espace libre (24) est situé entre les deux domaines partiels (14, 15).

15. Dispositif conforme à l'une des revendications précédentes, dans la mesure où cette revendication n'est pas rattachée à la revendication 5, **caractérisé en ce qu'**
un canal de gaz (24) est disposé entre les deux domaines partiels (14, 15).

16. Dispositif conforme à l'une des revendications précédentes, dans la mesure où cette revendication n'est pas rattachée à la revendication 5, **caractérisé en ce qu'**
un isolant (23) est disposé entre les deux domaines partiels.

17. Dispositif conforme à l'une des revendications précédentes,
**caractérisé en ce que**
plusieurs domaines partiels (14a, 14b, 14c ; 15a, 15b) sont disposés linéairement en série, en particulier transversalement à la direction longitudinale.

18. Dispositif conforme à la revendication 17,
**caractérisé en ce que**
les directions de polarisation des domaines partiels alternent le long de la série.

19. Dispositif conforme à l'une des revendications précédentes,
**caractérisé en ce que**
plusieurs domaines partiels (14a, 14b, 14c ; 15a, 15b, 15c) sont disposés le long d'un plan à la façon d'une trame.

20. Dispositif conforme à la revendication 19,
**caractérisé en ce que**
les directions de polarisation des domaines partiels (14a, 14b, 14c, 15a, 15b, 15c) alternent le long d'une première direction (Q) transversale à la direction longitudinale et le long d'une seconde direction (S) perpendiculaire à la première direction et perpendiculaire à la direction longitudinale.

21. Dispositif (10) pour générer un plasma à pression atmosphérique (20, 20a, 20b, 20c), en particulier pour le traitement d'un substrat comportant un dispositif (11, 11a, 11b, 11c) en un matériau piézoélectrique avec au moins un domaine primaire (12, 12a, 12b, 12c) sur lequel sont disposées au moins deux électrodes (17a, 17b, 17c) pour établir une tension alternative basse tension, et avec un domaine secondaire (13) le long de la direction longitudinale (L) duquel se forment des différences de potentiel suite à une excitation du domaine primaire, **caractérisé en ce que**
le domaine secondaire (13) est formé de deux domaines partiels séparés (14, 14a, 14b, 14c, 15, 15a, 15b, 15c) qui sont polarisés le long de la même direction de polarisation,
un domaine primaire propre (12a, 12b) est associé à chaque domaine partiel,
les deux domaines primaires (12a, 12b) sont en opposition de phase.

22. Dispositif conforme à la revendication 21,
**caractérisé en ce que**
les deux domaines partiels (12a, 12b) présentent des directions de polarisation coïncidentes, et peuvent être excités avec un déphasage de 180°.

23. Dispositif conforme à la revendication 21,
**caractérisé en ce que**
les deux domaines primaires (12a, 12b) présentent des directions de polarisation opposées et peuvent être excités dans une même phase c'est-à-dire en phase et sans déphasage.

24. Dispositif conforme à l'une des revendications 21 à 23,
**caractérisé en ce que**
chacun des deux domaines primaires (12a, 12b) dispose d'une paire (17a, 17b ;17b, 17c) d'électrodes.

25. Dispositif conforme à la revendication 24,
**caractérisé en ce que**
les deux domaines primaires (12a, 12b) comportent au moins une électrode commune (17b).

26. Dispositif conforme à l'une des revendications 21 à 25,
**caractérisé en ce que**
les deux domaines partiels (14, 15, 14a, 15a, 14b, 15b, 14c, 15c) sont disposés essentiellement parallèlement l'un à l'autre.

27. Dispositif conforme à l'une des revendications 21 à 26,
**caractérisé en ce que**
les deux domaines partiels (14, 14a, 14b, 14c, 15, 15a, 15b, 15c) sont disposés au voisinage l'un de l'autre.

28. Dispositif conforme à l'une des revendications 21 à 27,
**caractérisé en ce qu'**
un domaine primaire (12a, 12b) et un domaine partiel (14, 15) sont respectivement formés par une pièce commune.

29. Dispositif conforme à la revendication 27,
**caractérisé en ce que**
les deux domaines partiels sont situés à une faible distance l'un de l'autre.

30. Dispositif conforme à la revendication 29,
**caractérisé en ce qu'**
un espace libre (24) est situé entre les deux domaines partiels (14, 15).

31. Dispositif conforme à la revendication 30,
**caractérisé en ce qu'**
un canal de gaz (24) est disposé entre les deux domaines partiels.

32. Dispositif conforme à la revendication 27,
**caractérisé en ce qu'**
un isolant (23) est disposé entre les deux domaines partiels.

33. Dispositif conforme à l'une des revendications 21 à 32,
**caractérisé en ce que**
plusieurs domaines partiels (14a, 14b, 14c) sont disposés linéairement en série, en particulier transversalement (direction Q) à la direction longitudinale (L).

34. Dispositif conforme à la revendication 33,
**caractérisé en ce que**
la mise en opposition de phase du domaine primaire (12a, 12b, 12c) associé s'effectue en alternance le long de la série de domaines partiels (14a, 14b, 14c).

35. Dispositif conforme à l'une des revendications 21 à 34,
**caractérisé en ce que**
plusieurs domaines partiels (14a, 14b, 14c) sont disposés le long d'un plan à la façon d'une trame.

36. Dispositif conforme à la revendication 35,
**caractérisé en ce que**
la mise en opposition de phase du domaine primaire (12a, 12b, 12c) associé s'effectue en alternance le long d'une première direction (Q) transversale à la direction longitudinale et le long d'une seconde direction (S) perpendiculaire à la première direction et perpendiculaire à la direction longitudinale.

37. Dispositif (10) pour générer un plasma à pression atmosphérique (20, 20a, 20b, 20c), en particulier pour le traitement d'un substrat comportant un dispositif (11, 11a, 11b, 11c) en un matériau piézoélectrique avec au moins un domaine primaire (12, 12a, 12b, 12c, 12d) sur lequel sont disposées au moins deux électrodes (17a, 17b, 17c) pour établir une tension alternative basse tension, et avec un domaine secondaire (14) s'étendant dans la direction longitudinale (L), des différences de potentiel étant formées le long de la direction longitudinale (L) par suite d'une excitation du domaine primaire,
**caractérisé en ce qu'**
il est prévu un second dispositif (11b) avec un second domaine primaire (12b) séparé et avec un second domaine secondaire (15) séparé s'étendant dans la direction longitudinale,
les deux domaines secondaires (14, 15) sont dirigés parallèlement l'un à l'autre et sont situés à distance l'un de l'autre transversalement à la direction longitudinale, et
les deux domaines secondaires forment entre eux un canal de guidage de gaz (24) s'étendant dans la direction longitudinale (L).

38. Dispositif conforme à la revendication 37,
**caractérisé en ce que**
plusieurs domaines secondaires (14, 15, 14a, 15a, 14b, 15b, 14c, 15c) sont disposés linéairement en série et forment entre eux plusieurs canaux de guidage de gaz (24a, 24b, 24c) s'étendant dans la direction longitudinale (L).

39. Dispositif conforme à la revendication 37,
**caractérisé en ce que**
plusieurs domaines secondaires (14, 15, 14a, 15a, 14b, 15b, 14c, 15c) sont disposés le long d'un plan, en particulier à la façon d'une trame, et forment entre eux plusieurs canaux de guidage de gaz s'étendant dans la direction longitudinale (L).

40. Dispositif (10) pour générer un plasma à pression atmosphérique (20, 20a, 20b, 20c), en particulier pour le traitement d'un substrat comportant un dispositif (11) en un matériau piézoélectrique avec au moins un domaine primaire (12) sur lequel sont disposées au moins deux électrodes (17a, 17b) pour établir une tension alternative basse tension, et avec un domaine secondaire (13) le long de la direction longitudinale (L) duquel se forment des différences de potentiel par suite d'une excitation du domaine primaire,
**caractérisé en ce que**
le domaine secondaire (13) comporte une surface interne (IF) courbe qui forme une paroi d'un canal de guidage de gaz (24).

41. Dispositif conforme à la revendication 40,
**caractérisé en ce que**
la surface interne courbe (IF) constitue une surface de limitation pour le plasma à pression atmosphérique (20).

42. Dispositif (10) pour générer un plasma à pression atmosphérique, en particulier pour le traitement d'un substrat comportant un dispositif (11) en un matériau piézoélectrique avec au moins un domaine primaire (12) sur lequel sont disposées au moins deux électrodes (17a, 17b) pour établir une tension alternative basse tension, et avec un domaine secondaire (13) le long de la direction longitudinale (L) duquel se forment des différences de potentiel par suite d'une excitation du domaine primaire (12),
**caractérisé en ce qu'**
un canal d'écoulement de gaz continu s'étendant dans la direction longitudinale (L) est formé dans le domaine secondaire (13), et
le domaine secondaire (13) encadre complètement le canal d'écoulement de gaz (24).

43. Dispositif conforme à la revendication 42,
**caractérisé en ce que**
le domaine secondaire (13) constitue par sa surface interne (IF) une paroi du canal d'écoulement de gaz (24).

44. Dispositif conforme à la revendication 42 ou 43,
**caractérisé en ce que**
le canal d'écoulement de gaz (24) pénètre dans le domaine primaire (12).

45. Dispositif conforme à l'une des revendications 42 à 44,
**caractérisé en ce que**
le dispositif (11) est essentiellement réalisé avec une forme tubulaire.

46. Dispositif (10) pour générer un plasma à pression atmosphérique, en particulier pour le traitement d'un substrat comportant un dispositif (11) en un matériau piézoélectrique avec au moins un domaine primaire (12) sur lequel sont disposées au moins deux électrodes (17a, 17b) pour établir une tension alternative basse tension, et avec un domaine secondaire (13) le long de la direction longitudinale (L) duquel se forment des différences de potentiel par suite d'une excitation du domaine primaire (12),
**caractérisé en ce que**
plusieurs canaux d'écoulement de gaz (24) continus et disposés parallèlement les uns aux autres s'étendant dans la direction longitudinale (L) sont disposés dans le domaine secondaire (13).
